# FASCICULE DE BREVET EUROPEEN

(11) **EP 2 121 814 B1**
(45) Date de publication et mention de la délivrance du brevet: **18.05.2011**
(21) Numéro de dépôt: 07871969.7
(22) Date de dépôt: 19.12.2007
(51) Int. Cl.: C08J 5/18, C09D 4/00, C09D 133/00, C09D 139/08, C08F 2/38, C08J 5/24, C08J 7/12, B05D 7/00, B05D 3/12, B82B 3/00

(54) **PROCÉDÉ DE PRÉPARATION D'UN FILM ORGANIQUE À LA SURFACE D'UN SUPPORT SOLIDE DANS DES CONDITIONS NON-ÉLECTROCHIMIQUES, SUPPORT SOLIDE AINSI OBTENU ET KIT DE PRÉPARATION**
VERFAHREN ZUR HERSTELLUNG EINES ORGANISCHEN FILMS AN DER OBERFLÄCHE EINES FESTEN SUBSTRATS UNTER NICHT-ELEKTROCHEMISCHEN BEDINGUNGEN, AUF DIESE WEISE HERGESTELLTES FESTSUBSTRAT UND HERSTELLUNGSSET
METHOD FOR PREPARING AN ORGANIC FILM AT THE SURFACE OF A SOLID SUBSTRATE IN NON-ELECTROCHEMICAL CONDITIONS, SOLID SUBSTRATE THUS FORMED AND PREPARATION KIT

(30) Priorité: 19.12.2006 FR 0655653; 14.03.2007 US 686076; 04.04.2007 FR 0754278; 24.05.2007 US 753394; 30.05.2007 FR 0755356; 11.06.2007 FR 0755659; 29.06.2007 FR 0756182; 07.08.2007 US 835004; 29.10.2007 FR 0758660
(43) Date de publication de la demande: 25.11.2009
(73) Titulaire: Commissariat à l'Énergie Atomique et aux Énergies Alternatives, 75015 Paris (FR)
(72) Inventeur: MEVELLEC, Vincent, 92100 Boulogne Billancourt (FR); ROUSSEL, Sébastien, 91450 Soisy Sur Seine (FR); PALACIN, Serge, 78180 Montigny Le Bretonneux (FR); BERTHELOT, Thomas, 91140 Villebon Sur Yvette (FR); BAUDIN, Cécile, 75014 Paris (FR); TRENGGONO, Adhitya, 91120 Palaiseau (FR); DENIAU, Guy, 78610 Auffargis (FR)
(74) Mandataire: Ilgart, Jean-Christophe
(86) Numéro de dépôt international: PCT/FR2007/052556
(87) Numéro de publication internationale: WO 2008/078052

(56) Documents cités:
- FR-A1- 2 829 046
- FR-A1- 2 841 908
- FR-A1- 2 851 181

## Description

### DOMAINE TECHNIQUE

La présente invention concerne le domaine des revêtements organiques de surface, lesdits revêtements étant sous la forme de films organiques. Elle est plus particulièrement relative à l'utilisation de solutions convenablement sélectionnées afin de permettre la formation simple et reproductible de films organiques par enduction sur des surfaces conductrices ou non de l'électricité sans passer par les techniques conventionnelles de fonctionnalisation de surface. La présente invention concerne également un procédé de préparation de tels revêtements organiques.

### ÉTAT DE LA TECHNIQUE ANTÉRIEURE

A l'heure actuelle, il existe plusieurs techniques permettant la réalisation de films organiques minces sur des substrats, chacune reposant sur une famille ou une classe de molécules adaptée.

Le procédé de formation d'un revêtement par centrifugation connu sous l'appellation anglaise de « spin coating » ne requiert pas d'affinité particulière entre les molécules déposées et le substrat d'intérêt, ce qui est également le cas des techniques apparentées de formation de revêtements par immersion (« dip coating ») ou de dépôt par vaporisation (« spray coating»). En effet, la cohésion du film déposé repose essentiellement sur les interactions entre les constituants du film qui peut, par exemple, être réticulé après dépôt pour en améliorer la stabilité. Ces techniques sont très versatiles, applicables à tout type de surface à couvrir, et très reproductibles. Cependant, elles ne permettent aucun greffage effectif entre le film et le substrat (il s'agit d'une simple physisorption), et les épaisseurs produites sont mal contrôlables notamment pour les dépôts les plus fins (inférieurs à 20 nanomètres). De plus, les techniques de « spin coating » ne permettent des dépôts uniformes que lorsque la surface à recouvrir est essentiellement plane (demande de brevet FR 2 843 757). La qualité des films obtenus par les techniques de « spray coating » est liée au mouillage des surfaces par le liquide pulvérisé, puisque le dépôt ne devient essentiellement filmogène que lorsque les gouttes coalescent. Ainsi, pour un polymère donné, il n'existe généralement qu'un ou deux solvants organiques capables de donner des résultats satisfaisants en termes de contrôle de l'épaisseur et de l'homogénéité du dépôt.

D'autres techniques de formation d'un revêtement organique à la surface d'un support, telles que le dépôt par plasma décrit par exemple dans les articles de Konuma M., « Film deposition by plasma techniques », (1992) Springer Verlag, Berlin, et de Biederman H. et Osada Y., « Plasma polymerization processes », 1992, Elsevier, Amsterdam ou bien l'activation photochimique reposent sur un même principe : générer à proximité de la surface à couvrir des formes instables d'un précurseur, qui évoluent en formant un film sur le substrat. Si le dépôt par plasma ne requiert aucune propriété particulière de ses précurseurs, la photo-activation nécessite quant à elle l'utilisation de précurseurs photosensibles, dont la structure évolue sous irradiation lumineuse. Ces techniques donnent en général lieu à la formation de films adhérents, bien qu'il soit le plus souvent impossible de discerner si cette adhésion est due à une réticulation d'un film topologiquement fermé autour de l'objet ou à une réelle formation de liaisons à l'interface. Malheureusement ces méthodes nécessitent des prétraitements relativement complexes et coûteux, l'utilisation d'installations sous vide pour les méthodes plasma telles que le dépôt chimique en phase vapeur assistée par plasma, l'irradiation, ou encore l'utilisation de potentiostats pour les méthodes électrochimiques auxquelles sont associés de nombreux problèmes de connexion.

La cataphorèse est une technique également employée pour le revêtement de surfaces conductrices par des films organiques. La cataphorèse ou procédé d'électrodéposition cationique, permet de recouvrir dès pièces métalliques à l'aide de polymères chargés et donne accès à des films uniformes sur des surfaces conductrices. Cette méthode ne s'applique pas aux pièces non conductrices et ne peut s'effectuer qu'à l'aide de polymères chargés déjà synthétisés au préalable. Il n'y a donc pas de croissance de films lors de l'utilisation de la cataphorèse mais seulement le dépôt de ceux-ci sur la surface. De plus, le traitement nécessite que les pièces soient en contact direct avec la cathode ainsi qu'un contrôle très strict des paramètres du bain cathodique qui sont à respecter. La couche électrodéposée est insoluble mais sans résistance physique ou chimique et nécessite donc une étape supplémentaire d'étuvage afin d'acquérir toutes ces propriétés. Cette technique reste cependant peu adaptée aux pièces de petites tailles de géométrie complexe.

L'auto-assemblage de monocouches est une technique très simple à mettre en oeuvre (Ulman A., « An introduction to ultrathin organic films from Langmuir-Blodgett films to self-assembly », 1991, Boston, Academic Press). Cette technique requiert toutefois l'utilisation de précurseurs généralement moléculaires possédant une affinité suffisante pour la surface d'intérêt à revêtir. On parlera alors de couple précurseur-surface, tels les composés soufrés ayant une affinité pour l'or ou l'argent, les tri-halogéno silanes pour les oxydes comme la silice ou l'alumine, les polyaromatiques pour le graphite ou les nanotubes de carbone. Dans tous les cas, la formation du film repose sur une réaction chimique spécifique entre une partie du précurseur moléculaire (l'atome de soufre dans le cas des thiols par exemple) et certains sites « récepteurs » de la surface. Une réaction de chimisorption assure l'accrochage. On obtient ainsi, à température ambiante et en solution, des films d'épaisseur moléculaire (moins de 10 nm). Cependant, si les couples impliquant des surfaces d'oxyde donnent lieu à la formation de films très solidement greffés (la liaison Si-O impliquée dans la chimisorption de tri-halogéno silanes sur silice est parmi les plus stables de la chimie), il n'en est rien lorsque l'on s'intéresse aux métaux ou aux semi-conducteurs sans oxyde. Dans ces cas, la liaison d'interface entre la surface conductrice et le film monomoléculaire est fragile. Ainsi, les monocouches auto-assemblées de thiols sur or désorbent dès qu'on les chauffe au-dessus de 60°C, ou en présence d'un bon solvant à température ambiante, ou encore dès qu'elles sont mises en contact avec un milieu liquide oxydant ou réducteur. De façon semblable, les liaisons Si-O-Si sont fragilisées dès qu'elles se trouvent en milieu aqueux voire humide, en particulier sous l'effet de la chaleur.

L'électrogreffage de polymères est une technique basée sur l'initiation puis la polymérisation, par propagation en chaîne, électro-induite de monomères électro-actifs sur la surface d'intérêt jouant à la fois le rôle d'électrode et celui d'amorceur de polymérisation (Palacin, S., et al., « Molecule-to-metal bonds: Electrografting polymers on conducting surfaces ». Chemphyschem, 2004. 5(10): p. 1469-1481). L'électrogreffage requiert l'utilisation de précurseurs adaptés à son mécanisme d'initiation par réduction et de propagation, en général anionique car on préfère souvent l'électrogreffage initié cathodiquement, applicable sur les métaux nobles et non nobles (contrairement à l'électrogreffage par polarisation anodique qui n'est applicable que sur des substrats nobles ou carbonés : graphite, carbone vitreux, diamant dopé bore). Les molécules « vinyliques appauvries », c'est-à-dire porteuses de groupements fonctionnels électro-attracteurs, comme les acrylonitriles, les acrylates, les vinyl-pyridines... sont particulièrement adaptées à ce procédé qui donne lieu à de nombreuses applications dans le domaine de la microélectronique ou du biomédical. L'adhérence des films électrogreffés est assurée par une liaison covalente carbone-métal (G. Deniau et al., « Carbon-to-metal bonds : electroreduction of 2-butenenitrile » Surf. Sci. 2006, 600, 675).

Selon cette technique d'électrogreffage, la polymérisation est indispensable à la formation de la liaison d'interface carbone/métal : il a été en effet montré (G. Deniau et al., « Coupled chemistry revisited in the tentative cathodic electropolymerization of 2-butenenitrile. », Journal of Electroanalytical Chemistry, 1998, 451, 145-161) que le mécanisme de l'électrogreffage procède par une électro-réduction du monomère au voisinage immédiat de la surface, pour donner un radical anion instable capable de se greffer de façon covalente par sa terminaison radicalaire sur l'électrode. L'anion greffé ainsi obtenu, s'il n'était pas à proximité immédiate de molécules polymérisables, désorberait pour retourner en solution (op.cit.). En compétition avec cette réaction de désorption, la réaction d'addition (de type addition de Michaël) de la charge du premier anion chimisorbé sur un monomère libre offre un second moyen de stabiliser l'intermédiaire réactionnel : le produit de cette addition donne à nouveau un anion greffé, où la charge s'est cependant « éloignée » de la surface, ce qui contribue à stabiliser l'édifice adsorbé. Cet anion dimérique peut lui-même à nouveau s'additionner à un monomère libre, et ainsi de suite, chaque nouvelle addition apportant une stabilité supplémentaire par relaxation de la répulsion charge/surface polarisée, ce qui revient à dire que la liaison d'interface du premier radical anion, temporaire, devient stable à mesure que la polymérisation a lieu.

Parmi les différentes techniques rappelées précédemment, l'électrogreffage est la seule technique qui permette de produire des films greffés avec un contrôle spécifique de la liaison d'interface. En effet, la seule technique permettant de greffer des films de polymères issus de monomères vinyliques activés sur des surfaces, nécessairement conductrices, consiste à électro-initier la réaction de polymérisation à partir de la surface via un potentiostat, suivie d'une croissance des chaînes, monomère par monomère nécessitant l'emploi d'une cellule électrochimique avec une cathode et une anode ainsi qu'une application d'une tension aux bornes de celles-ci.

Ortiz et al. ont décrit le greffage de sels de diazonium synthétisés *in situ* en phase aqueuse acide par activation électrochimique (« Electrochemical modification of a carbon electrode using aromatic diazonium saluts. 2. Electrochemistry of 4-nitrophenyl modified glassy carbon electrodes in aqueous media. » Journal of Electroanalytical Chemistry, 1998. 455(1-2)). La demande internationale WO 03/018212 et la demande de brevet FR 2 829 046 décrivent notamment un procédé de greffage et de croissance d'un film organique conducteur sur une surface conductrice de l'électricité, le greffage et la croissance étant réalisés simultanément par électroréduction d'un sel de diazonium précurseur dudit film organique.

La demande de brevet FR 2 851 181 propose un procédé de revêtement d'une surface par un premier et un second matériaux via le dépôt sur ladite surface du premier matériau, l'insertion au sein du premier matériau d'un précurseur du second matériau et la transformation de ce précurseur en ledit second matériau. Le premier matériau obtenu à partir de monomères vinyliques ou de sels de diazonium, de sulfonium, de phosphonium, d'iodonium, fonctionnalisés ou non, peut être fixé par électrogreffage sur la surface.

La demande de brevet FR 2 841 908 propose un support solide avec au moins une région (semi)conductrice de l'électricité sur lequel est électrogreffé un film organique obtenu à partir de précurseurs organiques électro-actifs comportant des groupements fonctionnels d'intérêt et de précurseurs organiques électro-actifs ne comportant pas des groupements fonctionnels d'intérêt. Les précurseurs organiques mis en oeuvre sont notamment des monomères polymérisables et électrogreffables.

Toutefois, il n'a pas été proposé à ce jour une solution technique pour réaliser des revêtements organiques greffés sur tout type de surface, en conditions non-électrochimiques et ne nécessitant aucune technique de prétraitement particulière.

### EXPOSÉ DE L'INVENTION

La présente invention permet de résoudre les inconvénients des procédés et des revêtements de l'état de la technique et se différencie de l'art antérieur notamment en ce qu'elle permet d'effectuer le greffage de films de polymères ou de copolymères organiques en absence de tension électrique. Le procédé proposé permet ainsi de greffer des films sur des surfaces de natures variées et son application n'est pas limitée aux surfaces conductrices ou semiconductrices de l'électricité.

La présente invention concerne un procédé de préparation d'un film organique à la surface d'un support solide tel que défini par les revendications 1 à 16, 17 à 18 et 19.

Au sens de la présente invention, on entend par « film organique », tout film de nature organique, issu de plusieurs unités d'espèces chimiques organiques, lié de manière covalente à la surface du support sur lequel est effectué le procédé objet de l'invention. Il s'agit particulièrement d'un film lié de manière covalente à la surface d'un support et comprenant au moins une couche d'unités structurales de nature similaires. Selon l'épaisseur du film, sa cohésion est assurée par les liaisons covalentes qui se développent entre les différentes unités.

Le solvant employé dans le cadre du procédé, également désigné dans la présente par « solvant de réaction » peut être de nature protique ou aprotique. Il est préférable que le primaire qui est employé soit soluble dans le solvant de réaction.

Par « solvant protique », on entend, dans le cadre de la présente invention, un solvant qui comporte au moins un atome d'hydrogène susceptible d'être libéré sous forme de proton.

Le solvant protique est avantageusement choisi dans le groupe constitué par l'eau, l'eau désionisée, l'eau distillée, acidifiées ou non, l'acide acétique, les solvants hydroxylés comme le méthanol et l'éthanol, les glycols liquides de faible poids moléculaire tels que l'éthylèneglycol, et leurs mélanges. Dans une première variante, le solvant protique utilisé dans le cadre de la présente invention n'est constitué que par un solvant protique ou par un mélange de différents solvants protiques. Dans une autre variante, le solvant protique ou le mélange de solvants protiques peut être utilisé en mélange avec au moins un solvant aprotique, étant entendu que le mélange résultant présente les caractéristiques d'un solvant protique. L'eau acidifiée est le solvant protique préféré et, plus particulièrement, l'eau distillée acidifiée ou l'eau désionisée acidifiée.

Par « solvant aprotique », on entend, dans le cadre de la présente invention, un solvant qui n'est pas considéré comme protique. De tels solvants ne sont pas susceptibles de libérer un proton ou d'en accepter un dans des conditions non extrêmes.

Le solvant aprotique est avantageusement choisi parmi la diméthylformamide (DMF), l'acétone et le diméthyl sulfoxyde (DMSO).

Le terme "primaire d'adhésion" correspond, dans le cadre de la présente invention, à toute molécule organique susceptible, sous certaines conditions, de se chimisorber à la surface d'un support solide par réaction radicalaire tel qu'un greffage chimique radicalaire. De telles molécules comportent au moins un groupe fonctionnel susceptible de réagir avec un radical et également une fonction réactive vis-à-vis d'un autre radical après chimisorption. Ces molécules sont ainsi capables de former un film de nature polymérique après greffage d'une première molécule à la surface d'un support puis réaction avec d'autres molécules présentes dans son environnement.

Le terme « greffage chimique radicalaire » se réfère notamment à l'utilisation d'entités moléculaires possédant un électron non apparié pour former des liaisons de type liaison covalente avec une surface d'intérêt, lesdites entités moléculaires étant générées indépendamment de la surface sur laquelle elles sont destinées à être greffées. Ainsi, la réaction radicalaire conduit à la formation de liaisons covalentes entre la surface concernée et le dérivé du primaire d'adhésion greffé puis entre un dérivé greffé et des molécules présentes dans son environnement.

Par « dérivé du primaire d'adhésion », on entend, dans le cadre de la présente invention, une unité chimique résultant du primaire d'adhésion, après que ce dernier a réagi par greffage chimique radicalaire notamment avec la surface du support solide, ou avec un autre radical, mis en oeuvre dans le cadre de la présente invention. Il est clair pour l'homme du métier que la fonction réactive vis-à-vis d'un autre radical après chimisorption du dérivé du primaire d'adhésion est différente de la fonction impliquée dans la liaison covalente notamment avec la surface du support solide.

Le primaire d'adhésion est un sel d'aryle clivable choisi dans le groupe constitué par les sels d'aryle diazonium, les sels d'aryle d'ammonium, les sels d'aryle phosphonium et les sels d'aryle sulfonium. Dans ces sels, le groupe aryle est un groupe aryle qui peut être représenté par R tel que défini ci-après.

Parmi les sels d'aryle clivables, on peut en particulier citer les composés de formule (I) suivante :

R-N₂⁺, A⁻ (I)

dans laquelle :
- A représente un anion monovalent et
- R représente un groupe aryle.

A titre de groupe aryle des sels d'aryle clivables et notamment des composés de formule (I) ci-dessus, on peut avantageusement citer les structures carbonées aromatiques ou hétéroaromatiques, éventuellement mono- ou polysubstituées, constituées d'un ou plusieurs cycles aromatiques ou hétéroaromatiques comportant chacun de 3 à 8 atomes, le ou les hétéroatomes pouvant être N, O, P ou S. Le ou les substituants peuvent contenir un ou plusieurs hétéroatomes, tels que N, O, F, Cl, P, Si, Br ou S ainsi que des groupes alkyles en C₁ à C₆ notamment.

Au sein des sels d'aryle clivables et notamment des composés de formule (I) ci-dessus, R est de préférence choisi parmi les groupes aryles substitués par des groupements attracteurs d'électrons tels que NO₂, COH, les cétones, CN, CO₂H, NH₂, les esters et les halogènes. Les groupes R de type aryle particulièrement préférés sont les radicaux nitrophényle et phényle.

Au sein des composés de formule (I) ci-dessus, A peut notamment être choisi parmi les anions inorganiques tels que les halogénures comme I⁻, Br⁻ et Cl⁻, les halogénoborates tels que le tetrafluoroborate, et les anions organiques tels que les alcoolates, les carboxylates, les perchlorates et les sulfonates.

A titre de composés de formule (I), il est particulièrement avantageux d'utiliser un composé choisi dans le groupe constitué par le tétrafluoroborate de phényldiazonium, le tétrafluoroborate de 4-nitrophényldiazonium, le tétrafluoroborate de 4-bromophényldiazonium, le chlorure de 4-aminophényldiazonium, le chlorure de 2-méthyl-4-chlorophényldiazonium, le tétrafluoroborate de 4-benzoylbenzènediazonium, le tétrafluoroborate de 4-cyanophényldiazonium, le tétrafluoroborate du 4-carboxyphényldiazonium, le tétrafluoroborate de 4-acétamidophényldiazonium, le tétrafluoroborate de l'acide 4-phénylacétique diazonium, le sulfate de 2-méthyl-4-[(2-méthylphényl)diazényl]benzènediazonium, le chlorure de 9,10-dioxo-9,10-dihydro-1-anthracènediazonium, le tétrafluoroborate de 9-nitronaphtalènediazonium et le tétrafluoroborate de naphtalènediazonium.

Il est préférable que le primaire d'adhésion soit soluble dans le solvant utilisé. Au sens de l'invention, un primaire d'adhésion est considéré comme soluble dans un solvant donné s'il demeure soluble jusqu'à une concentration de 0,5 M, *i.e*. que sa solubilité soit au moins égale à 0,5 M dans les conditions normales de température et de pression (CNTP). La solubilité est définie comme la composition analytique d'une solution saturée en fonction de la proportion d'un soluté donné dans un solvant donné ; elle peut notamment s'exprimer en molarité. Un solvant contenant une concentration donnée d'un composé sera considéré comme saturé, lorsque la concentration sera égale à la solubilité du composé dans ce solvant. La solubilité peut être finie comme infinie. Dans ce dernier cas, le composé est soluble en toute proportion dans le solvant considéré.

La quantité de primaire d'adhésion présente dans la solution utilisée conformément au procédé selon l'invention peut varier en fonction du souhait de l'expérimentateur. Cette quantité est notamment liée à l'épaisseur de film organique désirée ainsi qu'à la quantité de primaire d'adhésion qu'il est possible et envisageable d'intégrer au film. Ainsi pour obtenir un film greffé sur l'ensemble de la surface du support solide en contact avec la solution, il faut employer une quantité minimale de primaire d'adhésion qu'il est possible d'estimer par des calculs d'encombrement moléculaire. Selon une forme de réalisation particulièrement avantageuse de l'invention, la concentration en primaire d'adhésion au sein de la solution liquide est comprise entre 10⁻⁶ et 5 M environ, de préférence entre 5.10⁻² et 10⁻¹ M. Une couche dite « d'accroche » est formée lorsque la surface est recouverte par au moins un film d'épaisseur monomoléculaire dérivé du primaire d'adhésion et notamment dérivé du diazonium. Le film organique peut ainsi être constitué uniquement par une couche d'accroche. Il est bien entendu possible d'employer tout moyen d'analyse pour contrôler la présence de la couche d'accroche et déterminer son épaisseur, de tels moyens peuvent notamment être des mesures de spectrométrie infrarouge (IR) ou de spectroscopie de photoélectrons X (XPS) et ultraviolets (UV) en fonction des atomes et groupes chimiques présents sur le primaire d'adhésion employé.

Lorsque le solvant est un solvant protique, et avantageusement, dans le cas où le primaire d'adhésion est un sel d'aryle diazonium, le pH de la solution est inférieur à 7, typiquement inférieur ou égal à 3. Il est recommandé de travailler à un pH compris entre 0 et 3. Si nécessaire, le pH de la solution peut être ajusté à la valeur désirée à l'aide d'un ou plusieurs agents acidifiants bien connus de l'homme du métier, par exemple à l'aide d'acides minéraux ou organiques tels que l'acide chlorhydrique, et l'acide sulfurique.

Le primaire d'adhésion peut soit être introduit en l'état dans la solution liquide telle que définie précédemment, soit être préparé *in situ* dans cette dernière. Ainsi, dans une forme de mise en oeuvre particulière, le procédé selon la présente invention comporte une étape de préparation du primaire d'adhésion, notamment lorsque celui-ci est un sel d'aryle diazonium. De tels composés sont généralement préparés à partir d'aryleamine, pouvant comporter plusieurs substituants amine, par réaction avec NaNO₂ en milieu acide. Pour un exposé détaillé des modes expérimentaux utilisables pour une telle préparation *in situ,* l'homme du métier pourra se reporter à la littérature ouverte [D. Belanger et al. Chem. Mater. 18 (2006) 4755-4763]. De préférence, le greffage sera alors réalisé directement dans la solution de préparation du sel d'aryle diazonium.

Par « conditions non-électrochimiques », on entend dans le cadre de la présente invention en absence de tension électrique. Ainsi, les conditions non-électrochimiques sont des conditions qui permettent la formation d'entités radicalaires à partir du primaire d'adhésion, en l'absence de l'application d'une quelconque tension électrique à la surface du support solide ou dans la solution liquidé. Ces conditions impliquent des paramètres tels que, par exemple, la température, la nature du solvant, la présence d'un additif particulier dans la solution, l'agitation alors que le courant électrique n'intervient pas lors de la formation des entités radicalaires. Les conditions non-électrochimiques permettant la formation d'entités radicalaires sont nombreuses et ce type de réaction est connu et étudié en détail dans l'art antérieur (Rempp & Merrill, Polymer Synthesis, 1991, 65-86, Hüthig & Wepf).

Il est ainsi par exemple possible d'agir sur l'environnement thermique, cinétique, chimique, photochimique ou radiochimique du primaire d'adhésion afin de le déstabiliser pour qu'il forme une entité radicalaire. Il est bien entendu possible d'agir simultanément sur plusieurs de ces paramètres.

L'environnement thermique est fonction de la température de la solution. Son contrôle est aisé avec les moyens de chauffage habituellement employés par l'homme du métier. L'utilisation d'un environnement thermostaté présente un intérêt particulier puisqu'il permet un contrôle précis des conditions de réaction.

L'environnement cinétique correspond essentiellement à l'agitation au sein de la solution. Il ne s'agit pas ici de l'agitation des molécules en elle-même (élongation de liaisons), mais du mouvement global des molécules au sein de la solution. Une agitation vigoureuse, par exemple à l'aide d'un barreau magnétique ou encore d'ultrasons, permet notamment d'apporter de l'énergie cinétique à la solution et ainsi de déstabiliser le primaire d'adhésion pour qu'il forme des radicaux.

Enfin, l'action de rayonnements divers tels que rayonnements électromagnétiques, rayonnements γ, rayons UV, faisceaux d'électrons ou d'ions peut également déstabiliser suffisamment le primaire d'adhésion pour qu'il forme des radicaux, la longueur d'onde employée sera fonction du primaire utilisée, par exemple 306 nm pour le 4-hexylbenzènediazonium.

Dans le cadre de la présente invention, les conditions non-électrochimiques permettant la formation d'entités radicalaires sont typiquement choisies dans le groupe constitué par les conditions thermiques, cinétiques, chimiques, photochimiques, radiochimiques et leurs combinaisons. Avantageusement, les conditions non-électrochimiques permettant la formation d'entités radicalaires sont choisies dans le groupe constitué par les conditions thermiques, chimiques, photochimiques, radiochimiques et leurs combinaisons entre elles et/ou avec les conditions cinétiques. Les conditions non-électrochimiques sont plus particulièrement des conditions chimiques.

Dans le cadre des conditions chimiques, on envisage d'ajouter à la solution liquide telle que précédemment définie un ou plusieurs amorceur(s) chimique(s). En effet, il est également possible d'agir sur l'environnement chimique du primaire d'adhésion en ajoutant à la solution liquide un ou plusieurs amorceur(s) chimique(s). La présence d'amorceurs chimiques est souvent couplée à des conditions environnementales non chimiques, telles qu'exposées ci-dessus. Typiquement, un amorceur chimique dont la stabilité est moins grande que celle du primaire d'adhésion dans les conditions environnementales choisies va évoluer sous une forme instable qui agira sur le primaire d'adhésion et engendrera la formation d'entité radicalaire à partir de ce dernier. Il est également possible d'employer des amorceurs chimiques dont l'action n'est pas liée essentiellement aux conditions environnementales et qui peuvent agir sur de vastes plages de conditions thermiques ou encore cinétiques par exemple. L'amorceur sera de préférence adapté au solvant de la réaction, il est en effet préférable que l'amorceur soit soluble dans le solvant de réaction.

Il existe de nombreux amorceurs chimiques de polymérisation radicalaire. On en distingue grossièrement trois types en fonction des conditions environnementales employées :
- les *amorceurs thermiques* dont les plus courants sont les peroxydes ou les composés azoïques. Sous l'action de la chaleur, ces composés se dissocient en radicaux libres ; dans ce cas la réaction est effectuée à une température minimum correspondant à celle nécessaire à la formation de radicaux à partir de l'amorceur. Ce type d'amorceurs chimiques est en général utilisé spécifiquement dans un certain intervalle de température, en fonction de leur cinétique de décomposition ;
- les *amorceurs photochimiques* ou *radiochimiques* qui sont excités par le rayonnement déclenché par irradiation (le plus souvent par UV, mais aussi par radiations γ ou par faisceaux d'électrons) permettent la production de radicaux par des mécanismes plus ou moins complexes. Le Bu₃SnH et l'I₂ appartiennent aux amorceurs photochimiques ou radiochimiques ;
- les *amorceurs essentiellement chimiques,* ce type d'amorceurs agissant rapidement et dans des conditions normales de température et de pression sur le primaire d'adhésion pour lui permettre de former des radicaux. De tels amorçeurs ont généralement un potentiel d'oxydoréduction qui est inférieur au potentiel de réduction du primaire d'adhésion utilisé dans les conditions de réaction. Selon la nature du primaire, il peut ainsi s'agir par exemple d'un métal, généralement sous forme finement divisée, comme de la laine (également appelée plus communément « paille ») métallique ou de la limaille métallique, réducteur, tel que du fer, zinc, nickel, d'un sel métallique et particulièrement sous forme d'un métallocène, d'un réducteur organique comme l'acide hypophosphoreux (H₃PO₂) ou l'acide ascorbique, ou encore d'une base organique ou inorganique dans des proportions suffisantes pour permettre une déstabilisation du primaire d'adhésion ; généralement un pH supérieur ou égal à 4 est suffisant. Des structures de type réservoir de radicaux, comme des matrices polymériques préalablement irradiées par un faisceau d'électrons ou par un faisceaux d'ions lourds et/ou par l'ensemble des moyens d'irradiations cités précédemment, peuvent également être employées en tant qu'amorceurs chimiques pour déstabiliser le primaire d'adhésion et conduire à la formation d'entités radicalaires à partir du primaire.

Avantageusement, la solution liquide mise en oeuvre dans le cadre du procédé selon l'invention comprend en outre un ou plusieurs amorceur(s) chimique(s) choisi(s) parmi :
- un métal réducteur sous forme finement divisée tel que défini dans la présente,
- un métallocène,
- une base organique ou inorganique dans des proportions suffisantes pour que le pH de la solution liquide soit supérieur ou égal à 4,
- une matrice polymérique préalablement irradiée, telle que définie dans la présente.

Parmi les amorceurs susceptibles d'être employés dans le cadre de l'invention, et notamment lorsque le primaire d'adhésion est un sel d'aryle clivable tel qu'un sel d'aryle diazonium, on peut notamment citer les amorceurs halogénés comme l'iode, les α-halogénoalkyles possédant des groupement aryle, allyle, carbonyle ou sulfonyle, les composés polyhalogénés comme le CCl₄ ou le CHCl₃, les composés possédant des liaisons covalentes très labiles avec des halogènes et correspondant généralement à des liaisons établies entre un hétéroatome, tel que N, S ou O, et un halogène, le persulfate de potassium (K₂S₂O₈), l'azobis(isobutyronitrile), les composés peroxydés comme le peroxyde de benzoyle, le peroxyde de tert-butyle, le peroxyde de cumyle, le perbenzoate de tert-butyle, l'hydroperoxyde de tert-butyle, les métaux réducteurs finement divisés tel que le fer, le zinc, le nickel, de préférence sous forme de limaille, de fines particules ou de fibres de laine métallique, les sels métalliques, particulièrement les métallocènes comme le ferrocène, des matrices polymériques irradiées et notamment des matrices de polymères choisis parmi les polyuréthanes, les polyoléfines, les polycarbonates, les polyéthylènetéréphtalates, ces polymères étant avantageusement fluorés voir perfluorés.

La quantité d'amorceur sera choisie selon les conditions opératoires employées. Généralement, il s'agit de quantités comprises entre 5 et 20% en masse de monomères, typiquement aux alentours de 10%. Ainsi, par exemple, lorsque le primaire d'adhésion est un sel d'aryle diazonium, il est possible d'employer comme amorceur de la limaille de fer, dont le diamètre des particules est compris entre 50 et 250 µm. Il est également possible d'employer de la laine de fer ou d'acier, celle-ci sera généralement de type (degré de finesse) fine (0), extra fine (00) ou super fine (000). Plus particulièrement le diamètre des fibres de la laine sera inférieur ou égal à 3, 81. 10⁻² mm et typiquement supérieur à 6, 35.10⁻³ mm. Alternativement, il est possible de se placer dans des conditions basiques telles que le pH de la solution soit suffisamment élevé pour conduire à une déstabilisation du primaire d'adhésion sous forme de radicaux.

Il est aussi possible d'utiliser des matrices irradiées sous des formes variées comme des membranes. Typiquement, une telle membrane aura une épaisseur micrométrique, généralement comprise entre 1 et 100 pm, notamment entre 5 et 50 µm, et, plus particulièrement, proche de 9 µm. Il s'agira avantageusement d'une membrane de polyfluorure de vinylidène (PVDF). En particulier, il est possible d'employer une membrane de polyfluorure de vinylidène (PVDF) irradiée aux électrons. La dose d'irradiation est généralement comprise entre 10 et 200 kGy, plus particulièrement 100 kGy pour le PVDF. Une telle membrane pourra par exemple avoir des dimensions de 1 cm x 2 cm x 9 µm soit une surface totale d'environ 4.0054 cm².

Il est également possible d'employer une matrice polymérique préalablament irradiée se présentant sous forme :
- de granules, par exemple d'un diamètre moyen de 200 µm à 1 cm,
- de microparticules, par exemple de 1 µm à 100 µm de diamètre, ou encore
- de nanoparticules, généralement de 5 nm à 900 nm de diamètre.

En effet, la diminution du diamètre des particules permet d'augmenter la surface de contact spécifique et donc la quantité de radicaux en surface par rapport à la même masse de matériau polymérique irradié sous forme de membrane. Typiquement, la surface de contact spécifique de la matrice irradiée disponible sera très inférieure à celle de la surface du support solide sur lequel le greffage doit être réalisé.

L'irradiation d'une matrice polymérique peut consister à soumettre ladite matrice à un faisceau d'électrons (appelée également irradiation électronique). Plus particulièrement, cette étape peut consister à balayer la matrice polymérique avec un faisceau d'électrons accélérés, ce faisceau pouvant être émis par un accélérateur d'électrons (par exemple, un accélérateur Van de Graaf, 2,5 MeV). Dans le cas de l'irradiation par faisceau d'électrons, le dépôt d'énergie est homogène, ce qui signifie que les radicaux libres créés par cette irradiation seront répartis uniformément à la surface et dans le volume de la matrice.

L'étape d'irradiation d'une matrice polymérique peut également consister à soumettre ladite matrice à un bombardement par des ions lourds. On précise que par « ions lourds », on entend des ions dont la masse est supérieure à celle du carbone. Généralement, il s'agit d'ions choisis parmi le krypton, le plomb et le xénon.

Que ce soit pour le premier mode ou le second mode de réalisation ci-dessus, l'irradiation crée des radicaux libres dans le matériau constitutif de la matrice, cette création de radicaux libres étant une conséquence du transfert d'énergie de l'irradiation audit matériau.

Les radicaux présents dans une telle matrice irradiée peuvent être piégés dans des cristallites, afin de prolonger la durée de vie de la matrice sous forme irradiée. Il est donc recommander d'employer des matrices comportant des cristallites et, de préférence, entre 30% et 50%, généralement 40% de cristallites en volume. Ainsi, par exemple, le polyfluorure de vinylidène (PVDF) est de nature semi-cristalline (il présente généralement 40% de cristallinité et 60% de forme amorphe) et peut se présenter sous plusieurs phases cristallines, α, β, γ et δ constituées par l'association, planaire ou en hélice, de chaînes. Les phases α et β sont les plus courantes. Le PVDF est un polymère thermoplastique qui peut donc être fondu puis moulé. Ainsi, le PVDF majoritairement à base de phase α est généralement obtenu par refroidissement à partir de l'état fondu, par exemple après extrusion simple. Le PVDF majoritairement à base de phase β est généralement obtenu par bi-étirage à froid, à moins de 50°C, de PVDF majoritairement à base de phase α. Il est recommandé d'employer du PVDF comportant majoritairement de la phase β car la cristallinité est plus grande dans ce cas.

Afin d'augmenter la quantité de radicaux accessibles à la surface des polymères irradiés se présentant sous les différentes formes décrites précédemment, la surface spécifique de contact des matériaux polymériques avec la solution peut être avantageusement augmentée en les rendant micro ou nanoporeux. Afin d'obtenir ce type de matériaux, l'étape d'irradiation peut se dérouler de la manière suivante :
- irradiation de la matrice polymérique par des ions lourds ;
- révélation chimique, généralement par hydrolyse, des traces latentes créées par le passage des ions lourds, à l'issue de laquelle l'on obtient des canaux ouverts ;
- irradiation électronique desdits canaux ouverts.

La révélation chimique consiste à mettre en contact la matrice avec un réactif apte à hydrolyser les traces latentes, de façon à former des canaux creux à la place de celles-ci.

Selon ce mode de réalisation particulier, suite à l'irradiation de la matrice polymérique par des ions lourds, les traces latentes générées présentent des chaînes courtes de polymères formées par scission des chaînes existantes lors du passage de l'ion dans la matière durant l'irradiation. Dans ces traces latentes, la vitesse d'hydrolyse lors de la révélation est plus importante que celles des parties non irradiées. Ainsi, il est possible de procéder à une révélation sélective.

Les réactifs susceptibles d'assurer la révélation des traces latentes sont fonction du matériau constitutif de la matrice. Ainsi, les traces latentes peuvent notamment être traitées par une solution fortement basique et oxydante, comme une solution KOH 10N en présence de KMnO₄ à 0,25% en poids à une température de 65°C, lorsque la matrice polymérique est, par exemple, constituée de polyfluorure de vinylidène (PVDF), de poly(VDF-co-HFP) (fluorure de vinylidène-co-hexafluoropropène), de poly(VDF-co-TrFE) (fluorure de vinylidène-co-trifluoroéthylène), poly(VDF-co-TrFE-co-ChloroTrFE) (fluorure de vinylidène-co-trifluoroéthylène-co-monochlorotrifluoroéthylène) et autres polymères perfluorés. Un traitement avec une solution basique, éventuellement couplée avec une sensibilisation des traces par UV, peut suffire, par exemple, pour des polymères comme du polyéthylene téréphthalate (PET) et du polycarbonate (PC). Le traitement conduit à la formation de pores cylindriques, creux dont le diamètre est modulable en fonction du temps d'attaque avec la solution basique et oxydante. Généralement l'irradiation sera effectuée de telle sorte que la membrane comporte un nombre de trace par cm² compris entre 10⁶ et 10¹¹. Typiquement il sera compris entre 5.10⁷ et 5.10¹⁰, plus spécialement de l'ordre de 10¹⁰ pour les membranes. D'autres informations concernant les réactifs et les conditions opératoires utilisables pour la révélation chimique en fonction du matériau constitutif de la matrice peuvent être trouvées dans Rev. Mod. Phys., Vol. 55, N° 4, oct.1983, p.925.

Après cette étape de révélation, l'irradiation aux électrons est effectuée pour induire la formation de radicaux libres sur la paroi des canaux, la mise en oeuvre étant, dans ce cas, similaire à celle qui a été exposée pour l'irradiation électronique en général. Généralement, le faisceau est orienté dans une direction normale à la surface de la membrane et la surface de celle-ci est balayée de façon homogène. La dose d'irradiation varie généralement de 10 à 200 kGy pour le radiogreffage ultérieur, elle sera typiquement proche de 100 kGy pour le PVDF. La dose est généralement telle qu'elle est supérieure à la dose gel. Cette dernière correspond à la dose à partir de laquelle les recombinaisons entre radicaux sont favorisées entraînant la création de liaisons interchaînes menant à la formation d'un réseau tridimensionnel (ou encore réticulation) c'est-à-dire la formation d'un gel. Ainsi, le fait d'utiliser une dose supérieure à la dose gel permet d'induire, en même temps, des réticulations permettant ainsi d'améliorer les propriétés mécaniques du polymère final.

A titre d'exemple non limitatif, une membrane de PVDF de 2 cm² et d'épaisseur de 9 µm voit sa surface de contact spécifique augmenter d'environ 4 cm² à environ 60 cm² pour la même membrane possédant 10¹⁰ pores par cm² d'un diamètre moyen de 10 nm permettant ainsi un nombre relatif de radicaux présents en surface 15 fois plus grand que pour la même membrane non poreuse.

La solution liquide mise en oeuvre dans le cadre de la présente invention peut en outre contenir au moins un tensioactif tel que décrit et défini ultérieurement.

Le support solide dont la surface est traitée selon le procédé de l'invention peut être de toute nature. En effet, c'est à la surface de l'échantillon en contact avec la solution qu'aura lieu la réaction de greffage radicalaire. Ainsi, la surface du support solide à traiter conformément au procédé selon la présente invention présente typiquement au moins un atome pouvant être impliqué dans une réaction radicalaire. Le support solide peut être conducteur ou non conducteur de l'électricité. Le support solide peut présenter une surface plus ou moins grande et une rugosité variable. Le procédé est applicable à des échantillons de taille nanométrique ou métrique. Ainsi, par exemple, le procédé peut être appliqué à des surfaces de nano-objets comme des nanoparticules ou des nanotubes, typiquement de carbone, ou à des dispositifs plus complexes.

L'invention est applicable à une grande diversité de surfaces d'intérêt, dont la composition peut-être choisie parmi une grande variété de matériaux. En effet, le procédé met à profit un greffage de nature purement radicalaire, il ne nécessite pas que la surface présente des caractéristiques spécifiquement limitantes telles qu'une conductivité élevée. Ainsi la surface peut être de nature organique ou non organique, et également être de nature composite et présenter une composition non uniforme. Toute surface présentant un ou plusieurs atome(s) ou groupement(s) d'atomes pouvant être impliqué(s) dans une réaction d'addition ou de substitution radicalaire, tel que CH, les carbonyles (cétone, ester, acide, aldéhyde), OH, les éthers, les amines, les halogènes, comme F, Cl, Br, est notamment concernée par la présente invention.

Le support solide peut présenter une surface inorganique qui peut être choisie parmi les matériaux conducteurs comme les métaux, les métaux nobles, les métaux oxydés, les métaux de transition, les alliages métalliques et par exemple Ni, Zn, Au, Pt, Ti, l'acier. La surface inorganique peut également être choisie parmi les matériaux semi-conducteurs comme Si, SiC, AsGa, et Ga. Il est également possible d'appliquer le procédé à des supports solides présentant une surface non conductrice comme les oxydes non conducteurs tels que SiO₂, Al₂O₃ et MgO. De manière plus générale, la surface inorganique du support solide peut être constituée, par exemple, d'un matériau amorphe, tel qu'un verre contenant généralement des silicates ou encore une céramique, aussi bien que cristallin comme le diamant.

Le support solide non-conducteur de l'électricité sur lequel est greffé un film organique est défini par les revendications 20 à 21.

Le support solide peut présenter une surface organique. A titre de surface organique, on peut citer des polymères naturels comme le latex ou le caoutchouc, ou artificiels comme les dérivés de polyamide ou de polyéthylène, et notamment les polymères présentant des liaisons de type n comme les polymères portant des liaisons éthylèniques, des groupements carbonyles, imine. Il est également possible d'appliquer le procédé à des surfaces organiques plus complexes telles que des surfaces comprenant des polysaccharides, comme la cellulose pour le bois ou le papier, des fibres artificielles ou naturelles, comme le coton ou le feutre, ainsi que des polymères fluorés tels que le polytétrafluoroéthylène (PTFE). On peut bien entendu appliquer le procédé à une surface correspondant à une couche d'accroche ainsi qu'elle a été préalablement définie.

Avantageusement, le support solide et/ou la surface du support solide mis en oeuvre dans le cadre de la présente invention sont constitués d'un matériau choisi dans le groupe constitué par les métaux, le bois, le papier, le coton, le feutre, le silicium, les nanotubes en carbone, les polymères fluorés et le diamant.

Selon un mode de réalisation particulier la surface du support solide sur laquelle le film organique doit être formé est équipée d'un masque qui la recouvre au moins en partie et qui l'isole de la solution liquide. Le masque correspond typiquement à une entité physique qui n'est ni greffée à la surface, ni liée de manière covalente à celle-ci. Il peut notamment s'agir d'un matériau massif ou d'une mince couche de matière, typiquement de quelques Ångstrom à quelques microns, généralement de nature organique, déposée sur la surface.

Le masque permet de « masquer » localement la réactivité chimique de la surface à l'égard des radicaux générés durant le procédé et entraîne ainsi la formation de manière contrôlée d'un film uniquement sur les parties de la surface exposées à la solution, les zones de la surface du support équipées par le masque étant préservées de la formation du film organique. La surface du support solide mise au contact de la solution liquide telle que précédemment définie comporte ainsi typiquement au moins une zone recouverte d'un masque. Après élimination du masque en fin d'opération, la surface qui était protégée, contrairement à celle qui n'était pas équipée d'un masque, ne comporte pas de film greffé.

De préférence, le masque sera constitué d'une mince couche de matière inorganique ou organique agissant comme une couche de moindre cohésion aisément éliminable dans des conditions douces. Une couche de matière est considérée comme telle dans la mesure où elle ne nécessite pas d'employer des conditions extrêmes nuisibles au film greffé pour être éliminée. Typiquement les conditions douces correspondent à un simple lavage chimique, effectué généralement à l'aide d'un solvant dans lequel le masque est soluble, à un traitement ultrasonore dans un solvant dans lequel le masque est soluble ou à une élévation de la température. Il est bien entendu souhaitable que le masque ne soit pas soluble dans le solvant de réaction présent dans la solution liquide *i.e*. employé dans le cadre de la réaction de greffage. Ainsi il est recommandé d'employer un masque qui présente une affinité pour la surface supérieure à celle qu'il présente pour le solvant de réaction.

La matière constituant le masque peut ainsi être choisie dans une large gamme. Elle sera généralement choisie en fonction de la nature du support solide. Avantageusement, le masque est composé d'alkylthiols en particulier d'alkylthiols à chaîne longue, souvent en C15-C20 et typiquement en C18.

Le masque peut réagir avec les radicaux générés au cours du procédé. Dans tous les cas, il est possible de l'éliminer pour découvrir les zones de la surface du support solide protégées du greffage sur lesquelles aucun film organique ne sera observé (assimilable aux méthodes dites de « lift-off » en lithographie).

Les techniques de dépôts de masque sont connues de l'homme du métier. Il peut s'agir notamment d'enduction, de vaporisation ou encore d'immersion. Ainsi, le masque, sous forme d'une mince couche de matière, peut-être par exemple déposé soit par dessin direct à partir d'un feutre (type crayon) imprégné de la matière choisie. Sur du verre, il est, par exemple, possible d'employer, à titre de masque, un marqueur tel que ceux proposés en papeterie ou encore des corps gras. Il est également possible d'employer le procédé dit du tampon. Cette technique est applicable notamment dans le cas de support solide présentant une surface complexante pour les atomes de soufre, comme une surface d'or, dans ce cas le masque sera généralement composé d'alkylthiols, en particulier d'alkylthiols à chaîne longue (technique dites de la microimpression - *« microcontact printing»* en anglais), souvent en C15-C20 et typiquement en C18. Plus généralement les techniques de lithographie classique peuvent être employées pour former le masque : spin-coating, puis insolation à travers un masque physique ou via un faisceau de lumière ou de particules pilotable, puis révélation.

Selon un autre mode de réalisation de la présente invention, le procédé de préparation d'un film organique à la surface d'un support solide est caractérisé en ce qu'il comprend une étape de mise en contact de ladite surface avec une solution liquide comprenant :
- au moins un solvant,
- au moins un primaire d'adhésion, et,
- au moins un monomère différent du primaire d'adhésion et polymérisable par voie radicalaire,
dans des conditions non-électrochimiques et permettant la formation d'entités radicalaires à partir du primaire d'adhésion.

Tout ce qui a été précédemment décrit concernant le primaire d'adhésion et les possibilités d'action sur son environnement, le solvant protique ou aprotique, dans lequel il est préférable que le monomère soit soluble, le support, les éventuelles amorces chimiques et un éventuel masque s'applique également au mode de réalisation ci-dessus.

Les monomères polymérisables par voie radicalaire mis en oeuvre dans le cadre de la présente invention correspondent aux monomères susceptibles de polymériser en condition radicalaire après amorçage par une entité chimique radicalaire. Typiquement, il s'agit de molécules comportant au moins une liaison de type éthylénique, i.e. de molécules de type éthylénique. Les monomères vinyliques, notamment les monomères décrits dans la demande de brevet FR 05 02516 ainsi que dans le brevet FR 03 11491, sont particulièrement concernés.

Selon une forme de réalisation particulièrement avantageuse de l'invention, le ou les monomères vinyliques sont choisis parmi les monomères de formule (II) suivante : 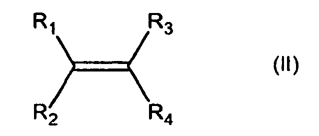 dans laquelle les groupes R₁ à R₄, identiques ou différents, représentent un atome monovalent non métallique tel qu'un atome d'halogène, un atome d'hydrogène, un groupe chimique saturé ou insaturé, tel qu'un groupe alkyle, aryle, un groupe -COOR₅ dans lequel R₅ représente un atome d'hydrogène ou un groupe alkyle en C₁-C₁₂ et de préférence en C₁-C₆, un nitrile, un carbonyle, une amine ou un amide.

Les composés de formule (II) ci-dessus sont en particulier choisis dans le groupe constitué par l'acétate de vinyle, l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle et leurs dérivés ; les acrylamides et notamment les méthacrylamides d'amino-éthyle, propyle, butyle, pentyle et hexyle, les cyanoacrylates, les di-acrylates et di-méthacrylates, les tri-acrylates et tri-méthacrylates, les tétra-acrylates et tétra-méthacrylates (tels que le pentaérythritol tetraméthacrylate), le styrène et ses dérivés, le parachloro-styrène, le pentafluoro-styrène, la N-vinyl pyrrolidone, la 4-vinyl pyridine, la 2-vinyl pyridine, les halogénures de vinyle, d'acryloyle ou de méthacryloyle, le di-vinylbenzène (DVB), et plus généralement les agents réticulants vinyliques ou à base d'acrylate, de méthacrylate, et de leurs dérivés.

Selon un mode de réalisation particulier, les monomères employés sont ceux qui, *a contrario* des composés solubles en toute proportion dans le solvant considéré, sont solubles jusqu'à une certaine proportion dans le solvant, *i.e*. la valeur de leur solubilité dans ce solvant est finie. Les monomères utilisables conformément au procédé de l'invention peuvent ainsi être choisis parmi les composés dont la solubilité dans le solvant de réaction est finie et plus particulièrement inférieure à 0,1 M, plus préférentiellement entre 5.10⁻² et 10⁻⁶ M. Parmi de tels monomères, on peut par exemple citer le méthacrylate de butyle dont la solubilité, mesurée dans les conditions normales de température et de pression, est d'environ 2,5.10⁻³ M dans l'eau et le méthacrylate de méthyle 4.10⁻² M dans l'eau. Selon l'invention, et sauf indication contraire, les conditions normales de pression et de température (CNTP) correspondent à une température de 25°C et à une pression de 1.10⁵ Pa.

L'invention s'applique également à un mélange de deux, trois, quatre où plus monomères choisis parmi les monomères précédemment décrits.

La quantité de monomères polymérisables dans la solution peut varier en fonction du souhait de l'expérimentateur. Cette quantité peut être supérieure à la solubilité du monomère considéré dans le solvant de réaction employé et peut représenter par exemple de 18 à 40 fois la solubilité dudit monomère dans la solution à une température donnée, généralement la température ambiante ou celle de réaction. Dans ces conditions il est avantageux d'employer des moyens permettant la dispersion des molécules de monomère dans la solution tels qu'un tensioactif ou des ultrasons.

Lorsque le solvant est protique, selon un mode de réalisation particulier de l'invention, il est recommandé d'ajouter un tensioactif lorsque le monomère présente une solubilité inférieure à 5.10⁻²M. Une description précise des tensioactifs utilisables dans le cadre de l'invention est donnée dans les demandes de brevet FR 06 01804 et FR 06 08945 et dans la littérature (Deniau et al., Chem. Mater. 2006, 18, 5421-5428) auxquelles l'homme du métier pourra se référer. Un seul tensioactif ou un mélange de plusieurs tensioactifs peut être utilisé. La quantité de tensioactif(s) nécessaire est variable ; elle doit notamment être suffisante pour permettre la formation du film organique. La quantité minimale de tensioactif(s) peut être facilement déterminée en échantillonnant des solutions de composition identique mais de concentration variable en tensioactif(s). De manière générale, la concentration en tensioactif(s) est telle que la concentration micellaire critique (CMC) soit atteinte et qu'il puisse y avoir ainsi formation de micelles. La CMC d'un tensioactif peut être déterminée par les méthodes connues de l'homme du métier, par exemple par des mesures de tensions de surface. Typiquement la concentration en tensioactif sera comprise entre 0,5 mM et 5 M environ, de préférence entre 0,1 mM et 150 mM environ. La concentration recommandée en tensioactif est usuellement de 10 mM.

Les tensioactifs sont des molécules comportant une partie lipophile (apolaire) et une partie hydrophile (polaire). Parmi les tensioactifs utilisables selon l'Invention, on peut notamment citer
i) les tensioactifs anioniques dont la partie hydrophile est chargée négativement ; de préférence le tensioactif sera un alkyle ou un aryle sulfonates, sulfates, phosphates, ou sulfosuccinates associé à un contre ion comme un ion ammonium (NH₄⁺), un ammonium quaternaire tel que tetrabutylammonium, et les cations alcalins tels que Na+, Li+ et K+ ;
ii) les tensioactifs cationiques dont la partie hydrophile est chargée positivement ; ils sont de préférence choisis parmi les ammoniums quaternaires comportant au moins une chaînes aliphatiques en C₄-C₂₂ associés à un contre ion anionique choisi notamment parmi les dérivés du bore tels que le tetrafluoroborate ou les ions halogénures tels que F-, Br-, I- ou Cl- ;
iii) les tensioactifs zwittérioniques qui sont des composés neutres possédant des charges électriques formelles d'une unité et de signe opposé ; ils sont de préférence choisis parmi les composés présentant une chaîne alkyle en C₅-C₂₀ substituée généralement par une fonction chargée négativement comme un sulfate ou un carboxylate et une fonction chargée positivement comme un ammonium ;
iv) les tensioactifs amphotères qui sont des composés se comportant à la fois comme un acide ou comme une base selon le milieu dans lequel ils sont placés ; ces composés peuvent avoir une nature zwittérionique, les acides aminés sont un exemple particulier de cette famille,
v) les tensioactifs neutres (non-ioniques): les propriétés tensioactives, notamment l'hydrophilie, sont apportées par des groupements fonctionnels non chargés tels qu'un alcool, un éther, un ester ou encore une amide, contenant des hétéroatomes tels que l'azote ou l'oxygène ; en raison de la faible contribution hydrophile de ces fonctions, les composés tensioactifs non ioniques sont le plus souvent polyfonctionnels.

Les tensioactifs chargés peuvent bien entendu porter plusieurs charges.

A titre de tensioactifs anioniques, il est par exemple possible d'utiliser le paratoluènesulfonate de tetraéthylammonium, le dodécylsulfate de sodium, le palmitate de sodium, le stéarate de sodium, le myristate de sodium, le di(2-éthylhexyl) sulfosuccinate de sodium, le méthylbenzène sulfonate et l'éthylbenzène sulfonate.

A titre de tensioactifs cationiques, il est par exemple possible d'employer le chlorure tétrabutylammonium, le chlorure tetradécylammonium, le bromure de tetradécyltriméthyle ammonium (TTAB), les halogénures d'alkylpyridinium portant une chaîne aliphatique et les halogénures d'alkylammonium.

A titre de tensioactifs zwittérioniques, il est possible d'employer le N,N diméthyldodécylammoniumbutanate de sodium, le diméthyldodécylammonium propanate de sodium et les acides aminés.

A titre de tensioactifs amphotères, il est possible d'utiliser le lauroamphodiacétate de disodium, les bétaïnes comme l'alkylamidopropylbétaïne ou la laurylhydroxysulfobétaïne.

A titre de tensioactifs non-ioniques, il est possible d'employer les polyéthers comme les tensioactifs polyéthoxylés tels que par exemple le lauryléther de polyéthylèneglycol (POE23 ou Brij ® 35), les polyols (tensioactifs dérivés de sucres) en particulier les alkylates de glucose tels que par exemple l'hexanate de glucose.

Parmi les tensioactifs préférés selon l'invention, on peut citer les tensioactifs anioniques tels que les sulfonates, les ammoniums quaternaires et les tensioactifs non ioniques tels que les polyoxyéthylènes.

Selon une autre modalité de réalisation de l'invention, il est possible d'employer des ultrasons pour favoriser la solubilisation du monomère ou pour former une dispersion lorsque le monomère est insoluble dans le milieu [R. Asami et al. Langmuir B, 2006, sous presse].

Selon les dispositions présentées, la solubilité du monomère s'avère ne pas être un obstacle à la réalisation du procédé grâce à l'utilisation de moyens techniques, tels qu'une agitation vigoureuse, qui peut être induite par les ultrasons, qui permettent la formation d'une dispersion et/ou d'une émulsion, pour le ou les monomère(s) liquide(s). Dans le cas de monomère(s) polymérisable(s) ne présentant pas d'affinité pour le solvant de réaction employé, comme les monomères non hydrosolubles dans l'eau, il est donc avantageux que la solution se présente sous la forme d'une émulsion ou d'une dispersion. Il est également possible d'employer un autre type de solvant et d'adapter l'amorceur en conséquence.

Dans une variante particulièrement adaptée aux solvants protiques, le procédé selon la présente invention comprend une étape préalable durant laquelle le monomère polymérisable ou le mélange de monomères polymérisables est dispersé ou émulsionné en présence d'au moins un tensioactif ou par action des ultrasons, avant son mélange à la solution liquide comprenant au moins un solvant protique et au moins un primaire d'adhésion.

Le procédé est généralement effectué dans des conditions douces et non destructrices soit pour la surface de l'échantillon sur laquelle il est souhaitable de greffer le film, soit pour le monomère éventuellement employé. Ainsi, il est souhaitable de travailler dans des conditions dans lesquelles le monomère ne se dégrade pas. De plus, la température du milieu réactionnel est limitée par le solvant de réaction, qu'il est préférable de conserver liquide. Typiquement le procédé est effectué entre 0 et 100°C et généralement dans les conditions normales de température et de pression (CNTP), fonction de l'endroit où l'utilisateur se trouve, souvent à environ 25°C à une pression avoisinant 101,325 KPa (1 atm).

Le temps de réaction est modulable. En effet, la modulation du temps d'exposition de la surface du support solide à la solution permet de faire varier l'épaisseur du film qui est obtenu. Il est bien entendu possible pour un même type de surface de calibrer précisément les conditions opératoires que l'utilisateur considèrera comme optimales, les moyens d'analyses décrits dans les exemples ci-après sont particulièrement adaptés pour déterminer notamment l'épaisseur du film, sa composition ainsi qu'incidemment le temps de réaction. Il est, par exemple, possible d'obtenir des films dont l'épaisseur est comprise entre 2 nm et 200 nm en faisant varier le temps de réaction entre 1 et 15 minutes et ce, pour une concentration en sel de diazonium de 5.10⁻² M, ou une concentration en monomère de 0,9 M et en sel de diazonium de 5.10⁻² M.

Dans une variante et lorsque la présence d'un monomère différent du primaire d'adhésion est mise à profit, le procédé selon l'invention peut comprendre les étapes suivantes consistant à :
a) ajouter au moins un monomère à une solution contenant au moins un primaire d'adhésion différent dudit monomère en présence d'au moins un solvant et éventuellement d'au moins un amorceur chimique,
b) placer la solution obtenue à l'étape (a) dans des conditions non-électrochimiques permettant la formation d'entités radicalaires à partir du primaire d'adhésion et éventuellement à partir de l'amorceur chimique,
c) mettre en contact la surface du support solide avec la solution de l'étape (b).

Dans une seconde variante du procédé selon l'invention, ce dernier peut comprendre les étapes suivantes consistant à :
a') mettre en contact la surface du support solide avec une solution contenant au moins un primaire d'adhésion en présence d'au moins un solvant et, éventuellement d'au moins un amorceur chimique et d'au moins un monomère,
b') placer la surface du support solide en contact avec la solution de l'étape (a') dans des conditions non-électrochimiques permettant la formation d'entités radicalaires à partir du primaire d'adhésion et éventuellement à partir de l'amorceur chimique,
c') éventuellement ajouter au moins un monomère à la solution obtenue à l'étape (b').

Dans la seconde variante du procédé telle que définie ci-dessus, on peut envisager les trois cas de figures suivants :
i. les monomères ne sont pas présents dans la solution de l'étape (a') et ne sont ajoutés qu'à l'étape (c'). Ce cas de figure est particulièrement intéressant lorsque le monomère utilisé est faiblement soluble et notamment en solution aqueuse ; lorsque le monomère est non hydrosoluble et le primaire d'adhésion est le sel de diazonium. Ainsi, à l'étape (c'), le monomère peut être ajouté en solution notamment dans le même solvant que celui mis en oeuvre à l'étape (a') et avantageusement sous la forme d'une émulsion ou d'une dispersion réalisée préalablement à l'aide d'ultrasons ou de tensio-actifs.
ii. les monomères sont présents dans la solution de l'étape (a') et le procédé ne présente pas d'étape (c'). Ce cas de figure s'applique notamment lorsque le primaire est un sel de diazonium et lorsque le monomère est hydrosoluble. Le procédé conformément à la première variante est également utilisable dans ce cas de figure.
iii. une partie des monomères sont présents dans la solution de l'étape (a') et une autre partie des monomères de nature identique ou différente est ajoutée qu'à l'étape (c').

Comme illustré précédemment le primaire d'adhésion peut être soit introduit dans la ou les solutions en l'état, soit préparé *in situ* dans celle ou ces dernières.

Avantageusement, le procédé selon la présente invention comporte une étape supplémentaire, préalablement au greffage, de nettoyage de la surface sur laquelle on souhaite former le film organique, notamment par ponçage et/ou polissage ; un traitement supplémentaire aux ultrasons avec un solvant organique comme l'éthanol, l'acétone ou la diméthylformamide (DMF) est même recommandé.

Selon dés dispositions particulières, il est possible de réaliser en utilisant le procédé de la présente invention des films organiques essentiellement de type polymères statistiques ou séquencés.

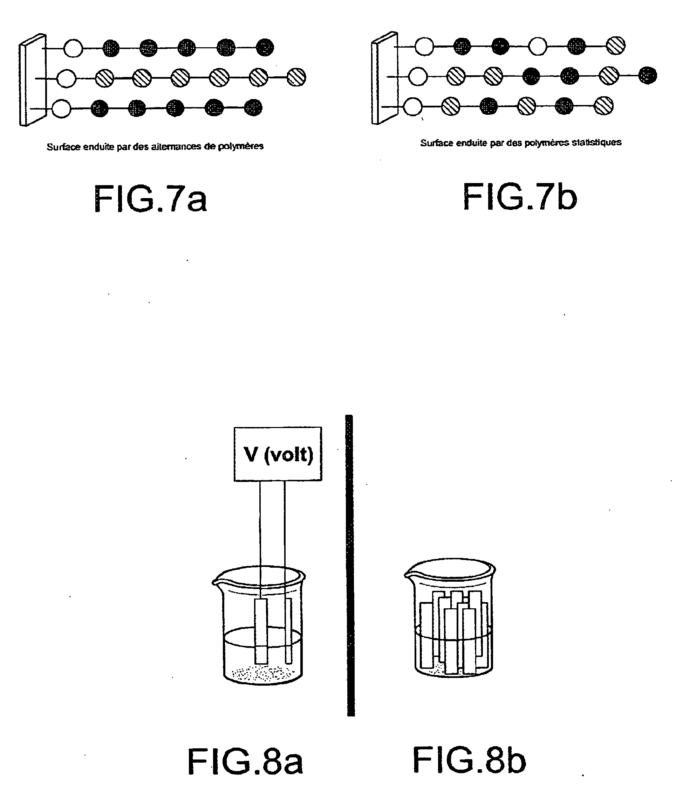

Afin de préparer un film séquencé, il suffit par exemple de préparer comme décrit précédemment une couche d'un premier polymère sur la surface d'un support solide puis de recommencer l'expérience en changeant la nature du monomère en solution. Il est ainsi possible de réaliser par itération un film alterné de grande qualité (figure 7a). Lors de chacune des étapes successives, le primaire d'adhésion se greffera sur la surface à son contact et permettra la croissance d'un film à base du monomère ou des monomères en présence dans la solution. Entre chacune des séquences de greffage, il est tout à fait possible d'effectuer un nettoyage de la surface obtenue.

Afin d'obtenir un copolymère statistique (figure 7b), il suffit d'employer dans la solution des monomères de nature différente. La composition exacte du film est dans ce cas fonction de la réactivité de chacun des monomères en présence.

Les films organiques obtenus selon les procédés précédemment exposés sont ainsi essentiellement polymère ou copolymère, issu de plusieurs unités monomériques d'espèces chimiques identiques ou différentes et/ou de molécules de primaire d'adhésion. Les films obtenus par le procédé de la présente invention sont « essentiellement » du type polymère dans la mesure où le film incorpore également des espèces issues du primaire d'adhésion et pas uniquement des monomères présents. Un film organique dans ce mode particulier de réalisation est ainsi notamment un film préparé à partir d'au moins un type de primaire d'adhésion ou d'au moins un type de monomère polymérisable, particulièrement par voie radicalaire, et d'au moins un type de primaire d'adhésion. Avantageusement, le film organique dans le cadre de l'invention présente une séquence en unités monomériques dans laquelle la première unité est constituée par un dérivé du primaire d'adhésion, les autres unités étant indifféremment dérivées des primaires d'adhésion et des monomères polymérisables.

L'épaisseur du film est aisément contrôlable selon le procédé de la présente invention, comme précédemment expliqué. Pour chacun des paramètres et en fonction des réactifs qu'il emploiera, l'homme du métier sera à même de déterminer par itération les conditions optimales pour obtenir un film d'épaisseur variable. Il est également utile de se reporter aux exemples qui illustrent l'invention et montrent qu'il est par exemple possible de réaliser des films dont l'épaisseur est comprise entre quelques nanomètres et plusieurs centaines de nanomètres.

Le procédé précédemment exposé, permet en outre d'accéder à des supports comportant des films fonctionnalisables. Ceux-ci correspondent typiquement aux films présentant à leur surface des groupes chimiques susceptibles de réagir avec un autre groupe chimique, typiquement extérieur au film, pour former des liaisons covalentes, ioniques ou hydrogène, un groupe répondant à cette définition sera nommé groupe chimique de fonctionnalisation (GCF) dans la suite de l'exposé. De tels groupes correspondent généralement à des groupes comportant au moins une liaison covalente entre un hétérotamone et un autre élément correspondant à un carbone, un hydrogène ou un autre hétéroatome. Le ou les hétéroatomes sont généralement choisis parmi N, O, S, Cl, Br et Si. L'homme du métier pourra notamment consulter la demande internationale WO 2004/005410 qui décrit un procédé dont les modalités concernent la modification des fonctions chimiques que comportent des films et s'appliquent aisément au procédé de la présente invention.

Un film fonctionnalisable peut ainsi comporter un GCF qui pourra notamment être choisi parmi les fonctions hydroxyle, thiol, azide, époxyde, azyridine, amine, nitrile, isocyanate, thiocyanate, nitro, amide, halogénure, carbonyle, comme les acides carboxyliques, les aldéhydes, les cétones, les halogénures d'acide, les esters et les esters activés, et parmi les alcènes ou les alcynes.

A titre d'exemple de films fonctionnalisables dérivés d'un primaire seul comme un sel de diazonium, il est notamment possible de citer les films dérivés des primaires, ici des diazoniums, présentés dans le tableau 1 avec leur GCF associé.

**Tableau 1**

| **Groupe fonctionnalisable possible** | **Primaire utilisable** |
|---|---|
| Amine ou fonction azotée (utilisable comme précurseur d'amine) | le tétrafluoroborate de 4-nitrophényldiazonium, le tétrafluoroborate de 4-cyanophényldiazonium, le tétrafluoroborate de 4-nitronaphtalènediazonium |
| Nitrile et alcool | le tétrafluoroborate de 4-benzoylbenzènediazonium, le sulfate de 2-méthyl-4-[(2-méthylphényl)diazényl]benzènediazonium, le chlorure de 9,10-dioxo-9,10-dihydro-1-anthracènediazonium |
| Acide carboxylique et dérivés (ester, chlorures d'acides) | le tétrafluoroborate du 4-carboxyphényldiazonium, le tétrafluoroborate de 4-benzoylbenzènediazonium, le tétrafluoroborate de l'acide 4-phénylacétique |
| Halogène | le tétrafluoroborate de 4-bromophényldiazonium, le chlorure de 2-méthyl-4-chlorophényldiazonium |

L'utilisation d'un film fonctionnalisable dérivé d'un primaire et d'un monomère permet une grande latitude dans le choix des groupes fonctionnalisables. D'une part, on peut envisager des groupes GCF portés par le primaire tels que précédemment décrits. D'autre part, il est notamment possible d'employer des films préparés à partir de monomères vinyliques pour obtenir un ou plusieurs groupes qui leurs sont associés et tels qu'ils sont représentés dans le tableau 2.

**Tableau 2**

| **Groupe fonctionnalisable possible** | **Monomère utilisable** |
|---|---|
| Ester | acétate de vinyle |
| Nitrile | méthacrylonitrile, le méthacrylate de méthyle, le méthacrylate d'éthyle, le méthacrylate de butyle, le méthacrylate de propyle, di-acrylates et di-méthacrylates, les tri-acrylates et tri-méthacrylates, les tétra-acrylates et tétra-méthacrylates (tels que le pentaérythritol tetraméthacrylate) |
| Nitrile et alcool | méthacrylate d'hydroxyéthyle, le méthacrylate d'hydroxypropyle |
| amide | acrylamides et notamment les méthacrylamides d'amino-éthyle, propyle, butyle, pentyle et hexyle |
| Nitrile et amide | cyanoacrylates |
| Acide carboxylique et dérivés | Acide acrylique, chlorures d'acryloyle et dérivés |
| Halogène | le styrène et ses dérivés, (le parachloro-styrène, le pentafluoro-styrène) |
| Des doubles liaisons | Les agents réticulants vinyliques ou à base d'acrylate, de méthacrylate, et de leurs dérivés |

L'hommme du métier est à même de choisir le type de film et ce, notamment parmi les films de monomères vinyliques, à employer en fonction du GCF qu'il souhaite intégrer au film présent sur le support. Utilement l'homme du métier consultera la demande internationale WO 2004/005410.

Dans la mesure où un GCF ne serait pas directement accessible à l'homme du métier à partir des films qu'il est susceptible de préparer, il est bien entendu possible d'effectuer une modification des GCF que comporte le film à l'aide d'une ou plusieurs réactions chimiques simples. Ainsi à titre d'exemple, un film dérivé de l'acide acrylique qui comporte à titre de GCF une fonction CO₂H peut être modifié par réaction avec du chlorure de thionyle (SOCl₂) pour former un film comportant des chlorure d'acide à titre de GCF. De même, dans le cadre d'un film de nitrobenzène présentant une fonction nitro à titre de GCF, celle-ci peut être réduite par le fer pour donner un film ayant une amine à titre de GCF. Un film de polyacrylonitrile comportant un groupement nitrile comme GCF permet par exemple, après traitement au LiAlH₄, d'accéder à un film comportant une amine comme GCF. Utilement l'homme du métier pourra se repporter à la demande internationale WO 2004/005410.

L'accès à des films fonctionnalisables permet leur fonctionnalisation ultérieure. Ainsi, et selon une disposition particulière, le procédé de préparation de film organique sur un support, tel qu'il a été précédemment exposé, peut comporter une étape supplémentaire de fonctionnalisation, une telle étape est applicable notamment aux films fonctionnalisables.

La fonctionnalisation peut être réalisée par la mise en contact de la surface d'un film, notamment obtenu par le procédé précédemment décrit, fonctionnalisable, et particulièrement avec un GCF du film, avec un greffon. La mise en contact peut se faire grâce à une solution, dite « solution de fonctionnalisation », comportant au moins un greffon.

La réaction aura notamment lieu à la surface du film mais également en son sein en fonction des GCF présents, de l'épaisseur du film et du solvant de la solution.

Parmi les réactions chimiques qu'il est possible de réaliser sur les GCF on peut par exemple citer les additions et subsitutions nucléophiles, les additions et substitutions électrophiles, les réactions de cycloaddition, les réarrangements, les transpositions et les métathèses, ainsi que d'une manière plus générale les réactions de click-chemistry (Sharples et al., Angew. Chem. Int. Ed., 2001, 40, 2004-2021). Le type de réaction est bien entendu fonction du greffon que l'utilisateur souhaite greffer aux GCF que comporte le film. L'homme du métier trouvera aisément dans les connaissances générales en chimie organique des listes exhaustives des réactions chimiques dans lesquelles un GCF pourra être engagé.

Le solvant de la solution comportant le greffon sera de préférence un solvant de gonflement. Un solvant de gonflement correspond à un solvant susceptible de pénétrer au sein du film organique présent sur le support. De tels solvants lorsqu'ils sont mis au contact du film entraînent généralement un gonflement du film de manière perceptible par des moyens optiques, à vue d'oeil, ou par simple microscopie optique. Un test standard pour déterminer si un solvant est particulièrement adapté à un film consiste à déposer une goutte de solvant sur la surface du film et à observer si la goutte est absorbée au sein du film. Il est souhaitable d'employer parmi un ensemble de solvants testés ceux pour lesquels l'absorption est la plus rapide. L'utilisation d'un tel solvant conduit à un greffage plus profond du greffon au sein du film. Bien entendu, il est également préférable que les réactifs utilisés pour faire la réaction soient solubles dans un tel solvant.

Au sens de l'invention un greffon correspond à un composé organique susceptible de réagir avec le film fonctionnalisable et particulièrement avec un GCF que comporte le film fonctionnalisable. Le greffon peut être tout type de molécule organique dans la mesure où celle-ci présente un groupe susceptible de réagir avec un GCF que comporte le film sur le support.

Le greffon peut comporter dans sa structure un groupe d'intérêt (GI) correspondant à une sous-structure présentant une ou des propriété(s) d'intérêt, ainsi qu'éventuellement un groupe de liaison (LG) correspondant à une structure essentiellement dénuée de propriétés d'intérêt. Avantageusement la fonctionnalisation se fait par l'intermédiaire du LG qui comporte un groupe susceptible de réagir avec le GCF.

Le greffon, et particulièrement le GI, peut notamment présenter une structure chelatante, ou une structure biologiquement active. Le GI peut ainsi notamment être choisi parmi les cyclodextrines (CD), tel que les dérivés de peranhydrocyclodextrines, les calixarènes, tel que le calix[4]arène, les porphyrines, telle que la tétrakis (acide bezoïque) - 4, 4', 4'', 4'''-(Porphyrine-5,10,15,20-tetrayle), et leurs dérivés qui présentent des propriétés de chelation. Le GI peut aussi par exemple être choisi parmi les polysaccharides et les polypeptides.

Le groupe de liaison (LG), correspond généralement à un groupe qui ne développe pas d'interaction autre que de nature stérique, de nature hydrophile ou hydrophobe ou d'affinité avec le GI, et qui ne réagit pas significativement avec lui (pas de manière détectable). Typiquement, il peut par exemple s'agir d'une chaîne de nature essentiellement aliphatique, *e.g*. chaîne alkyl, de préférence de 1 à 22, et typiquement 3 à 16, atomes de carbone, d'une chaîne aromatique, ou d'une chaîne hétérocyclique, comme une chaîne polyéther. Le LG comporte avantageusement un ou plusieurs hétéroatomes réactifs susceptibles de réagir avec un GCF.

Ainsi que cela apparaît à la lecture de ce qui précède, il est possible, selon le procédé de l'invention, de préparer un film comportant des molécules greffées et présentant des propriétés d'intérêt à la surface d'un support. De tels films peuvent notamment correspondre à des films de chelation ou de filtration ou encore à des films présentant des biomolécules. Utilement l'homme du métier pourra se reporter à la demande internationale WO 2004/005410 en ce qui concerne des exemples de molécules qu'il est possible de greffer.

Selon une modalité particulière de la fonctionnalisation, il est possible d'accéder à des supports recouverts d'un film organique de complexation. Pour cela il est nécessaire de fonctionnaliser le film avec des groupes complexants ou chelatants comme les cyclodextrines, les prophyrines et les calixarènes.

Selon une autre modalité de la fonctionnalisation il est possible d'accéder à des supports recouverts d'un film organique comportant des biomolécules comme des protéines, des polypeptides, des peptides, des anticorps et fragments d'anticorps, des polysaccharides ou encore des oligonucléotides. Typiquement le greffon correspond alors à un dérivé d'une biomolécule. Ainsi par exemple à partir d'un support présentant un film comportant du polyméthacrylonitrile, obtenu à l'aide d'un diazonium et de méthacrylonitrile, il est possible de greffer une protéine comme l'avidine et d'en vérifier l'activité selon les modalités décrites dans la demande internationale WO 2004/005410.

La présente invention concerne également un support solide non-conducteur de l'électricité sur lequel est greffé un film organique dont la première unité liée de façon covalente audit support non-conducteur de l'électricité est un dérivé d'un primaire d'adhésion. Le support solide non-conducteur de l'électricité selon la présente invention peut éventuellement présenter un masque tel que précédemment défini.

Avantageusement, le film organique comprend, en plus de la première unité liée de façon covalente au support non-conducteur de l'électricité dérivé d'un primaire d'adhésion, des monomères de natures identiques ou différentes liés les uns aux autres par réaction radicalaire et éventuellement des dérivés du primaire d'adhésion. Ainsi, comme précédemment expliqué, le film organique est un film essentiellement polymère. Plus particulièrement, il peut se présenter sous la forme d'un film polymère séquencé ou d'un film copolymère statistique. Les supports solides non-conducteurs de l'électricité, les primaires d'adhésion et les monomères sont tels que précédemment définis. Le support solide selon l'invention peut également comporter des greffons greffés ainsi qu'exposé précédemment.

Selon un autre mode de réalisation l'invention, il est possible d'accéder à des films organiques comportant des nano-objets. Au sens de la présente invention, un film organique comportant des nano-objets, comme des nanoparticules (NPs), des nanocristaux (NCs) ou des nanotubes (NTs), correspond typiquement à un film à la surface et jusqu'au sein duquel sont présents des nano-objets (NBs).

Ce mode de réalisation est applicable à un support recouvert d'un film organique et notamment à un support recouvert d'un film organique lié de manière covalente à sa surface, il s'agira typiquement d'un support obtenu à l'issu d'un procédé tel que précédemment décrit.

Ainsi, ce mode de réalisation correspond notamment à un procédé de préparation d'un film organique comportant des nano-objets à partir d'un support solide recouvert d'un film organique, typiquement obtenu par le procédé précédemment exposé, caractérisé en ce que la surface du support est mise en contact avec une suspension d'au moins un nano-objet (NB) dans un solvant de suspension et en ce que le film et le nano-objet présentent une affinité physico-chimique.

Un nano-objet (NB) correspond à un objet de taille nanométrique, généralement sa plus grande dimension est inférieure à 1 µm et typiquement inférieure à 25 nm. Il peut notamment s'agir d'une nanoparticule (NP), d'un nanocristal (NC), d'un nanofil ou d'un nanotube (NT) ou encore d'une nanocolonne. Il est évident que les NBs dont il est ici question auront avantageusement une taille inférieure à l'épaisseur du film organique présent sur le support, avantageusement leur plus grande dimension n'excèdera pas. 20%, généralement 10% et et typiquement 5%, de l'épaisseur du film organique.

Il existe une affinité entre le film et les NBs lorsqu'il est possible de corréler la durée du contact entre la suspension et la surface du support à une diminution de la concentration en NBs au sein de la solution, une valeur plateau étant généralement atteinte, indépendamment d'une éventuelle démixtion des NBs dans la suspension. Il est ainsi possible de déterminer des couples NBs/film organique entre lesquels il existe une affinité. L'affinité est généralement due à des interactions de type faible ou forte qui se développent entre la surfaqce des NBs et le film. Parmi les interactions de type faible, on peut notamment citer les liaisons hydrogène, les liaisons de type ioniques, les liaisons de complexation, les interactions pi (« pi stacking »), les liaisons de Van der Waals, les liaisons hydrophobes (ou liaisons apolaires type surfactant) ; parmi les liaisons fortes on peut citer les liaisons covalentes qui peuvent se former spontanément.

La structure des NBs est variable, elle est simple ou complexe. Un NB simple est constitué d'un seul matériau, il s'agit souvent d'une NP, d'un NC, d'un nanofil ou encore d'une NP ou d'une nanocolonne, pouvant toutefois présenter une constitution variable, notamment dans le cas d'un NB dopé non uniformément dans l'ensemble de son volume. Un NB complexe présente généralement différents éléments structuraux ou des parties dont la composition est nettement distincte. Il peut, par exemple, s'agir d'assemblages artificiels de taille nanométrique présentant des structures organiques et inorganiques ou encore de NP comportant des ligands ou des NP à enrobages multiples. Un NB complexe peut être constitué de plusieurs NB simples.

De manière non exhaustive, les NBs peuvent notamment comporter au moins un métal. Les métaux peuvent être notamment choisis parmi les métaux nobles et les métaux de transition, les métaux des groupes IIIA, IVA et VA du tableau périodique des éléments, leurs alliages, les oxydes et les carbures métalliques, les mélanges de ces métaux et alliages. Ils peuvent également être dopés, notamment par des éléments comme l'azote, le bore et les terres rares. Plus particulièrement, l'invention s'applique à l'or, au platine, au palladium, au rhodium, au ruthénium, au cobalt, au nickel, à l'argent, au cuivre, à l'oxyde de titane, à l'oxyde de fer, aux alliages fer-platine, fer-palladium, or-platine et cobalt-platine. Les NBs peuvent également être constitués seulement des éléments préalablement cités, il s'agira, dans ce cas, de NBs métalliques.

Les NBs peuvent également comporter un semi-conducteur ou un isolant inorganique. Il peut par exemple s'agir de composés de formule AB avec A un élément dont l'état d'oxydation est +II et B un élément dont l'état d'oxydation est -II. Typiquement, A est choisi parmi Mg, Ca, Sr, Ba, Zn, Cd, Hg, Sn, Pb et des mélanges de ces éléments, et B est choisi parmi O, S, Se, Te et des mélanges de ces éléments. Parmi les semi-conducteurs, on peut également citer les semi-conducteurs de formule CD avec C étant un élément dont l'état d'oxydation est +III et D étant un élément dont l'état d'oxydation est -III. Typiquement, C est choisi parmi Al, Ga, In et des mélanges de ces éléments, et D est choisi parmi N, P, As, Sb, Bi et des mélanges de ces éléments. Les semi-conducteurs de formule ECB₂ avec E étant un élément dont l'état d'oxydation est +I, C étant un élément dont l'état d'oxydation est +III et B étant un élément dont l'état d'oxydation est -II, dans laquelle B et C sont choisis comme précédemment, E est choisi parmi Cu, Ag et Au, sont également concernés par l'invention. Enfin, il est bien entendu possible d'employer des semi-conducteurs plus simples tels que le Si ou le Ge, ainsi que leurs oxydes et carbures, ou des isolants comme le diamant. Les semi-conducteurs peuvent se présenter sous une forme intrinsèque ou dopée. Les NBs peuvent également être constitués seulement des éléments préalablement cités.

Les NBs peuvent également comporter un élément de nature organique. Il s'agit généralement dans ce cas et pour les NBs complexes, d'édifices moléculaires particuliers comme des stabilisants ou des ligands organiques ou des films d'enrobage. Pour les NB simples, il s'agira généralement de carbone sous une forme structurale particulière comme un nanotube ou un fullerène. Les NBs peuvent également être constitués seulement des éléments préalablement cités.

Selon l'invention, et afin de permettre une plus grande flexibilité à l'utilisateur, il est recommandé d'employer des nano-objets fonctionnalisés. Un NB est dit « fonctionnalisé » lorsque sa surface comporte un ou plusieurs groupe BG₁ présentant une affinité pour le « film hôte » qui est le film présent sur le support. Dans le cas d'un NB simple, BG₁ peut ainsi correspondre à une fonction chimique présente à la surface comme les fonctions OH qui sont présentes sur les particules de silice ainsi qu'illustré dans les exemples. Dans le cas d'un NB complexe, BG₁ peut être présent sur l'un des éléments ou l'une des parties seulement du NB, ainsi par exemple dans le cas d'une NP comportant des stabilisants, des ligands ou présentant un enrobage, BG₁ peut être présent sur plusieurs stabilisants organiques ou sur l'enrobage.

Un stabilisant correspond à une molécule organique qui se lie à la surface du coeur du nano-objet et qui maintient le NB à l'état colloïdal, utilement dans ce domaine, l'homme du métier pourra se référer à Roucoux et al., Chem. Rev. 2002, 102, 3757-3778. Ainsi, selon une première possibilité, un nano-objet fonctionnalisé présente typiquement un coeur inorganique, ou du moins dont la surface est inorganique, constitué d'au moins un métal et/ou d'au moins un semi-conducteur ou un isolant tels que définis plus haut, auquel est lié au moins un stabilisant comportant un groupe organique BG₁. Selon le nombre de molécules de stabilisant présentes, il est possible de parler de couronne de nature organique. Selon une seconde possibilité, il est également possible d'employer un NB fonctionnalisé comportant un enrobage organique, un tel NB fonctionnalisé peut notamment être obtenu par le procédé de préparation d'un film organique à la surface d'un support précédemment décrit appliqué à un NB, *i.e*. correspondant au coeur qu'il est souhaitable d'enrober. Dans ce cas, il y a lieu de remarquer que considérant la grande flexibilité d'application du procédé de préparation de film organique à la surface d'un support tel qu'il a été précédemment décrit, la nature du coeur peut être variable, tant simple que complexe et inorganique qu'organique, pour de plus amples précisions il est utile de se référer à ce qui a été développé ainsi qu'aux exemples qui illustrent l'application à différentes surfaces. Le film organique sera préparé de telle sorte qu'il comporte un groupe BG₁.

Typiquement, les stabilisants sont choisis parmis les molécules amphiphiles commes les tensio-actifs ou les polyoxanions, les polymères comme le PVP (polyvinylpyrolydone), le PEG (polyéthylène glycol), les molécules chargées de faible poids moléculaire, en général moins de 200 g.mol⁻¹, comme le citrate de sodium ou l'acétate de sodium, et enfin les ligands chimiques de coordination comme les bases de Lewis telles que les dérivés du BINAP (2,2'-bis(diphenylphosphino)-1,1'-binaphthyl).

Les stabilisants utilisables dans le cadre de l'invention pour les NBs fonctionnalisés comportant un coeur composé d'un métal et/ou d'un semi-conducteur et/ou d'un isolant, ou dont la surface présente une telle composition, sont notamment des ligands de formule (III) :

BG₁ - (SG)ₚ - Y

dans laquelle :
- Y représente un atome ou un groupe d'atomes susceptible(s) de se lier à un métal et/ou à un composé semi-conducteur et/ou un isolant;
- SG représente un groupe espaceur ;
- BG₁ est tel que défini précédemment ;
- p est égal à 0 ou 1.

Selon l'invention, Y sera choisi en fonction du coeur du NB qui est employé dans le cadre du procédé. Y peut se lier de manière covalente, par complexation, chélation, ou par interaction électrostatique à la surface du coeur. De manière utile, afin de déterminer la structure la mieux adaptée au NB considéré, l'homme du métier pourra notamment se référer à l'art antérieur et particulièrement à Colloids and Colloid Assemblies, Frank Caruso (Ed.), 1. Ed. Dec. 2003, Wiley-VCH, Weinheim ou à Templeton, A. C.; Wuelfing, W. P.; Murray, R. W., Monolayer-Protected Cluster Molecules. Acc. Chem. Res. 2000, 33 (1), 27-36.

Y peut notamment être un thiol, un dithiol, un carbodithioate, dithiocarbamate, xanthate, lorsque le coeur, ou la surface du coeur, correspond à un métal tel que l'or, l'argent, le cuivre, le platine, le palladium ou encore lorsqu'il, ou elle, correspond à un semi-conducteur de type AB comme le CdSe, CdTe, ZnO, PbSe, PbS, CuInS₂, CuInSe₂ ou Cu(In,Ga)Se₂. Dans le cas des coeurs composés d'oxydes, tel que l'oxyde de titane, de zirconium, d'aluminium ou de fer, ou lorsque la surface du coeur présente une telle composition, Y peut notamment correspondre à un acide carboxylique, dicarboxylique, phosphonique, diphosphonique, sulfonique ou hydroxamique, les acides pouvant être sous forme déprotonée, ainsi que cela a été exposé dans l'art antérieur et notamment dans la demande internationale WO 2004/097871.

Selon l'invention, il est préférable que p soit égal à 1. Un groupe espaceur SG, correspond généralement à un groupe qui ne développe pas d'interaction autre que de nature stérique, de nature hydrophile ou hydrophobe ou d'affinité avec le coeur du NB ou le film organique hôte auquel est appliqué le procédé, et qui ne réagit pas significativement avec eux (pas de manière détectable). Typiquement, l'espaceur peut être une chaîne carbonée ne comportant pas d'hétéroatome. Il peut, par exemple, s'agir d'une chaîne de nature aliphatique, *e.g*. chaîne alkyl, de préférence de 1 à 22, et typiquement 6 à 16, atomes de carbone, d'une chaîne aromatique, ou d'une chaîne hétérocyclique, comme une chaîne polyéther.

Selon une première modalité, il est possible d'appliquer le procédé à un support recouvert d'un film organique fonctionnalisé de telle sorte qu'il présente un groupe organique BG₂ présentant une affinité pour le coeur du NB. Ainsi, selon un mode de réalisation particulier, BG₂ peut être choisi parmi les groupes précédemment listés pour Y et les NBs auront une composition, ou du moins leur surface, telle que précédemment listée en accord avec Y.

Selon une seconde modalité de réalisation, il est possible d'appliquer le procédé à un support recouvert d'un film organique fonctionnalisé de telle sorte qu'il présente un groupe organique BG₃ présentant une affinité pour le groupe BG₁ présent sur le stabilisant ou l'enrobage du coeur du NB. BG₁ et BG₃ forment alors un couple présentant une interaction de type électronique qui sera typiquement le siège de l'affinité entre le film organique et les NBs fonctionnalisées.

Selon une troisième modalité, il est possible d'appliquer le procédé à un support recouvert d'un film organique fonctionnalisé de telle sorte qu'il présente à la fois un groupe organique BG₃ et un groupe BG₂. Ce mode de réalisation est adapté lorsque le NB comporte un enrobage ou un stabilisant comportant des groupes de type BG₁ et lorsque la surface de son coeur comporte également ce type de groupe, les fonctions chimiques présentes à la surface du coeur, bien que toutes deux susceptibles de développer une interaction avec le film hôte, peuvent bien entendu être différentes.

A titre de film organique hôte, fonctionnalisé par des groupes BG₂ et/ou BG₃, et à titre de film d'enrobage, fonctionnalisé par un groupe BG₁, pour le coeur de NB, il est avantageux d'employer un film préparé selon le procédé préalablement exposé à partir d'un primaire et d'un monomère différent du primaire d'adhésion et polymérisable par voie radicalaire. Il est recommandé d'employer des films fonctionnalisables ainsi qu'ils ont été définis plus haut, typiquement BG₂ et BG₃ pourront correspondre à un GCF que comporte le film. La présence d'un monomère souvent aisément dérivatisable ou présentant des fonctions organiques particulières est adaptée. Ainsi que cela a été précisé plus haut, il est possible d'effectuer une modification des GCF que comporte un film pour accéder à d'autres GCF. Dans ce cadre, il est particulièrement recommandé d'employer les monomères vinyliques et notamment les monomères vinyliques de formule générale (II), et particulièrement ceux pour lesquels R₁ est un acide carboxylique, une amine, ou un groupe carboné présentant ces fonctions, typiquement les autres substituants R₂ à R₄ étant des H. Il s'agira particulièrement de l'acide acrylique. Bien entendu lors de la synthèse du film organique, celui-ci peut comporter un précurseur du groupe BG₁, BG₂ ou BG₃, un tel précurseur peut être transformé, lorsque l'utilisateur le décide, en groupe d'affinité correspondant en réalisant quelques étapes, typiquement une ou deux, chimiques simples. Ainsi, par exemple, il est possible de convertir facilement les fonctions acide carboxylique d'un film élaboré à partir d'acide acrylique en fonction carboxylate par une simple réaction acido-basique.

Par ailleurs, à titre de film organique hôte, il est bien entendu possible d'employer un film fonctionnalisé par un greffon. Selon cette modalité de réalisation il est souhaitable d'employer un greffon présentant une propriété de chelation. Dans ce cas le groupe BG₂ et/ou BG₃ correspond avantageusement à un GI tel qu'il a été défini plus haut, un tel GI est une structure chelatante ou complexante. Le greffon peut être greffé selon les modalités présentées plus haut, il est notamment possible qu'il comporte également un groupe de liaison LG tel qu'il a été défini.

Ainsi par exemple il est possible d'employer des films comportant des molécules dérivés de cyclodextrines, de prophyrine ou de callixarènes. Ainsi des molécules organiques ou des sels, par exemple de plob, comme le nitrate de plomb, peuvent être chelatés ou complexéss.

Typiquement, Y développera une interaction plus faible avec le coeur du NB que l'interaction que la surface du coeur pourrait développer avec le film hôte du support. Ainsi, l'interaction qui pourrait exister entre le coeur d'un NB complexe et Y sera avantageusement moins forte que celle qui pourrait exister entre le coeur d'un tel NB et BG₂.

Au sens de l'invention, le solvant de suspension est un solvant qui permet la formation d'une suspension de NBs. Ils correspondent typiquement aux solvants dans lesquels les NBs sont préparés car ils évitent ou retardent l'aggrégation des NBs. Le solvant de suspension sera avantageusement choisi parmi les solvants de gonflement, ainsi qu'ils ont été définis plus haut.

La suspension de NBs sera de préférence homogénéisée avant d'être utilisée. Il est, par exemple, possible de soumettre la suspension à une agitation mécanique, de préférence vigoureuse, ou encore à un traitement ultrasonore.

La concentration en NBs dans la suspension et la durée de mise en contact du film avec la suspension sont variables et peuvent être adaptées selon la quantité de NB que l'utilisateur souhaite intégrer au film. Des essais préliminaires en fonction de l'affinité existante entre le film et les NBs permettent de déterminer aisément des conditions opératoires raisonnables pour la mise en oeuvre du procédé, utilement l'utilisateur se référera aux exemples. Il est évident que l'augmentation de la concentration de la suspension permet de réduire le temps nécessaire pour intégrer une quantité donnée de NBs dans le film. De la même manière, l'augmentation de la durée du contact permet d'intégrer une quantité plus importante de NBs pour un temps donné. Ainsi, par exemple, pour un film de 200 à 300 nm, une mise en contact avec une suspension NPs de Pt durant 15 à 60 min permet d'obtenir un film comportant des nanoparticules. A titre de solvant, il est par exemple possible, lorsque le film comporte des groupes d'affinité de type carboxylate, d'employer comme solvant de suspension un solvant hydrophile comme l'eau ou un alcool de faible poids moléculaire tel que le méthanol ou l'éthanol, ou un mélange de ceux-ci. Le choix d'un solvant hydrophile permet par exemple de réaliser une suspension de NPs de silice, d'or ou de platine stabilisée par un stabilisant comportant un groupe hydrophile, comme un ammonium. Dans de tels solvants de suspension, il est également possible d'employer des NBs comportant des groupes hydrophiles à leur surface comme les NPs de silice. Utilement, l'homme du métier pourra se référer aux exemples.

L'invention permet en outre de réaliser des supports recouverts de films comportant une ou plusieurs zones de coalescence à partir de supports recouverts de films organiques comportant des NBs, ces derniers films pouvant être obtenus par le procédé préalablement présenté. Ainsi, avantageusement le procédé d'incorporation de NBs sera appliqué à des NBs susceptibles d'entrer en coalescence sous l'action d'un agent de coalescence, et comportera une étape supplémentaire d'exposition d'au moins une zone de la surface du support, recouverte du film comportant les NBs, à un agent de coalescence. La coalescence de NBs est généralement définie comme la disparition de la frontière entre deux NBs au contact l'un de l'autre, ou entre un NB et un objet de taille plus importante et de composition similaire, suivie par un changement de forme entrainant une réduction de la surface totale du système.

Le procédé est généralement réalisé par la mise en présence du film comportant les NBs, typiquement obtenu selon le procédé exposé précédemment, avec l'agent de coalescence. Le procédé peut bien entendu être réalisé sur une zone, ou bien plusieurs, du support comportant le film en exposant ladite zone à l'agent de coalescence. Ce procédé peut ainsi être réalisé de manière localisée. L'agent de coalescence peut entraîner une modifications du support et des éventuels films et couches organiques présents sur le support, une application localisée de l'agent peut ainsi être préférable.

Les NBs suceptibles de subir une coalescence sont, par exemple, des NBs simples, il s'agira généralement de NBs métalliques et notamment de NCs ou de NPs de métaux ou d'alliages métalliques, ou encore de NB complexes comme les NBs fonctionnalisés présentant un coeur métallique.

L'agent de coalescence peut être une variation d'un paramètre physique ou irradiation, lorsque le procédé est appliqué à une zone particulière du support le paramètre sera modifié uniquement dans cette zone. Les paramètres physiques susceptibles d'être modifiés pour obtenir une coalescence des NBs sont connus de l'homme du métier. Ainsi, par exemple, la modification de la température ou une irradiation, photonique ou électronique, peuvent être utilisées. Généralement, un traitement thermique à une température comprise entre 250 et 500°C, et par exemple 250 à 350°C pendant 2 à 5 min permet par d'obtenir la coalescence de nanoparticules de platine, un tel traitement effectué sur l'ensemble de la surface du support présentant un film comportant les nanoparticules conduit à la formation d'un film métallique homogène. Des essais pourront être réalisés pour déterminer la température minimum pour un temps donné en fonction des NBs et notamment en fonction de leur taille ainsi que de leur composition. De la même manière, l'application localisée d'une source cohérente infra-rouge, comme un laser de type CO₂ conduit aisément à des zones de coalescence localisées. L'application d'un faisceau d'électrons par exemple à l'aide d'un microscope permet de réaliser une coalescence localisée des NPs.

La présente invention concerne également un support solide non-conducteur de l'électricité sur lequel est greffé un film organique, comportant des NBs, et particulièrement des NPs, dont la première unité liée de façon covalente audit support non-conducteur de l'électricité est un dérivé d'un primaire d'adhésion. Le support solide non-conducteur de l'électricité selon la présente invention peut éventuellement présenter un masque tel que précédemment défini, il peut également comporter des molécules greffées selon les modalités précédemment exposées.

Avantageusement, le film organique comportant des NBs, et particulièrement des NPs, comprend, en plus de la première unité liée de façon covalente au support non-conducteur de l'électricité dérivé d'un primaire d'adhésion, des monomères de natures identiques ou différentes, liés les uns aux autres par réaction radicalaire et éventuellement des dérivés du primaire d'adhésion. Ainsi, comme précédemment expliqué, le film organique est un film essentiellement polymère. Plus particulièrement, il peut se présenter sous la forme d'un film polymère séquencé ou d'un film copolymère statistique. Les supports solides non-conducteurs de l'électricité, les primaires d'adhésion et les monomères sont tels que précédemment définis. Typiquement les NBs, et particulièrement les NPs, seront présentes dans les couches les plus externes du film.

Par ailleurs, il est possible d'employer des solutions d'électrodéposition pour former un revêtement métallique, et notamment de cuivre, sur un support revêtu d'un film organique obtenu par le procédé précédemment décrit. Généralement, l'électrodéposition sera effectuée sur des films organiques ne comportant pas de NBs. Typiquement, pour mettre en oeuvre de telles dispositions l'homme du métier se référera utilement à la demande internationale WO 2007/034116 et notamment aux exemples. Ainsi, le procédé d'électrodéposition sur un support revêtu d'un film organique, susceptible d'être obtenu par le procédé précédemment exposé, peut notamment être réalisé en effectuant les étapes suivantes:
- une étape dite d'« entrée a froid » au cours de laquelle la surface du support est mise en contact sans polarisation électrique avec un bain d'électrodéposition, et de préférence maintenue dans cet état pendant une durée d'au moms 5 secondes, de préférence comprise entre 10 et 60 secondes, et avantageusement d'environ 10 a 30 secondes,
- une étape de formation du revêtement métallique au cours de laquelle ladite surface est polarisée pendant une durée suffisante pour former ledit revêtement,
- une étape dite de « sortie a chaud », au cours de laquelle ladite surface est séparée du bain d'électrodéposition tandis qu'elle est encore sous polarisation électrique.

La présente invention concerne également un procédé de métallisation d'un film organique préparé à la surface d'un support solide comprenant les étapes consistant à
(a") préparer, à la surface d'un support solide, un film organique comportant des nano-objets (NBs) selon un procédé tel que précédemment défini ;
(b") mettre en contact le film préparé à l'étape (a") avec une solution contenant au moins un sel métallique susceptible d'être réduit par lesdits NBs.

En effet, pour former un revêtement métallique sur un support revêtu d'un film organique obtenu par le procédé précédemment décrit, il est également possible de mettre à profit la présence de NBs, et particulièrement de NPs, au sein du film organique. Pour cela, il est possible d'employer une solution comportant un ou plusieurs sels métalliques susceptibles d'être réduits par les NBs présents dans le film organique. En général, le support revêtu d'un film organique comportant des NBs sera directement plongé dans une solution comportant un ou plusieurs sels métalliques. La durée d'exposition du support revêtu du film organique comportant des NBs à la solution de sels métalliques est généralement comprise entre trente secondes et une dizaine de minutes. La concentration en NBs et la concentration en sels métalliques dans le film peuvent être adaptées selon l'épaisseur du film souhaitée.

A titre de NB, il est possible d'employer notamment des NBs simples, il s'agira généralement de NBs métalliques et notamment de NCs ou de NPs de métaux comme l'or ou le paladium, ou d'alliages métalliques, ou encore de NB complexes comme les NBs fonctionnalisés présentant un coeur métallique.

Parmi les solutions de sels métalliques, il est, par exemple, possible de choisir parmi les solutions de sulfate de cuivre ou de sulfate de nickel.

Le choix du type du NB et du type de solution est intimmement lié du fait de la réaction de réduction qui est effectuée.

La présente invention concerne également l'utilisation d'une solution contenant au moins un solvant, au moins un primaire d'adhésion, éventuellement au moins un monomère différent du primaire d'adhésion et, éventuellement, au moins un amorceur chimique tels que précédemment définis pour former, dans des conditions non-électrochimiques et permettant la formation d'au moins un radical sur le primaire d'adhésion, un film organique à la surface d'un support solide en contact avec ladite solution.

L'invention concerne également un kit de préparation d'un film organique essentiellement polymère à la surface d'un échantillon.

Un kit de préparation d'un film organique essentiellement polymère à la surface d'un support solide est défini par la revendication 22.

Le kit selon la présente invention peut éventuellement, en outre, contenir un compartiment contenant une suspension d'au moins un nano-objet dans un solvant de suspension et/ou un compartiment contenant une solution de fonctionnalisation.

Dans une variante du kit selon l'invention, le premier compartiment contient non pas la solution contenant au moins un primaire d'adhésion mais une solution contenant au moins un précurseur d'un primaire d'adhésion. Au sens de « précurseur de primaire d'adhésion », il faut comprendre une molécule séparée du primaire par une étape opératoire unique et aisée à mettre en oeuvre. Dans ce cas, le kit comprendra éventuellement au moins un autre compartiment dans lequel se trouvera au moins un élément nécessaire pour élaborer le primaire à partir de son précurseur (troisième compartiment ou quatrième compartiment si présence d'un amorceur chimique). Ainsi, le kit pourra par exemple contenir une solution d'une aryleamine, précurseur du primaire d'adhésion, et également une solution de NaNO₂ pour permettre par ajout la formation d'un sel d'aryle diazonium, primaire d'adhésion. L'homme du métier aura compris que l'utilisation d'un précurseur permet d'éviter de stocker ou transporter des espèces chimiques réactives.

Le solvant peut être contenu dans l'une quelconque des solutions des premier et deuxième compartiments et éventuellement dans la solution du troisième ou du quatrième compartiment. Avantageusement, un solvant identique ou différent est contenu dans chacune des solutions des premier et deuxième compartiments et éventuellement dans la solution du troisième ou du quatrième compartiment.

Les solutions des différents compartiments pourront bien entendu contenir différents autres agents identiques ou différents tels que des agents stabilisants ou des tensio-actifs. L'utilisation du kit s'avère simple puisqu'il suffit de placer l'échantillon dont la surface doit être traitée au contact du mélange des solutions préparé de façon extemporanée en mélangeant les solutions des différents compartiments, de préférence sous agitation et notamment sous ultrasons. Avantageusement, seule la solution contenant le monomère *i.e*. du deuxième compartiment est placée sous ultrasons avant d'être mélangée à la solution contenant le primaire d'adhésion préparé extemporanément à partir d'un précurseur ou présent dans la solution du premier compartiment.

L'invention permet d'accéder à des films polymériques présentant de remarquables propriétés. Il y a tout d'abord lieu de remarquer que les films présentent une tenue particulièrement importante puisqu'après un lavage avec un solvant dans lequel le monomère est particulièrement soluble et en présence d'ultrasons, l'épaisseur du film ne varie pas de manière significative. En outre, il est possible de contrôler avec une remarquable efficacité l'épaisseur de film obtenu en faisant varier les paramètres expérimentaux comme le temps de réaction ou la concentration en espèce active. La composition des films est également homogène et il est possible de la contrôler avec une grande précision, ce qui donne accès tant aux films polymériques de type statistique que de type séquencé (également appelé type bloc ou alternant). Les films sont conformes, *i.e*. ils présentent une surface homogène sur l'ensemble de la surface à laquelle le procédé a été appliqué. Cette invention permet donc l'accès à de très nombreuses fonctionnalisations sur une très grande variété de surfaces avec différents monomères qui peuvent être associés les uns aux autres.

Il est bien entendu possible d'appliquer l'ensemble des procédés décrit à partir d'un support de base, l'ordre et la succession des différents procédés, ainsi que l'application de certaines des modalités offertes par la présentes invention, comme le recourt à des masques et la formation localisée de zones de coalescence, donnent accès à des supports recouverts par des films pouvant présenter une complexité, tel qu'un feuilletage de films successifs organiques et inorganiques, inégalée par une méthodologie aussi simple à une échelle aussi faible:

Les avantages de l'invention sont multiples. Ce procédé permet à l'aide d'une seule méthode, simple et reproductible, d'accéder au greffage de surfaces conductrices ou non. La mise en oeuvre de ce procédé ne nécessite pas d'investissement lourd au niveau appareillage spécifique tels que potentiostats, installations sous vides coûteuses... De plus, la mise en oeuvre du procédé s'avère simple et rapide en comparaison aux autres techniques aujourd'hui connues pour le greffage ou l'enduction de surfaces. Cette méthode ne nécessite pas de connexion à un circuit électrique contrairement à l'électrochimie et permet ainsi son application sur des surfaces difficilement connectables telles que les nano objets. De plus, cette polymérisation radicalaire peut s'effectuer en présence d'oxygène et n'implique pas de précautions particulières lors de la synthèse.

Comme schématisé à la figure 8, la présente invention est utilisable en milieu aqueux sans autre appareillage qu'un récipient dans lequel se passe la réaction. Il n'est donc plus nécessaire de brancher la surface à greffer sur un potentiostat (Figure 8a) mais juste de la tremper dans la solution du milieu réactionnel (Figure 8b). Cette technique permet de synthétiser un grand nombre de polymères dont les monomères sont solubles ou non en milieu aqueux, sur une très large variété de surfaces conductrices ou non de l'électricité avec une cohésion très importante, les films obtenus résistant aux ultrasons dans différents solvants.

L'invention permet ainsi de revêtir et de fonctionnaliser, avec une grande efficacité, un nombre considérable de surfaces de nature variée et jusque là non décorées ou greffées telles qu'une surface de PTFE. Les domaines d'application sont très nombreux et un tel procédé est par exemple applicable dans la biologie, notamment pour des démarches de biocompatibilité (revêtement de stent), pour la fonctionnalisation et notamment la protection des surfaces, comme les métaux (anticorrosion) ou les fibres (hydrofuge), pour le traitement d'effluents en revêtant les films de molécules complexantes, ou encore pour effectuer du collage structural à partir du film greffé.

Par ailleurs la fonctionnalisation peut être localisée grâce à l'utilisation de masque. Il est ainsi possible de revêtir de manière précise différentes zones d'une même surface en protégeant d'autres zones avec un ou plusieurs masques. Ce type de procédure est facilement mis en oeuvre car des masques organiques aisément éliminables peuvent être employés, il pourra notamment s'agir de simples dépôts effectués à l'aide de feutres imprégnés d'encre ou d'enduction par un corps gras.

Enfin, la fonctionnalisation des surfaces d'intérêt peut encore être augmentée par l'utilisation de greffons eux-mêmes greffés sur le film greffé.

La mise en oeuvre du procédé selon l'invention s'inscrit en outre dans une démarche non polluante puisqu'il peut être réalisé en milieu aqueux et qu'il produit peu de déchets, l'un des produits de réaction pouvant notamment être le diazote.

D'autres caractéristiques et avantages de la présente invention apparaîtront encore à l'homme du métier à la lecture des exemples ci-dessous donnés à titre illustratif et non limitatif, en référence aux figures annexées.

### BRÈVE DESCRIPTION DES DESSINS

La figure 1 présente le spectre IR d'une lame d'or traitée conformément à une variante du procédé de la présente invention avec une solution dont le sel de diazonium a été préparé *in situ* à partir de p-benzylamine.
La figure 2 présente le spectre IR d'une lame d'or traitée conformément à une variante du procédé de la présente invention *i.e*. avec une solution dont le sel de diazonium a été préparé *in situ* à partir de p-phenyldiamine.
La figure 3 le spectre IR d'une lame d'or traitée conformément à une variante du procédé de la présente invention, *i.e*. avec une solution de diazonium, après 5, 10 et 15 minutes d'exposition de la lame (respectivement (a), (b) et (c)).
La figure 4 présente le spectre IR d'une lame de nickel traitée conformément à une variante du procédé de la présente invention avec une solution dont le sel de diazonium a été préparé *in situ* à partir de p-benzylamine.
La figure 5 présente le spectre IR d'une lame de d'acier (AISI 316L) traitée conformément à une variante du procédé de la présente invention avec une solution dont le sel de diazonium a été préparé *in situ* à partir de p-benzylamine.
La figure 6 représente une image AFM d'une surface de diamant recouverte d'un film de primaire (Figure 6a) et une courbe profilométrique (longueur X (nm)/hàuteur Z(Å)) de cette surface signalée par une double flèche sur l'image AFM (Figure 6b).
La figure 7 propose la représentation schématique d'un film séquentiel (Figure 7a) et d'un film statistique (Figure 7b) préparés selon la présente invention.
La figure 8 propose une représentation schématique des procédés de greffage de l'état de la technique (Figure 8a) et du procédé selon la présente invention (Figure 8b).
La figure 9 présente le spectre IR d'une lame d'or traitée conformément à une variante du procédé de la présente invention *i.e*. avec une solution dont le sel de diazonium a été préparé *in situ* et en utilisant un monomère.
La figure 10 présente, pour une lame d'or traitée conformément à la présente invention, avec un primaire et un monomère, d'une part, le spectre IR de ladite lame d'or traitée à différents temps d'exposition (Figure 10a) et, d'autre part, le spectre IR de ladite lame d'or traitée en fonction de la quantité de limaille de fer (Figure 10b).
La figure 11 présente les analyses par spectrométrie XPS (spectroscopie des photoélectrons X) d'un feutre de carbone conducteur (Figure 11a) et du même feutre de carbone sur lequel est greffé un film organique préparé selon le procédé de la présente invention *i.e*. à partir d'un sel de diazonium créé *in situ* et d'acide acrylique et ce en présence de limaille de fer (PAA pour polymère d'acide acrylique) (Figure 11b).
La figure 12 présente le spectre IR d'une lame d'or traitée selon le procédé de la présente invention pour former un film séquentiel.
La figure 13 présente le spectre IR d'une lame d'or traitée selon le procédé de la présente invention pour former un film statistique.
La figure 14 présente le spectre IR d'une lame d'or traitée selon le procédé de la présente invention pour former un film à partir d'un monomère insoluble dans le solvant de réaction.
La figure 15 présente le spectre IR d'une lame de verre traitée selon le procédé de la présente invention avec un primaire et un monomère.
La figure 16 présente une photographie de nanotubes de carbone (Figure 16a) et une photographie de nanotubes de carbone après un traitement selon l'invention avec un primaire et un monomère (Figure 16b).
La figure 17 présente le spectre IR d'une lame de PTFE traitée selon le procédé de la présente invention avec un primaire et un monomère.
La figure 18 présente les spectres IR obtenus pour une lame d'or (Figure 18a) et une lame de titane (Figure 18b) traitées de façon identique et selon le procédé de la présente invention *i.e*. à partir de 2-hydroxyéthylméthacrylate et d'un sel de diazonium préparé *in situ* et ce, en présence de limaille de fer.
La figure 19 présente la photographie d'une goutte d'eau sur une lame de verre vierge (Figure 19a) et la photographie d'une goutte d'eau sur la même lame de verre revêtue de p-butylméthacrylate (p-BuMA) conformément au procédé selon l'invention (Figure 19b).
La figure 20 présente la cartographie IR/AFM obtenue pour des lames d'or recouvertes d'un masque d'encre commerciale après traitement par le procédé en présence d'hydroxyméthylmétacrylate (Figure 20a) ou d'acide acrylique (Figure 20b) et élimination du masque.
La figure 21 présente la cartographie IR/AFM obtenue pour une lame d'or recouverte d'un masque de thiol après traitement par le procédé en présence d'acide acrylique et élimination du masque.
La figure 22 présente la cartographie IR/AFM obtenue pour une lame d'or recouverte d'un masque de thiol après traitement par le procédé en présence d'hydroxyméthylmétacrylate et élimination du masque avec différents motifs (Figure 22a et Figure 22b).
La figure 23 présente le spectre IRRAS d'une lame d'or recouverte d'un film comportant du PHEMA et un dérivé de cyclodextrine.
La figure 24 présente le spectre IRRAS d'une lame d'or recouverte d'un film comportant du PHEMA et un dérivé de calixarène.
La figure 25 présente les spectres XPS, C₁ₛ (25a) et N₁ₛ (25b), d'une lame d'or recouverte d'un film élaboré à partir d'un primaire seul et comportant un dérivé de prophyrine.
La figure 26 présente un spectre XPS (global) d'un film comportant du PAA, greffé sur une lame d'or, avant incorporation des nanoparticules de Pt.
La figure 27 présente un spectre XPS (global) d'un film comportant du PAA, greffé sur une lame d'or, après incorporation des nanoparticules de Pt.
La figure 28 présente un spectre XPS (global) d'un film comportant du PAA, greffé sur des nanotubes de carbone, après incorporation des nanoparticules de Pt.

### EXPOSÉ DÉTAILLÉ DE MODES DE RÉALISATION PARTICULIERS

Les exemples qui suivent ont été réalisés dans une cuve en verre. Sauf précision contraire, ils ont été réalisés dans des conditions normales de température et de pression (25°C sous 101,325 kPa (1 atm)) à l'air ambiant. Sauf mention contraire, les réactifs employés ont été directement obtenus dans le commerce sans purification supplémentaire. Les lames d'or employées avaient une surface de 1 cm²

Aucune précaution n'a été prise concernant la composition de l'atmosphère et les solutions n'ont pas été dégazées. Lorsque le temps de réaction n'est pas précisé, il s'agissait d'une exposition de la surface à traiter pendant 1 à 15 min à la solution de réactifs.

Quatre séries d'exemples illustrent les modes de réalisation de l'invention, la première concerne les films préparés à l'aide d'un primaire d'adhésion, la seconde les films préparés à l'aide d'un primaire d'adhésion et d'un monomère, la troisième les films fonctionnalisables, la quatrième les films comportant des nano-objets.

### I - Primaire d'adhésion seul

### Exemple I-1 - Préparation d'un film sur une plaque d'or à partir d'un sel de diazonium issu de la para-benzyl amine, préparé in situ en présence de limaille de fer

A 4 ml d'une solution de para-benzylamine à 0,1 M dans HCl (0,5 M), ont été ajoutés 4 ml d'une solution de NaNO₂ à 0,1 M dans de l'eau afin de former le sel de diazonium. A cette solution de sel de diazonium, ont été ajoutés 200 mg de limaille de fer. Une plaque d'or a alors été introduite dans le milieu réactionnel pendant 15 min. La plaque a ensuite été rincée à l'eau à l'acétone, passée aux ultrasons dans du DMF puis dans une solution basique de soude à pH = 9,5 de façon à déprotoner l'amine primaire, avant d'être séchée.

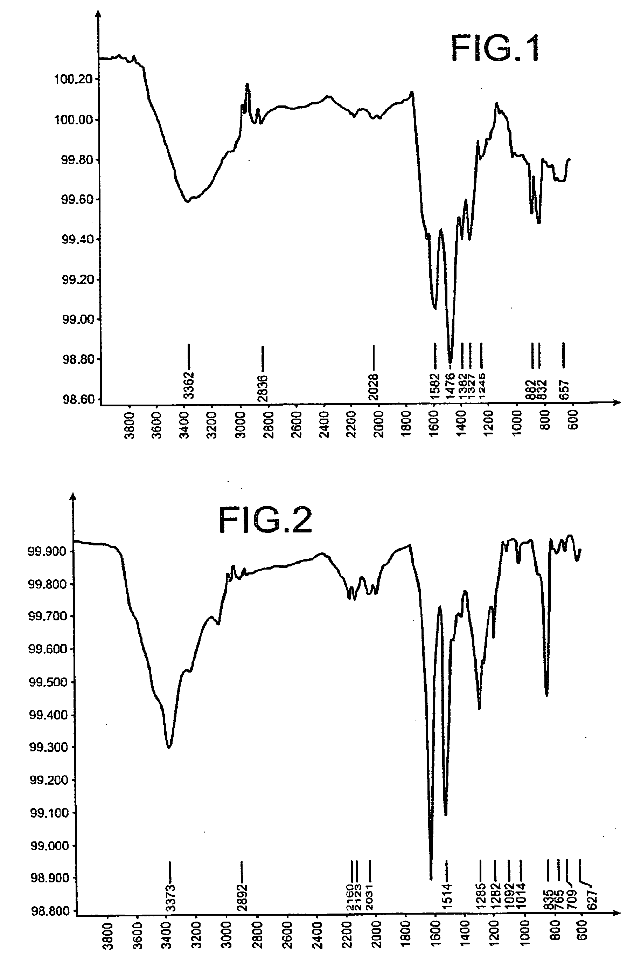

Les analyses par spectrométrie XPS (spectroscopie des photoélectrons X) et IR confirment la présence du film attendu dont l'épaisseur augmente avec le temps de réaction. Les bandes spécifiques du poly-benzylamine à 1476 cm⁻¹ (Déformation C=C), 1582 cm⁻¹ (Déformation N-H) et 3362 cm⁻¹ (Elongation N-H) sont visibles sur le spectre IR d'une plaque après le traitement (Figure 1).

### Exemple I-2 - Préparation d'un film sur une plaque d'or à partir d'un sel de diazonium issu de la p-phenyldiamine préparé in situ en présence de limaille de fer

A 4 ml d'une solution de p-phenyldiamine à 0,1 M dans HCl (0,5 M), ont été ajoutés 4 ml d'une solution de NaNO₂ à 0,1 M dans de l'eau afin de former le sel de diazonium. A cette solution de sel de diazonium, ont été ajoutés 200 mg de limaille de fer. Une plaque d'or a alors été introduite dans le milieu réactionnel pendant 15 min. La plaque a ensuite été rincée à l'eau à l'acétone, passée aux ultrasons dans du DMF puis dans de l'eau avant d'être séchée.

Les analyses par spectrométrie XPS (spectroscopie des photoélectrons X) et IR confirment la présence du film attendu dont l'épaisseur augmente avec le temps de réaction. Les bandes spécifiques du p-phenylamine à 1514 cm⁻¹ (Déformation C=C), 1619 cm⁻¹ (Déformation N-H) et 3373 cm⁻¹ (Elongation N-H) sont visibles sur le spectre IR d'une plaque après le traitement (Figure 2).

### Exemple I-3 - Contrôle de l'épaisseur du film

Afin de montrer l'influence de différents paramètres sur l'épaisseur du film organique, le procédé a été appliqué à une lame d'or, mise en présence d'une solution contenant du chlorure de 4-aminobenzyldiazonium, dans des conditions non électrochimiques permettant la formation d'entités radicalaires. Ce choix a notamment été motivé par la présence des bandes d'adsorption caractéristiques du film obtenu à 1504 cm⁻¹ (Déformation C=C), 1605 cm⁻¹ (Déformation N-H) et 1656 cm⁻¹ (Elongation N-H).

Une solution de sel de diazonium dans l'eau a été préparée en additionnant à 4 ml d'une solution à 0,1 M (4.10⁻⁴ moles) de p-4-aminobenzylamine dans du HCl (0,5 M), 4 ml d'une solution de NaNO₂ à 0,1 M (4.10⁻⁴ moles) sous agitation. A cette solution, a été ajoutée une lame d'or.

Pour étudier l'influence du temps de réaction, la solution a alors été placée dans des conditions non électrochimiques permettant la formation de radicaux sur le primaire d'adhésion par l'ajout de 200 mg de limaille de fer. La plaque a ensuite été extraite du milieu réactionnel et rincée immédiatement avec de l'eau puis à l'acétone et au diméthylformamide (DMF) sous l'action d'ultrasons et enfin séchée sous un courant d'argon.

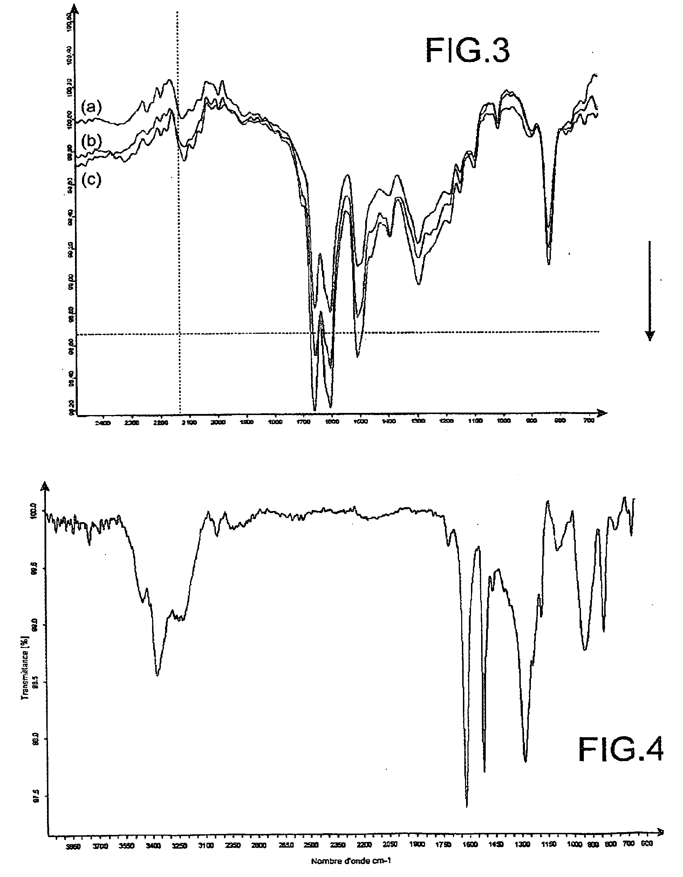

Ainsi que l'illustre le spectre IR représenté à figure 3, le temps d'exposition de l'échantillon au milieu réactionnel exerce une influence sur l'épaisseur du film obtenu. Des temps d'exposition de 5, 10 et 15 minutes ont été testés, il apparait qu'une exposition prolongée augmente l'épaisseur du film. En effet, l'augmentation de l'intensité des bandes d'adsorption du poly-p-4-aminobenzylamine 1504 cm⁻¹, 1605 cm⁻¹ et 1656 cm⁻¹ traduit une augmentation de l'épaisseur du film au cours du temps.

### Exemple I-4 - Préparation d'un film sur une plaque d'or à partir du p-nitrophenyldiazonium commercial en présence de limaille de fer

L'expérience a été menée selon le protocole exposé à l'exemple I-2 en utilisant du p-nitrophenyldiazonium commercial (Aldrich®) solubilisé à 0,05 M dans une solution de HCl (0,5 M). La plaque d'or a alors été immergée dans la solution pendant environ 15 min. La plaque a ensuite été rincée à l'eau et à l'acêtone, passée aux ultrasons dans du DMF puis dans de l'eau avant d'être séchée.

Comme précédemment, les analyses par spectrométrie XPS ont confirmé la présence du film attendu dont l'épaisseur augmente avec le temps de réaction.

### Exemple I-5 - Préparation d'un film sur une plaque d'or à partir d'un sel de diazonium créé in situ en présence de laine d'acier

Le mode opératoire est identique à celui de l'exemple I-1. La limaille de fer a été remplacée par environ 5-10 mg de fibres de laine d'acier (fournisseur CASTORAMA®) successivement fine (0), extra fine (00) et super fine (000), ce qui permet de ne pas avoir de résidus de fer solide dans la solution.

Les analyses XPS et IR confirment la présence du film attendu dont l'épaisseur augmente avec le temps de réaction.

### Exemple I-6 - Préparation d'un film sur une plaque d'or à partir d'un sel de diazonium créé in situ en milieu basque

Le mode opératoire est identique à celui de l'exemple I-1. A la limaille de fer, a été substitué 0,3 ml d'une solution de soude à 2,5. 10⁻³ M afin de permettre une légère remontée de pH au-delà de 4.

Les analyses XPS et IR confirment la présence du film attendu dont l'épaisseur augmente avec le temps de réaction.

### Exemple I-7 - Préparation d'un film sur une plaque d'or à partir d'un sel de diazonium créé in situ amorcé par une membrane de PVDF irradiée.

Le mode opératoire est identique à celui de l'exemple I-1. A la limaille de fer, a été substitué une membrane de PVDF irradiée (2 cm², épaisseur 9 µm, dose d'irradiation électronique : 100 kGy).

Les analyses IR ont confirmé la présence du film attendu dont l'épaisseur a augmenté avec le temps de réaction.

### Exemple I-8 - Préparation d'un film sur une lame de verre à partir d'un sel de diazonium préparé in situ en présence de limaille de fer

Le protocole est identique à celui présenté à l'exemple I-1, une lame de verre a été employée dans ce cas. Le spectre IR confirme la présence du film attendu dont l'épaisseur augmente avec le temps de réaction.

### Exemple I-9 - Préparation d'un film sur une lame de Nickel à partir d'un sel de diazonium préparé in situ en présence de limaille de fer

Le protocole est identique à celui présenté à l'exemple I-1, une lame de Nickel a été employée dans ce cas avec une température de réaction de 40°C. Le spectre IR obtenu (figure 4) confirme la présence du film attendu dont l'épaisseur augmente avec le temps de réaction.

### Exemple I-10 - Préparation d'un film sur une lame d'acier (AISI 316L) à partir d'un sel de diazonium préparé in situ en présence de limaille de fer

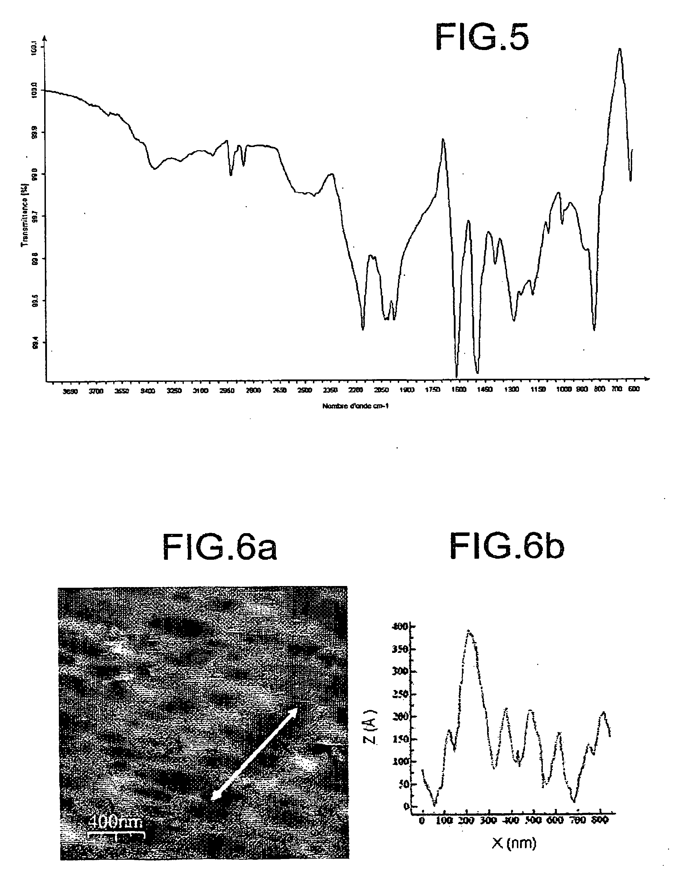

Le protocole est identique à celui présenté à l'exemple I-1, une lame d'acier AISI 316L a été employée dans ce cas. Le spectre IR (figure 5) confirme la présence du film attendu dont l'épaisseur augmente avec le temps de réaction.

### Exemple I-11 - Préparation d'un film sur du diamant à partir d'un sel de diazonium préparé in situ en présence de limaille de fer

Le protocole est identique à celui présenté à l'exemple 1-1, un morceau de diamant a été employé dans ce cas. Une image AFM (Figure 6) confirme la présence du film attendu dont l'épaisseur augmente avec le temps de réaction, l'analyse profilométrique montre la présence du film à la surface.

### II - Primaire d'adhésion et monomère

### Exemple II-1 - Préparation d'un film sur une plaque d'or à partir d'un sel de diazonium préparé in situ et de 2-hydroxyéthylméthacrylate (HEMA) en présence de limaille de fer

A 4 ml d'une solution de p-phenylènediamine à 0,1 M dans HCl (0,5 M), ont été ajoutés 4 ml d'une solution de NaNO₂ à 0,1 M dans de l'eau afin de former le sel de diazonium. A cette solution de sel de diazonium, ont été ajoutés 1 ml de HEMA puis 200 mg de limaille de fer. Une plaque d'or a alors été introduite dans le milieu réactionnel pendant 15 min. La plaque a ensuite été rincée à l'eau à l'acétone, passée aux ultrasons dans du DMF puis dans de l'eau avant d'être séchée.

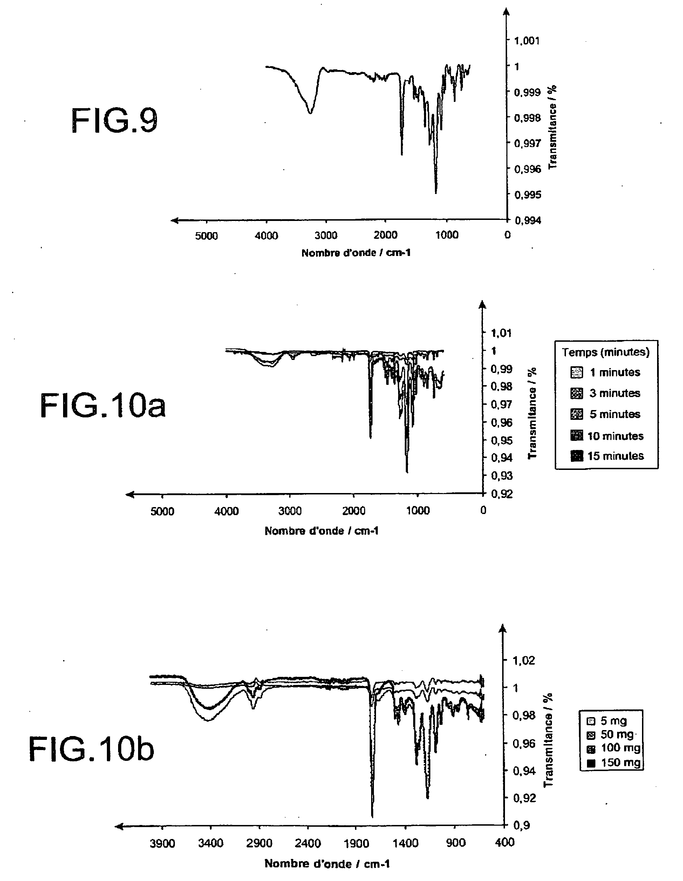

Les analyses par spectrométrie XPS (spectroscopie des photoélectrons X) et IR confirment la présence du film attendu dont l'épaisseur augmente avec le temps de réaction. Sur la figure 9, est représenté le spectre IR d'une plaque après le traitement.

Le tableau 3 présenté ci-après réunit un ensemble de valeurs d'épaisseurs obtenues pour les mêmes réactifs en faisant varier leurs concentrations, le temps d'exposition ou la quantité de limaille.

**Tableau 3**

| **HEMA (mol.l⁻¹)** | **Diazonium (mol.l⁻¹)** | **Temps (min)** | **Fer (mg)** | **Epaisseur (nm)** |
|---|---|---|---|---|
| 0,9 | 0,05 | 1 | 200 | 10 |
| 0,9 | 0,05 | 3 | 200 | 50 |
| 0,9 | 0,05 | 5 | 200 | 90 |
| 0,9 | 0,05 | 10 | 200 | 140 |
| 0,9 | 0,05 | 15 | 200 | 200 |
| 0,45 | 0,025 | 1 | 200 | <10 |
| 0,45 | 0,025 | 3 | 200 | 20 |
| 0,45 | 0,025 | 5 | 200 | 40 |
| 0,45 | 0,025 | 10 | 200 | 90 |
| 0,45 | 0,025 | 15 | 200 | 120 |
| 0,9 | 0,05 | 10 | 5 | <10 |
| 0,9 | 0,05 | 10 | 50 | 30 |
| 0,9 | 0,05 | 10 | 100 | 70 |
| 0,9 | 0,05 | 10 | 150 | 100 |
| 0,9 | 0,05 | 10 | 200 | 150 |

L'augmentation du temps d'exposition, de la concentration en primaire et en monomère, tout comme la quantité de limaille de fer, permettent d'accroître l'épaisseur du film formé.

### Exemple II-2 - Contrôle de l'épaisseur du film

Afin de montrer l'influence de différents paramètres sur l'épaisseur du film organique, le procédé a été appliqué à une lame d'or, mise en présence d'une solution contenant un primaire d'adhésion, le chlorure de 4-aminophényldiazonium, et un monomère, le HEMA, dans des conditions non électrochimiques permettant la formation d'entité radicalaire à partir du primaire d'adhésion. Ce choix a notamment été motivé par la présence des bandes d'adsorption caractéristiques à 1726, 1454 et 1166 nm du poly-HEMA.

Une solution de primaire d'adhésion dans l'eau a été préparée en additionnant à 4 ml d'une solution à 0,1 M (9.1,0⁻⁴ moles) de p-phenylènediamine dans HC1 (0,5 M), 4 ml d'une solution de NaNO₂ à 0,1 M (4.10⁻⁴ moles) sous agitation. A cette solution, ont été ajoutés 1 ml (8,24 mmoles) de HEMA), ainsi qu'une lame d'or.

### 2-1. influence du temps de réaction

La solution a alors été placée dans des conditions non électrochimiques permettant la formation de radicaux sur le primaire d'adhésion par l'ajout de 200 mg de limaille de fer. La plaque a ensuite été extraite du milieu réactionnel et rincée immédiatement avec de l'eau puis à l'acétone et au diméthylformamide (DMF) sous l'action d'ultrasons et enfin séchée sous un courant d'argon.

Ainsi que l'illustre le spectre IR représenté à figure 10a, le temps d'exposition de l'échantillon au milieu réactionnel exerce une influence sur l'épaisseur du film obtenu. En effet, l'augmentation de l'intensité des bandes d'adsorption du HEMA à 1726, 1454 et 1166 nm traduit une augmentation de l'épaisseur du film au cours du temps.

L'épaisseur des films a été mesurée à l'aide d'un profilomètre : elle varie de 12 nm à 200 nm pour un temps d'exposition variant de 1 à 15 min.

### 2-2. influence des conditions non électrochimiques permettant la formation de radicaux sur le primaire d'adhésion

Considérant que la quantité de radicaux présents en solution exerce une influence notable sur la réaction, le procédé à été mené avec une quantité variable de limaille de fer pour un temps de réaction fixé à 10 min.

Ainsi que l'illustre le spectre IR représenté à figure 10b, la quantité de limaille de fer présente dans le milieu réactionnel exerce une influence sur l'épaisseur du film obtenu. Une quantité minimale de limaille est nécessaire pour générer suffisamment de radicaux dans le milieu réactionnel et permettre l'obtention d'un film greffé d'épaisseur détectable en IR. Au-delà d'une certaine valeur maximale de limaille, les variations d'épaisseur du film obtenu s'avèrent négligeables.

### Exemple II-3 - Préparation d'un film sur une plaque d'or à partir du p-nitrophenyldiazonium commercial et de REMUA en présence de limaille de fer

L'expérience a été menée selon le protocole exposé à l'exemple II-2 en utilisant du p-nitrophenyldiazonium commercial (Aldrich®) solubilisé à 0,05 M dans une solution de HCl (0,5 M). La plaque d'or a alors été immergée dans la solution pendant environ 15 min. La plaque a ensuite été rincée à l'eau et à l'acétone, passée aux ultrasons dans du DMF puis dans de l'eau avant d'être séchée.

Comme précédemment, les analyses par spectrométrie XPS (spectroscopie des photoélectrons X) et IR ont confirmé la présence du film attendu dont l'épaisseur augmente avec le temps de réaction.

### Exemple II-4 - Préparation d'un film sur une plaque d'or à partir d'un sel de diazonium créé in situ et de HEMA en milieu basique

Le mode opératoire est identique à celui de l'exemple II-2. A la limaille de fer, ont été substitués 0,3 ml d'une solution de soude à 2,5. 10⁻³ M afin de permettre une légère remontée de pH au-delà de 4.

Les analyses XPS et IR confirment la présence du film attendu dont l'épaisseur augmente avec le temps de réaction.

### Exemple II-5 - Préparation d'un film sur un feutre de carbone conducteur à partir d'un sel de diazonium créé in situ et d'acide acrylique (AA) en présence de limaille de fer

L'exemple a été réalisé selon les modalités décrites à l'exemple II-2, le monomère employé dans ce cas était l'acide acrylique (1 ml) et l'échantillon était constitué de feutre de carbone.

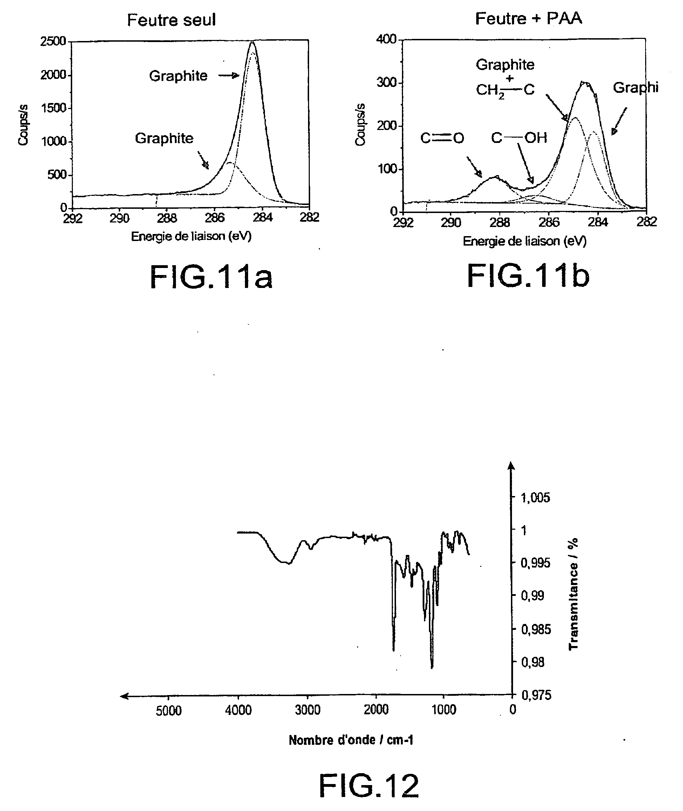

L'analyse XPS, comme le montre le spectre de la figure 11, confirme la présence du film attendu.

### Exemple II-6 - Préparation d'un film séquentiel sur une plaque d'or à partir d'un diazonium préparé in situ, de HEMA et de AA en présence de limaille de fer

Dans un premier temps, une plaque a été préparée et nettoyée selon les modalités de l'exemple II-2.

Une nouvelle solution du même sel de diazonium a ensuite préparée et il lui a été additionné 1 ml d'acide acrylique puis 200 mg de la limaille de fer. La plaque préalablement préparée selon l'exemple II-2 a ensuite été introduite dans le milieu réactionnel pendant un temps variable à l'issu duquel elle a été nettoyée et séchée ainsi que décrit précédemment.

La figure 12 représente le spectre IR obtenu pour une telle plaque après 15 minutes de réaction. Les bandes caractéristiques du PAA (polymère d'acide acrylique) à 1590 et 1253 nm apparaissent sur le spectre de l'exemple 2.

### Exemple II-7 - Préparation d'un film statistique sur une plaque d'or à partir d'un diazonium préparé in situ, de HEMA et de AA en présence de limaille de fer

Le mode opératoire suivi correspond à celui décrit à l'exemple II-2 à ceci près qu'à la solution de sel de diazonium sont ajoutés 0,5 ml d'acide acrylique ainsi que 0,5 ml de HEMA.

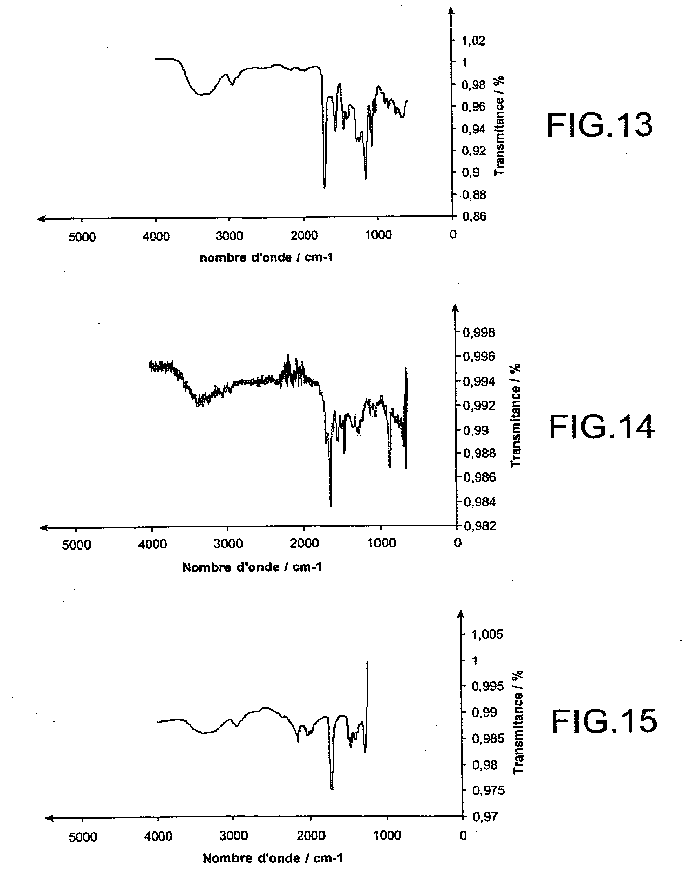

Le spectre IR obtenu est représenté à la figure 13 : il confirme la présence du film statistique attendu constitué notamment des deux monomères.

### Exemple II-8 - Préparation d'un film sur une plaque d'or à partir d'un sel de diazonium préparé in situ et de 4-vinyl-pyridine (4VP) en présence de limaille de fer

A une solution de sel de diazonium préparée selon l'exemple II-2 contenant une lame d'or, ont été ajoutés 200 mg de limaille de fer puis une dispersion de 1 ml de 4-vinyl-pyridine dans 10 ml d'eau, préparée par traitement ultrasonique. Après un temps de réaction variable, la lame est ensuite nettoyée et séchée selon les modalités décrites plus haut.

Le spectre IR obtenu pour la plaque est représenté figure 14. Les bandes caractéristiques à 1602, 1554, et 1419 nm valident la présence du film attendu.

### Exemple II-9 - Préparation d'un film sur une lame de verre à partir d'un sel de diazonium préparé in situ et de HEMA en présence de limaille de fer

Le protocole est identique à celui présenté à l'exemple II-2, une lame de verre ayant été employée dans ce cas.

Le spectre IR représenté figure 15 confirme la présence du film attendu dont l'épaisseur augmente avec le temps de réaction.

### Exemple II-10 - Préparation d'un film sur des nanotubes de carbone à partir d'un sel de diazonium préparé in situ et de HEMA en présence de limaille de fer

A une solution de sel de diazonium préparée comme indiqué à l'exemple II-2, ont été ajoutés 200 mg de limaille de fer et 1 ml de HEMA. A cette solution, ont ensuite été ajoutés 100 mg de nanotubes de carbone sous forme de tapis. Le tapis, après réaction, a été nettoyé selon le protocole décrit à l'exemple 2 avant d'être séché.

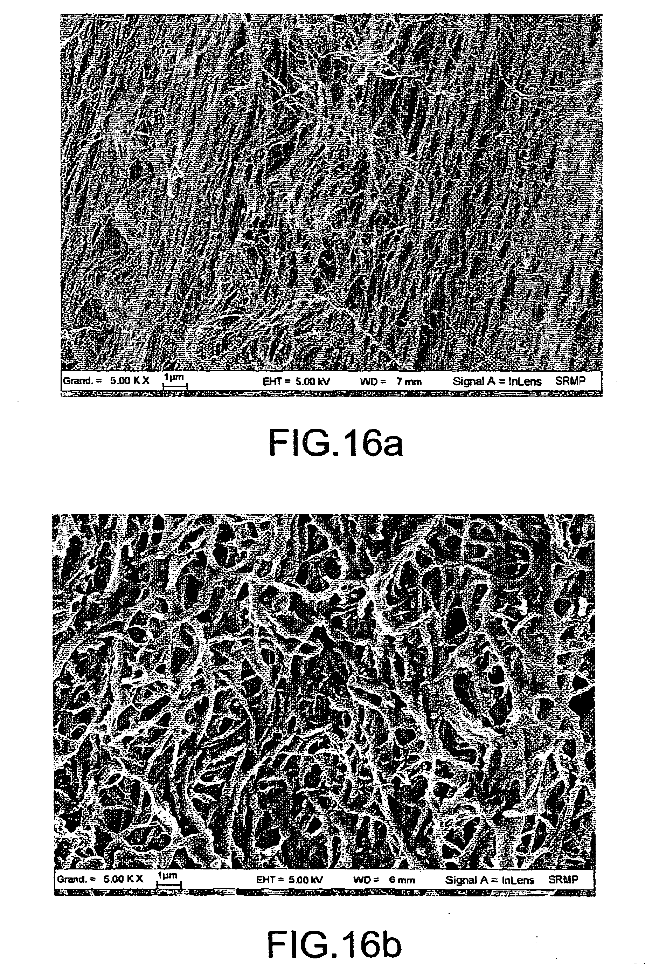

Les photographies obtenues par microscopie électronique à balayage (MEB), présentées à la figure 16 correspondent à des nanotubes avant (Figure 16a) et après (Figure 16b) traitement.

### Exemple II-11 - Préparation d'un film sur une surface de PTFE (teflon®) à partir d'un sel de diazonium préparé in situ et de HEMA en présence de limaille de fer

A 4 ml d'une solution de p-phenylènediamine à 0,1 M dans HCl (0,5 M), ont été ajoutés 4 ml d'une solution de NaNO₂ à 0,1 M dans de l'eau afin de former le sel de diazonium. A cette solution de sel de diazonium, ont été ajoutés 1 ml de HEMA puis 200 mg de limaille de fer. Une pièce de teflon® de 4 cm² est alors introduite dans le milieu réactionnel pendant 15 min, la plaque a ensuite été rincée à l'eau et à l'acétone, passée aux ultrasons dans du DMF puis dans de l'eau avant d'être séchée.

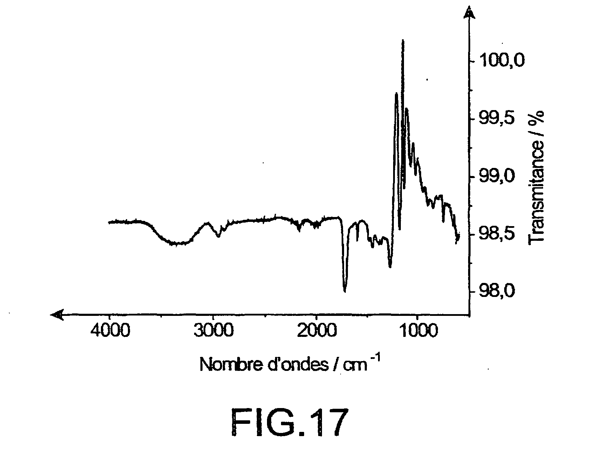

Les analyses par spectrométrie et IR (Figure 17) confirment la présence du film attendu dont l'épaisseur augmente avec le temps de réaction.

### Exemple II-12 - application du procédé à différents échantillons

Le procédé a été appliqué avec succès à un grand nombre d'échantillons de natures diverses et différents monomères ont été employés. Le sel de diazonium employé dans cet exemple a été préparé *in situ* à partir de p-phénylènediamine.

Les résultats obtenus pour chaque type d'échantillon en fonction du monomère sont présentés dans le tableau 4 ci-après. Pour chacun des échantillons testés, la présence du film organique a été vérifiée à l'aide des spectres IR.

**Tableau 4**

| **Support** | **Monomère** | **Temps (min)** | **Film** |
|---|---|---|---|
| Or | HEMA | 15 | oui |
| Or | Acide Acrylique | 15 | oui |
| Or | Acrylogitrile | 15 | oui |
| Water silicium | HEMA | 20 | oui |
| Water silicium | Acide Acrylique | 20 | oui |
| Water silicium | Acrylonitrile | 20 | oui |
| Aluminium | HEMA | 30 | oui |
| Aluminium | Acide Acrylique | 30 | oui |
| Aluminium | Acrylonitrile | 30 | oui |
| Nanotubes (c) | HEMA | 15 | oui |
| Nanotubes (c) | Acide Acrylique | 15 | oui |
| Feutre | HEMA | 15 | oui |
| Feutre | Acide Acrylique | 15 | oui |
| Feutre | Acrylonitrile | 15 | oui |
| Platine | HEMA | 15 | oui |
| Platine | Acide Acrylique | 15 | oui |
| Platine | Acrylonitrile | 15 | oui |
| Inox | HEMA | 15 | oui |
| Inox | Acide Acrylique | 15 | oui |
| Inox | Acrylonitrile | 15 | oui |
| Zinc | HEMA | 15 | oui |
| Zinc | Acide Acrylique | 15 | oui |
| Zinc | Acrylonitrile | 15 | oui |
| Titane | HEMA | 15 | oui |
| Titane | Acide Acrylique | 15 | oui |
| Titane | Acrylonitrile | 15 | oui |
| Nickel | HEMA | 15 | oui |
| Nickel | Acide Acrylique | 15 | oui |
| Nickel | Acrylonitrile | 15 | oui |
| Bois | HEMA | 45 | oui |
| Papier | HEMA | 45 | oui |
| Coton | HEMA | 45 | oui |
| Teflon | HEMA | 30 | oui |

### Exemple II-13 - Préparation d'un film sur des surfaces de natures différentes (lame d'or et lame de titane) pour une même solution

A 4 ml d'une solution de p-phenylènediamine à 0,1 M dans HCl (0,5 M), ont été ajoutés 4 ml d'une solution de NaNO₂ à 0,1 M dans de l'eau afin de former le sel de diazonium. A cette solution de sel de diazonium, ont été alors ajoutés 1 ml de HEMA puis 200 mg de limaille de fer. Une lame d'or et en même temps une lame de titane de 4 cm² ont alors été introduites dans le milieu réactionnel pendant 15 min. Les lames ont ensuite été rincées à l'eau et à l'acétone, passées aux ultrasons dans du DMF puis dans de l'eau avant d'être séchées.

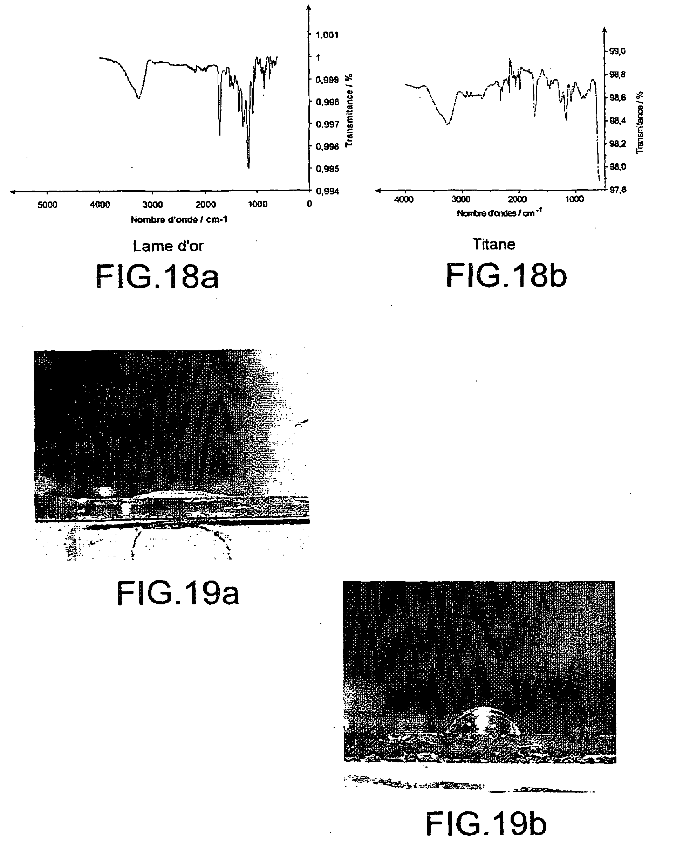

Les analyses par spectrométrie et IR (Figure 18) confirment la présence du film attendu pour les deux supports.

### Exemple II-14 - Préparation d'un film sur une plaque de verre à partir d'un sel de diazonium préparé in situ et de Butylméthacrylate en présence de limaille de fer

A une solution de sel de diazonium préparée selon l'exemple II-2 et contenant une lame de verre préalablement nettoyée par un traitement à la solution "piranha" (*i.e*. un mélange 60/40 en volume d'acide sulfurique concentré et d'eau oxygénée à 110 volumes), ont été ajoutés 200 mg de limaille de fer puis une dispersion de 1 ml de butylméthacrylate (BUMA) dans 10 ml d'eau préparée par traitement ultrasonique. Après un temps de réaction de 10 minutes, la lame est ensuite nettoyée et séchée selon les modalités décrites plus haut.

Un test de la goutte a alors été effectué sur la lame de verre ainsi revêtue (Figure 19b) et sur une lame de verre vierge pour contrôle (Figure 19a). Un changement de propriété physique de la lame de verre ainsi revêtue qui devient hydrophobe peut être observé à l'aide de la variation de l'angle de surface entre la goutte et la surface.

### Exemple II-15 - Préparation d'un film sur une lame d'or présentant un masque d'encre commerciale à partir d'un sel de diazonium préparé in situ et d'hydroxyméthylmétacrylate (HEMA) ou d'acide acrylique (AA) en présence de limaille de fer

Le protocole qui a été employé est identique à celui de l'exemple II-2 pour le HEMA et 5 pour l'AA. Préalablement à son introduction dans le milieu réactionnel, la lame a été revêtue d'un masque : différents motifs ont été réalisés sur la lame d'or à l'aide d'un feutre à encre de couleur noire (Staedtler®-lumocolor®).

Après réaction, la lame a été lavée avec de l'eau, du DMF et de l'acétone pour éliminer les produits de réaction puis encore lavée plus sévèrement aux ultrasons avec les mêmes solvants. La surface a été ensuite une nouvelle fois rincée à l'acétone puis séchée avant d'être analysée par spectroscopie Infrarouge (IR) (bandes C=O pour chacun des polymères) et par Microscopie à Force Atomique (AFM).

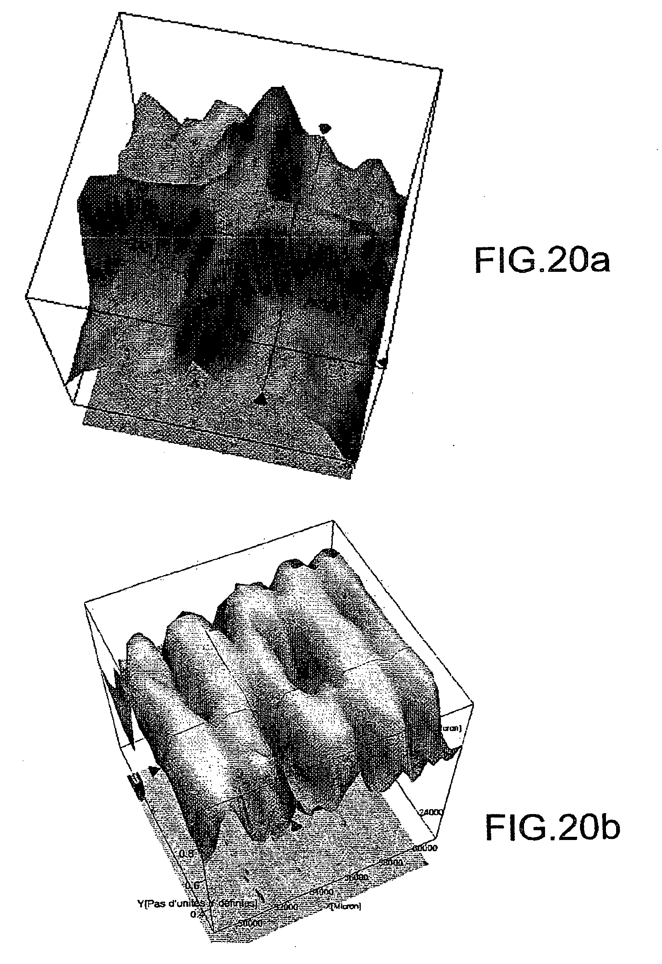

Les différentes cartographies (IR/AFM) obtenues sont illustrées à la figure 20. Sur la figure 20a, on peut constater la présence d'un motif en forme de croix et sur la figure 20b d'un autre motif qui ne sont pas recouverts par le film organique (il s'agit de mesure en transmitance, aussi, les zones en relief correspondent aux zones non greffées).

### Exemple II-16 - Préparation d'un film sur une lame d'or présentant un masque de thiol à partir d'un sel de diazonium préparé in situ et d'acide acrylique (AA) en présence de limaille de fer

Le protocole qui a été employé est identique à celui de l'exemple II-15. Préalablement à son introduction dans le milieu réactionnel une goutte d'une solution éthanolique de thiol à longue chaîne (en C18) a été déposée sur la lame, la lame a été traitée après évaporation de l'éthanol.

Après le traitement la lame a été nettoyée et analysée comme à l'exemple II-15.

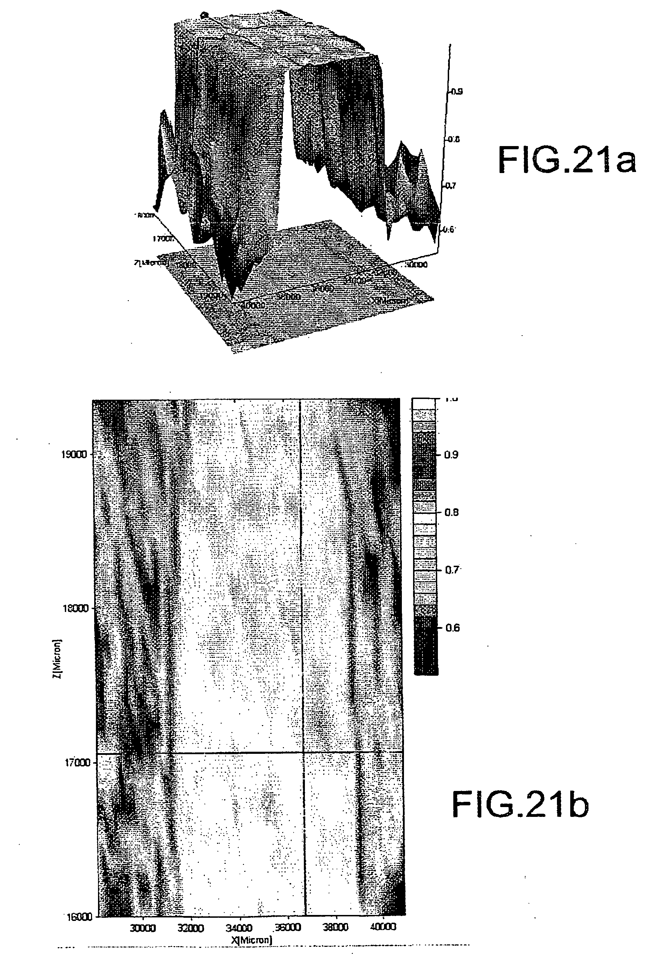

La cartographie IR/AFM est illustrée aux figures 21a et 21b qui représentent respectivement une vue en trois dimensions (il s'agit de mesure en transmitance, aussi, les zones en relief correspondent aux zones non greffées) et une vue plane de la lame (la zone claire correspondant à la zone non greffée). On peut constater sur ces figures que les zones qui étaient recouvertes par le masque ne présentent pas de film greffé.

### Exemple II-17 - Préparation d'un film sur une surface d'or présentant un masque micro-imprimé de thiol à partir d'un sel de diazonium préparé in situ et d'hydroxyméthylmétacrylate (HEMA) en présence de limaille de fer

Le protocole qui a été employé est identique à celui de l'exemple II-15. Préalablement à son introduction dans le milieu réactionnel la lame est recouverte d'un masque de thiol à l'aide d'un tampon de PDMS présentant des motifs micrométriques et préalablement imprégnés d'une solution éthanolique de thiol à longue chaine (en C18). La lame a été traitée après évaporation de l'éthanol.

Après le traitement la lame a été nettoyée et analysée comme à l'exemple II-15.

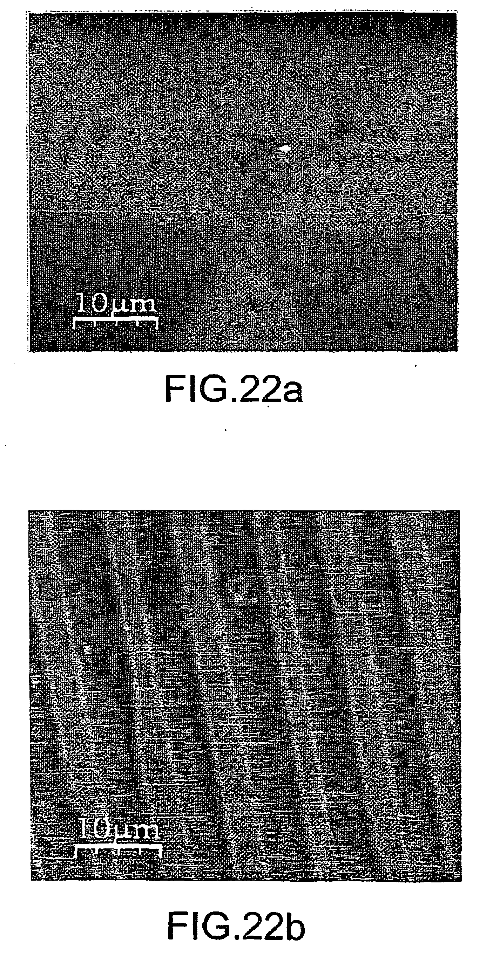

La cartographie AFM est illustrée à la figure 22a qui montre que la surface greffée correspond à l'inverse des motifs micrométriques triangulaires figurant sur le tampon et à la figure 22b qui montre des motifs micrométriques correspondant à des lignes (il s'agit de mesure en transmitance, aussi, les zones en relief correspondent aux zones non greffées).

### Exemple II- 18 - Préparation d'un film sur une plaque d'or à partir d'un sel de diazonium créé in situ amorcé par une membrane de PVDF non poreuse irradiée aux électrons et en présence d'acétonitrile (ACN) .

A 4 ml d'une solution de para-benzylamine à 0,1 M dans HCl (0,5 M), ont été ajoutés 4 ml d'une solution de NaNO₂ à 0,1 M dans de l'eau afin de former le sel de diazonium.

A 4 ml de la solution contenant le sel de diazonium, ont été ajoutés 4 ml d'acétonitrile (ACN). A la limaille de fer employée dans les exemples précédents a été substituée une membrane de PVDF non poreuse irradiée aux électrons (2 cm², épaisseur 9 µm, dose d'irradiation électronique : 100 kGy). Une plaque d'or a alors été introduite dans le milieu réactionnel pendant 15 min. La plaque a ensuite été rincée à l'eau à l'acétone, soumise à un traitement ultrasonore dans du DMF puis dans une solution basique de soude à pH = 9,5 de façon à déprotoner l'amine primaire, avant d'être séchée.

Les analyses IR ont confirmé la présence du film attendu dont l'épaisseur a augmenté avec le temps de réaction.

### Exemple II- 19 - Préparation d'un film sur une plaque d'or à partir d'un sel de diazonium créé in situ amorcé par une membrane de PVDF nanoporeuse réirradiée aux électrons et en présence d'acétonitrile (ACN) .

A 4 ml d'une solution de para-benzylamine à 0,1 M dans HCl (0,5 M), ont été ajoutés 4 ml d'une solution de NaNO₂ à 0,1 M dans de l'eau afin de former le sel de diazonium.

A 4 ml de la solution contenant le sel de diazonium, ont été ajoutés 4 ml d'acétonitrile (ACN). A la limaille de fer employée dans les exemples précédents a été substituée une membrane de PVDF nanoporeuse (fluence :10 ¹⁰ pores par cm², diamètre des pores : 50 nm) réirradiée aux électrons (2 cm², épaisseur 9 µm, dose d'irradiation électronique : 100 kGy).

Une plaque d'or a alors été introduite dans le milieu réactionnel pendant 15 min. La plaque a ensuite été rincée à l'eau à l'acétone, passée aux ultrasons dans du DMF puis dans une solution basique de soude à pH = 9,5 de façon à déprotoner l'amine primaire, avant d'être séchée.

Les analyses IR ont confirmé la présence du film attendu dont l'épaisseur a augmenté avec le temps de réaction.

### Exemple II- 20 - Préparation d'un film sur une plaque d'or à partir d'un sel de diazonium créé in situ amorcé par une membrane de PVDF irradiée aux électrons, en présence d'acide acrylique (AA).

A 6,5 ml d'une solution de para-benzylamine à 0,1 M dans HCl (0,5 M), ont été ajoutés 6,5 ml d'une solution de NaNO₂ à 0,1 M dans de l'eau afin de former le sel de diazonium.

A la solution contenant le sel de diazonium, ont été ajoutés 2 ml d'acide acrylique (AA). L'ensemble a été placé sous atmosphère inerte et un barbotage d'argon (Ar) a été effectué pendant 15 min.

A la limaille de fer employée dans les exemples précédents a été substituée une membrane de PVDF non poreuse irradiée aux électrons (2 cm², épaisseur 9 µm, dose d'irradiation électronique : 100 kGy). Une plaque d'or a alors été introduite dans le milieu réactionnel pendant 15 min toujours sous atmosphère inerte (Ar). La plaque a ensuite été rincée à l'eau et à l'acétone, un traitement ultrasonore a été appliqué avant que la plaque ne soit séchée.

Les analyses IR ont confirmé la présence du film attendu dont l'épaisseur a augmenté avec le temps de réaction.

### Exemple II- 21 - Préparation d'un film sur une plaque d'or à partir d'un sel de diazonium créé in situ amorcé par une membrane de PVDF nanoporeuse réirradiée aux électrons en présence d'acide acrylique (AA).

A 6,5 ml d'une solution de para-benzylamine à 0, 1 M dans HCl (0,5 M), ont été ajoutés 6,5 ml d'une solution de NaNO₂ à 0,1 M dans de l'eau afin de former le sel de diazonium.

A la solution contenant le sel de diazonium, ont été ajoutés 2 ml d'acide acrylique (AA). L'ensemble a été placé sous atmosphère inerte et un barbotage d'argon (Ar) a été effectué pendant 15 min.

A la limaille de fer employée dans les exemples précédents a été substituée une membrane de PVDF nanoporeuse (fluence :10 ¹⁰ pores par cm², diamètre des pores : 50 nm) réirradiée aux électrons (2 cm ², épaisseur 9 µm, dose d'irradiation électronique : 100 kGy).

Une plaque d'or a alors été introduite dans le milieu réactionnel pendant 15 min toujours sous atmosphère inerte (Ar). La plaque a ensuite été rincée à l'eau à l'acétone, traitée aux ultrasons avant d'être séchée.

Les analyses IR ont confirmé la présence du film attendu dont l'épaisseur a augmenté avec le temps de réaction.

### Exemple II- 22 - Préparation d'un film sur une plaque d'or à partir d'un sel de diazonium créé in situ amorcé par une membrane de PVDF irradiée aux électrons, en présence d'acétonitrile (ACN) et d'acide acrylique (AA).

A 4 ml d'une solution de para-benzylamine à 0,1 M dans HCl (0,5 M), ont été ajoutés 4 ml d'une solution de NaNO₂ à 0,1 M dans de l'eau afin de former le sel de diazonium.

A 4 ml de la solution contenant le sel de diazonium, ont été ajoutés 11 ml d'acétonitrile (ACN) et 2 ml d'acide acrylique (AA). L'ensemble a été placé sous atmosphère inerte et un barbotage d'argon (Ar) a été effectué pendant 15 min.

A la limaille de fer employée dans les exemples précédents a été substituée une membrane de PVDF non poreuse irradiée aux électrons (2 cm², épaisseur 9 µm, dose d'irradiation électronique : 100 kGy). Une plaque d'or a alors été introduite dans le milieu réactionnel pendant 15 min toujours sous atmosphère inerte (Ar). La plaque a ensuite été rincée à l'eau à l'acétone, passée aux ultrasons avant d'être séchée.

Les analyses IR ont confirmé la présence du film attendu dont l'épaisseur a augmenté avec le temps de réaction.

### Exemple II- 23 - Préparation d'un film sur une plaque d'or à partir d'un sel de diazonium créé in situ amorcé par une membrane de PVDF nanoporeuse réirradiée aux électrons, en présence d'acétonitrile (ACN) et d'acide acrylique (AA).

A 4 ml d'une solution de para-benzylamine à 0,1 M dans HCl (0,5 M), ont été ajoutés 4 ml d'une solution de NaNO₂ à 0,1 M dans de l'eau afin de former le sel de diazonium.

A 4 ml de la solution contenant le sel de diazonium, ont été ajoutés 11 ml d'acétonitrile (ACN) et 2 ml d'acide acrylique (AA). L'ensemble a été placé sous atmosphère inerte et un barbotage d'argon (Ar) a été effectué pendant 15 min.

A la limaille de fer employée dans les exemples précédents a été substitué une membrane de PVDF nanoporeuse (fluence :10 ¹⁰ pores par cm², diamètre des pores : 50 nm) réirradiée aux électrons (2 cm², épaisseur 9 µm, dose d'irradiation électronique : 100 kGy).

Une plaque d'or a alors été introduite dans le milieu réactionnel pendant 15 min toujours sous atmosphère inerte (Ar). La plaque a ensuite été rincée à l'eau à l'acétone, passée aux ultrasons avant d'être séchée.

Les analyses IR ont confirmé la présence du film attendu dont l'épaisseur a augmenté avec le temps de réaction.

### Exemple II- 24 - Préparation d'un film sur une plaque d'or à partir du p-nitrophenyldiazonium commercial et de 2-hydroxyéthylméthacrylate (HEMA) en présence de ferrocène.

A 2 ml de diméthylformamide (DMF), ont été ajoutés 0,04 mole de ferrocène et 1 ml d'HEMA (3.10⁻³ M). A cette solution, a été ajoutée 2 ml d'une solution de DMF contenant 0,015 mole de p-nitrophenyldiazonium tétrafluoroborate. Une plaque d'or a alors été introduite dans le milieu réactionnel pendant 30 min. La plaque a ensuite été rincée avec de la DMF et de l'acétone avant d'être traitée aux ultrasons pour 3 minutes dans du DMF et rincée de nouveau à l'acétone avant d'être séchée.

Les analyses IR ont confirmé la présence du film attendu dont l'épaisseur augmente avec le temps de réaction. Les bandes spécifiques du poly-HEMA à 1726, 1454 et 1166 cm⁻¹ sont visibles sur le spectre IR d'une plaque après le traitement.

La même réaction a été effectuée dans l'acétone et le diméthylsulfoxyde (DMSO).

### Exemple II- 25 - Préparation d'un film sur la surface de nanotubes de carbone multiparois (MWCNTs) à partir du p-nitrophenyldiazonium commercial et de butylméthacrylate (BUMA) en présence de ferrocène.

Une solution de 0,04 mole de ferrocène dans 5 ml de BUMA (3.10⁻³ M) est ajoutée une solution préalablement soumise aux ultrasons 10,2 mg de MWCNTs dans 8 ml de diméthylformamide (DMF). Ce mélange a été agité durant 3 minutes avant d'ajouter 0,015 mole de p-nitrophenyldiazonium tétrafluoroborate. Après 2 heures de réaction, les nanotubes ont été filtrés et rincés plusieurs fois avec de la DMF puis de l'acétone. Ils ont été ensuite sechés dans une étuve sous pression réduite (100 °C, 10⁻² Torr). Les analyses par spectrométrie XPS (spectroscopie des photoélectrons X) et en microscopie électronique à balayage (MEB) confirment la présence du film attendu dont l'épaisseur augmente avec le temps de réaction.

### Exemple II- 26 - Préparation d'un film sur la surface d'un tapis de nanotubes de carbone multiparois (MWCNTs) à partir du p-nitrophenyldiazonium commercial et de 2-hydroxyéthylméthacrylate (HEMA) en présence de ferrocène.

A 12 ml de diméthylformamide (DMF), ont été ajoutés 0,04 mole de ferrocène, 5 ml d'HEMA et le tapis de MWCNTs supporté par un substrat de silicium(1 cm² de substrat de silicium avec des tubes de 275 µm). A cette solution, ont été ajoutés 103,9 mg (0,015 moles) de p-nitrophenyldiazonium tétrafluoroborate. Après 2 heures de réaction, les nanotubes ont été rincés plusieurs fois avec de la DMF puis de l'acétone. Ils ont été ensuite séchés dans une étuve sous pression réduite (100 °C, 10⁻² Torr). Les analyses par spectrométrie XPS (spectroscopie des photoélectrons X) et en microscopie électronique à balayage (MEB) confirment la présence du film attendu dont l'épaisseur augmente avec le temps de réaction.

### III - Films fonctionnalisables

### Exemple III-1 - film comportant du PHEMA et des greffons dérivé de CD sur une lame d'or

La per- (3, 6) -anhydro-β-cyclodextrine (PaCD) (M = 1008 g/mol) a tout d'abord été préparée selon le protocole décrit dans Gadelle, A.; Defaye, J. Angew. Chem., Int. Ed. Engl. 1991, 30, 78*.* La fonction acide carboxylique de la PaCD (10 mg) a ensuite été activée en formant un ester activé à l'aide de N,N'-diisopropylcarbodiimide (DIC) (6 éq.) dans la DMF (5 ml) sous agitation pendant 6 heures en présence de quantités catalytiques (0,05 éq.) de diméthyle amino pyridine (DMAP).

Une lame d'or de surface de 2 cm² recouverte d'un film, d'environ 10 nm d'épaisseur, comportant du poly(2-hydroxyethyl)methacrylate (PHEMA) et réalisé selon les modalités de l'exemple II-3, a été placée dans un tube à essais fermé contenant 6 ml de DMF ainsi que la PaCD activée.

Le mélange réactionnel a été laissé sous agitation 72 heures à température ambiante puis la lame est extraite, rincée au DMF et à l'acétone avant d'être séchée.

Une analyse XPS et IRRAS confirme que le film comporte un greffon cyclodextrine.

La captation du plomb par un film comportant des greffons CD tels que ceux de cet exemple a été démontrée à l'aide d'une balance à quartz (QCM 922 SEIKO^{®}). Un quartz avec un dépôt d'or (fournie par SEIKO) comportant un film tel que réalisé précédemment a été plongée dans une solution de PbNO₃ (10⁻⁴ M) durant 130 s, la variation de fréquence de résonnance du quartz met en évidence la complexation.

### Exemple III-2 - film comportant du PAA et des greffons dérivé de CD, comportant un groupe de liaison, sur une lame d'or

La PaCD a été préparée conformément à l'exemple III-1. Un bras propanol a été ajouté à la PaCD pour former un greffon comportant un groupe de liaison (LG).

A une solution de PaCD (250 mg) dans du DMF (10 ml) ont été ajoutés du NaH (350 mg ; 28 éq.) et du 3-bromo-1-propanol (0,6 ml ; 28 éq.). Après 24 heures, du méthanol (5 ml) est ajouté au milieu réactionnel, puis la solution est évaporée et le solide obtenu est solubilisé dans l'eau (0,5 ml) avant d'être précipité dans l'acétone (300 ml). Après filtration, le solide beige obtenu est filtré sur büchner et séché. Un mélange de PaCDs bras propanol substituées à des degrés divers, de 4 à 14 propanols, est obtenu.

Une lame d'or de surface de 2 cm² avec un film de PAA de 100 nm environ, préparée selon les modalités de l'exemple II-2 à partir d'acide acrylique, a été est placée dans un tube à essai contenant le mélange de PaCDs bras propanol (10 mg) solubilisé dans du DMF (6 ml).

Le mélange réactionnel a été laissé sous agitation 72 heures à température ambiante puis la lame est extraite, rincée au DMF et à l'acétone avant d'être séchée.

L'analyse XPS a confirmé la présence de la cyclodextrine. En effet le pic du O₁ₛ à 534 eV qui apparaît est typique des liaisons esters de la cyclodextrine. De même sur le spectre du C₁ₛ le pic centré à 289 eV correspond aux liaisons C-O.

Sur le spectre IRRAS apparait une bande intense à 1740 cm⁻¹ typique de la bande de valence C=O (ester) qui confirme la formation d'un ester. De plus, les bandes apparaissant à 1250 cm⁻¹ typiques des liaisons C-O (bande de valence) démontrent la présence de la cyclodextrine sur le substrat.

La captation du plomb par un film comportant des greffons CD tels que ceux de cet exemple a été démontrée à l'aide d'une balance à quartz (QCM 922 SEIKO^{®}). Un quartz avec un dépôt d'or (fournie par SEIKO^{®}) comportant un film tel que celui a réalisé précédemment a été plongée dans une solution de PbNO₃ (10⁻⁴ M) durant 180 s, la variation de fréquence de résonnance du quartz met en évidence la complexation.

### Exemple III-3 - film comportant du PHEMA et des greffons dérivé de calixarène sur une lame d'or

Dans cet exemple a été utilisé le dérivé de calixarène représenté ci-dessous, celui-ci a été réalisé d'après la littérature (Bulletin of the Korean Chemical Society (2001), 22(3), 321-324).

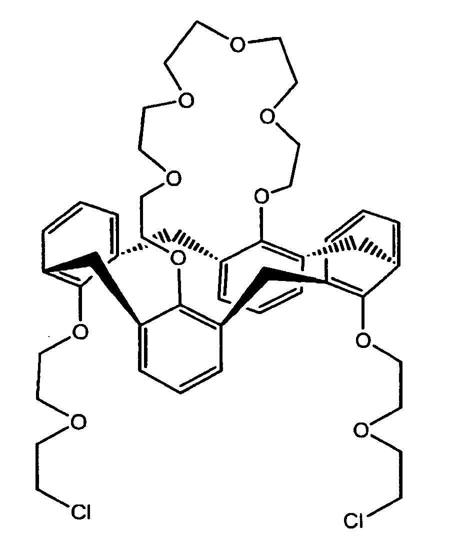

Une lame d'or de surface de 2 cm² recouverte d'un film, d'environ 5 nm d'épaisseur, comportant du poly(2-hydroxyethyl)methacrylate (PHEMA) et réalisé selon les modalités de l'exemple II-3, a été placée dans un tube à essais fermé contenant 10 ml de dichlorométhane ainsi que 10 mg de K₂CO₃. A cette solution, 20 mg d'un dérivé de calix[4]arène ont été ajoutés et le milieu réactionnel a été porté au reflux sous agitation durant 72 h. La lame a ensuite été rincée à l'acétone, à l'eau et au dichlorométhane.

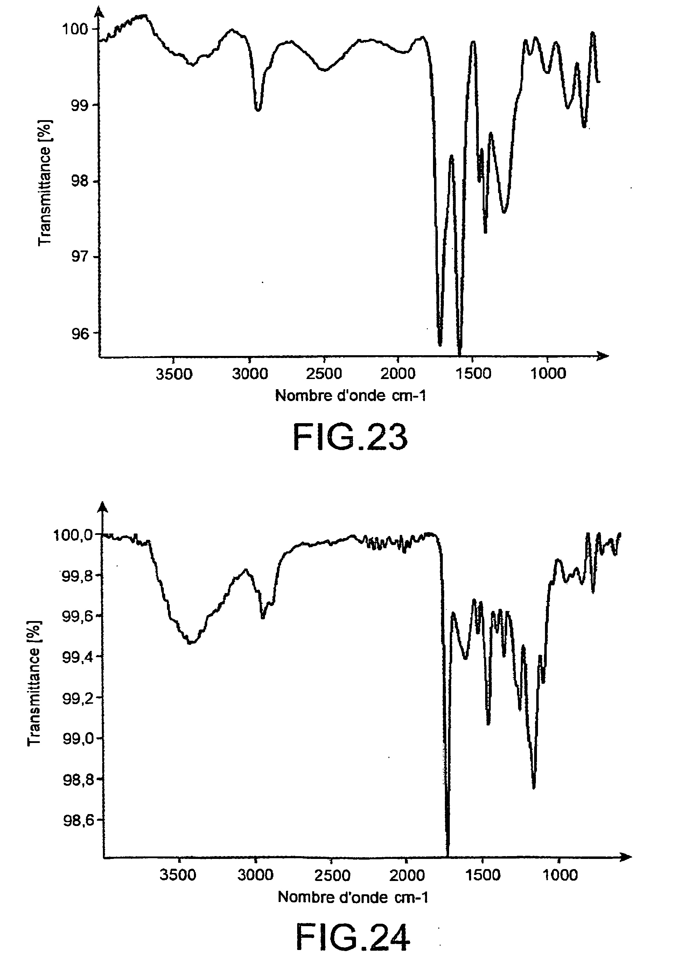

Sur le spectre IRRAS, représenté en figure 24, apparait une bande à 1600 cm⁻¹ qui est typique de la bande C=C (aromatique) (bande de valence) démontrant la présence du calixarène greffé sur le film.

### Exemple III-4 - film comportant de la polybenzyle amine et des greffons dérivé de porphyrine sur une lame d'or

Une prophyrine dont la fonction acide carboxylique a été activée par formation d'un ester activé a été employée. L'ester activé a été formé par réaction de la tétrakis (acide bezoïque)-4,4',4" ,4"'-(Porphyrine-5,10,15,20-tetrayle) (10 mg ; 1.26 10⁻⁵ mol) avec le N,N'-diisopropylcarbodiimide (6 éq.) dans le DMF en présence d'un quantité catalytique de DMAP (0,05 éq).

Une lame d'or de surface de 2 cm² comportant un film de polybenzyle amine, d'une épaisseur de 0,6 nm et préparé selon les modalités de l'exemple I-1, a été placée dans un ballon contenant la porphyrine activée.

Le milieu réactionnel a été laissé sous agitation 72 h à température ambiante puis la lame a été extraite, rincée au DMF et à l'acétone avant d'être séchée.

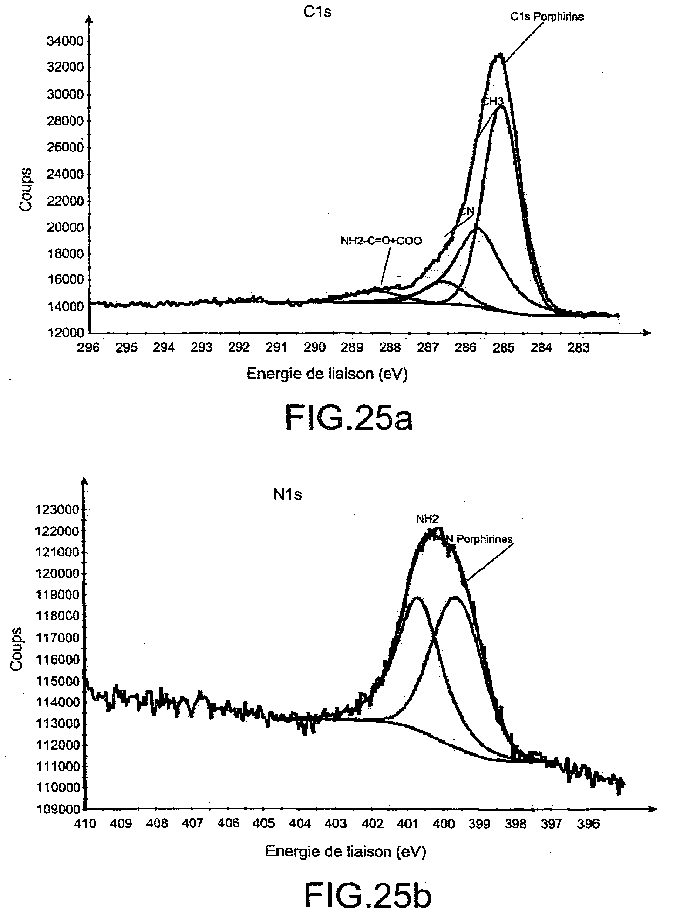

L'analyse XPS a confirmé la présence de la porphyrine sur le film. En effet, le pic centré à 189,5 eV sur le spectre du C₁ₛ, représenté à la figure 25a, correspond à la liaison C=O de l'amide qui est formé avec la surface ainsi qu'aux acides de la porphyrine non reliés au film. De même, le spectre N_{1S}, représenté à la figure 25b, est composé de deux pics dont l'un centré sur 399,5 eV, est typique des azotes inclus dans un cycle aromatique et correspond à celui des azotes de la porphyrine.

### IV - Films comportant des nano-objets

### Exemple IV-1 - Incorporation de nanoparticules de platine dans un film comportant de l'acide polyacrylique greffé sur Au

Un film organique copolymérique dérivé d'acide acryclique (AA) et d'un sel de diazonium préparé *in situ,* greffé sur une lame d'or et comportant des nanoparticules de platine a été préparé.

### 1-1. Synthèse du stabilisant HEA-16-Cl

Dans un ballon de 50 ml équipé d'un réfrigérant, 29,2 mmol de N-N-diméthyl éthanolamine, 35 mmol (1,2 eq) de chlorure d'héxadécyle ont été dissous dans 15 ml d'éthanol absolu. Le mélange a ensuite été porté au reflux pendant 24 h. L'éthanol a alors été évaporé et le mélange réactionnel refroidi à température ambiante. Le solide blanc qui s'est formé a été recristallisé dans un mélange acétone/éthanol pour donner le chlorure de N,N-diméthyl-N-hexadecyl-N-(2-hydroxyéthyl) ammonium noté HEA-16-Cl.

### 1-2. Préparation de la suspension colloïdale de platine (0) Pt-HEA-16-Cl

La suspension colloïdale a été préparée à 20°C. A 300 mg de HEA-16-Cl dissout dans 5 ml d'eau ultrapure ont été ajoutés 3,6 mg de borohydrure de sodium (NaBH₄). Cette solution a ensuite ajoutée rapidement sous vive agitation à 5 ml d'eau ultra pure contenant 12 mg de tétrachlorure de platine (PtCl₄). La réduction du Pt(IV) en Pt(0) se caractérise par un changement de coloration du jaune pâle vers le noir/marron. La suspension a été laissée une heure sous agitation mécanique avant utilisation. Cette suspension est stable durant plusieurs semaines.

### 1-3. Greffage d'un film comportant de l'acide polyacrylique sur Au

Dans un bécher de 50 ml ont été ajoutés, dans l'ordre, 2 ml de 1-4 diaminophényl (0,1 M), 2 ml de nitrite de sodium (NaNO₂, 0,1 M) et 1 ml d'acide acrylique (AA). 50 mg de poudre de fer ont ensuite été ajoutés à la solution et une lame d'or de 5 cm² a été introduite dans le milieu. Après 45 minutes, la lame a été extraite du milieu réactionnel puis rincée (Eau/éthanol/acétone) et séchée.

Une analyse XPS a confirmé la présence du film de PAA.

### 1-4. Incorporation des nanoparticules de Pt dans le film comportant du PAA

Dans un premier temps, la lame d'or recouverte du film organique a été plongée dans une solution de soude 0,5 M pendant 5 minutes puis séchée sans rinçage supplémentaire. Cette étape a permi de transformer les groupements acides carboxyliques, précurseur de groupe d'affinité, du PAA en groupements carboxylates, qui présentent une affinité pour les particules. 1 ml de suspension colloïdale de Pt(0) a ensuite été déposé sur la lame d'or revêtue du film. Après 15 minutes, la lame a été rincée (Eau/Ethanol/acétone) avant d'être séchée puis analysée par XPS.

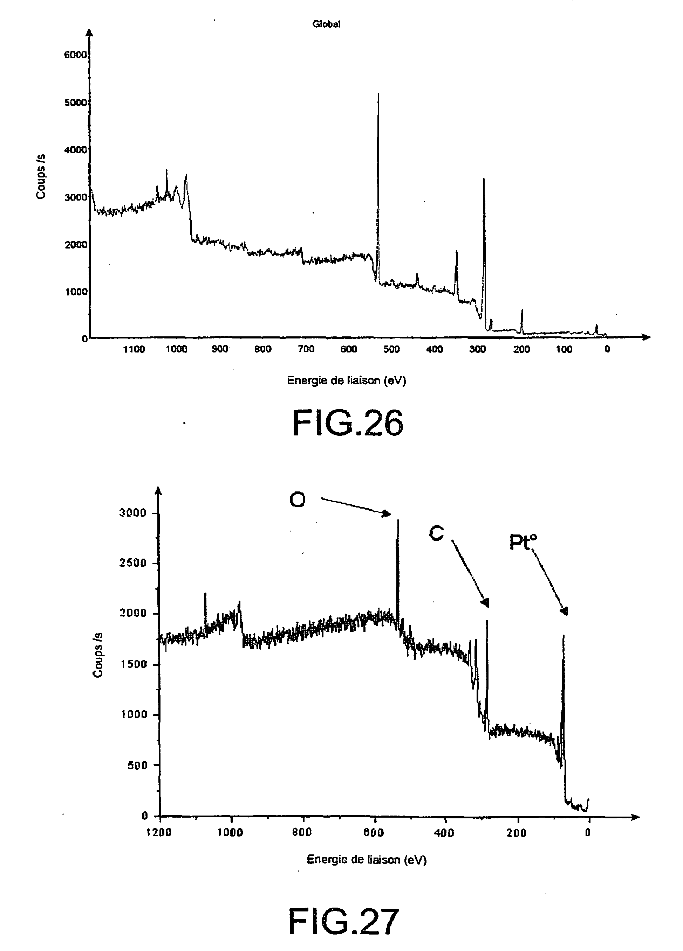

L'analyse XPS a démontré la présence de Platine (0) en quantité significative à l'issu du traitement, ainsi que cela apparait sur la figure 27, qui correspond à un spectre XPS du film après l'intégration des particules, comparativement à la figure 26, qui correspond au film avant l'incorporation des particules.

### Exemple IV-2 - Incorporation de nanoparticules d'or dans un film comportant de l'acide polyacrylique greffé sur de l'acier (AISI 316L)

Un film organique copolymérique dérivé d'acide acryclique (AA) et d'un sel de diazonium préparé *in situ,* greffé sur une lame d'acier (AISI 316L) et comportant des nanoparticules d'or a été préparé.

### 2-1. Synthèse du stabilisant HEA-16-Cl

Le stabilisant a été préparé conformément à l'exemple I-1.

### 2-2. Préparation de la suspension colloïdale d'or (0) : Au-HEA-16-Cl

La suspension colloïdale a été préparée à 20°C. A 300 mg de HEA-16-Cl dissout dans 5 ml d'eau ultrapure ont été ajoutés 3,6 mg de borohydrure de sodium (NaBH₄). Cette solution a ensuite été ajoutée rapidement sous vive agitation à 5 ml d'eau ultra pure contenant 12 mg de sel d'or (AuHCl₄). La réduction du Au (IV) en Au(0) se caractérise par un changement de coloration du jaune pâle vers le rouge brique. La suspension a été laissée une heure sous agitation mécanique avant utilisation. Cette suspension est stable durant plusieurs semaines.

### 2-3. Greffage d'un film comportant de l'acide polyacrylique sur de l'acier (AISI 316L)

Dans un bécher de 50 ml ont été ajoutés, dans l'ordre, 2 ml de 1-4 diaminophényl (0,1 M), 2 ml de nitrite de sodium (NaNO₂, 0,1 M) et 1ml d'acide acrylique (AA). 50 mg de poudre de fer ont ensuite été ajoutés à la solution et une lame d'acier (AISI 316L) de 5 cm² a été introduite dans le milieu. Après 45 min, la lame a été extraite du milieu réactionnel et rincée (Eau/éthanol/acétone) avant d'être séchée.

L'analyse par XPS a confirmé la présence du film.

### 2-4. Incorporation des nanoparticules de Au dans le film comportant du PAA

Dans un premier temps, la lame d'acier (AISI 316L) recouverte du film organique a été plongée dans une solution de soude 0,5 M pendant 5 minutes puis séchée sans rinçage supplémentaire. Cette étape a permi de transformer les groupements acides carboxyliques, précurseur de groupe d'affinité, du PAA en groupements carboxylates, qui présentent une affinité pour les particules. 1 ml de suspension colloïdale de Au(0) a ensuite été déposé sur la lame d'acier (AISI 316L) revetue du film. Après 15 minutes, la lame a été rincée (Eau/Ethanol/acétone) avant d'être séchée puis analysée par XPS.

L'analyse XPS a démontré la présence d'or(0) en quantité significative car l'acier (AISI 316L) n'est plus visible.

### Exemple IV-3 - Incorporation de nanoparticules de platine dans un film comportant de l'acide polyacrylique greffé sur des nanotubes de carbone

Un film organique copolymérique dérivé d'acide acryclique (AA) et d'un sel de diazonium préparé *in situ,* greffé sur un tapis de nanotubes de carbone et comportant des nanoparticules de platine a été préparé.

### 3-1. Synthèse du stabilisant HEA-16-Cl

Le stabilisant a été préparé selon le protocole décrit dans l'exemple IV-1.

### 3-2. Préparation de la suspension colloïdale de platine (0) Pt-HEA-16-Cl

La suspension a été réalisée conformément à ce qui est décrit dans l'exemple IV-1.

### 3-3. Greffage d'un film comportant de l'acide polyacrylique sur le tapis de nanotubes

A une solution de sel de diazonium préparée comme indiqué à l'exemple II-2, ont été ajoutés 200 mg de limaille de fer et 1 ml d'Acide Acrylique. A cette solution, ont ensuite été ajoutés 100 mg de nanotubes de carbone sous forme de tapis. Le tapis, après réaction, a été nettoyé selon le protocole décrit à l'exemple IV-2 avant d'être séché.

### 3-4. Incorporation des nanoparticules de Pt dans le film comportant du PAA

Dans un premier temps, le tapis de nanotubes recouvert du film organique a été plongé dans une solution de soude 0,5 M pendant 5 minutes puis séché sans rinçage supplémentaire. Cette étape a permi de transformer les groupements acides carboxyliques, précurseur de groupe d'affinité, du PAA en groupements carboxylates, qui présentent une affinité pour les particules. 1 ml de suspension colloïdale de Pt(0) a ensuite été déposé sur le tapis de nanotubes revêtus du film. Après 15 minutes, le tapis de nanotubes a été rincé (Eau/Ethanol/acétone) avant d'être séché puis analysé par XPS.

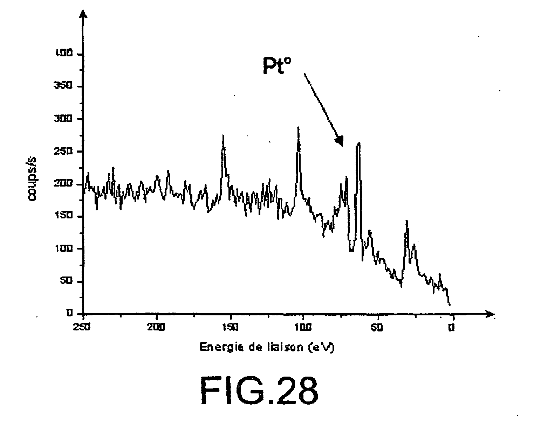

L'analyse XPS a démontré la présence de Platine (0) comme cela est indiqué sur le spectre présenté à la figure 28.

### Exemple IV-4 - Incorporation de nanoparticules de platine dans un film de poly benzyle amine greffé sur Au

Un film organique dérivé d'un sel de diazonium préparé *in situ,* greffé sur une lame d'or et comportant des nanoparticules de platine a été préparé.

### 4-1. Synthèse du stabilisant HEA-16-Cl

Le stabilisant a été préparé comme indiqué à l'exemple IV-1.

### 4-2. Préparation de la suspension colloïdale de platine (0) : Pt-HEA-16-Cl

Le mode opératoire est identique à celui de l'exemple IV-1.

### 4-3. Greffage d'un film de poly benzyle amine sur Au

Dans un bécher de 50 ml ont été ajoutés, dans l'ordre, 2 ml de p-amino-benzyle amine (0,1 M), 2 ml de nitrite de sodium (NaNO₂, 0,1 M) puis, 50 mg de poudre de fer ont ensuite été ajoutés à la solution et une lame d'or de 5 cm² a été introduite dans le milieu. Après 45 minutes la lame a été extraite du milieu réactionnel puis rincée (Eau/éthanol/acétone) et séchée.

L'analyse pas XPS a confirmé la présence du film organique de poly benzyle amine.

### 4-4. Incorporation des nanoparticules de Pt dans le film de poly benzyle amine

Dans un premier temps, la lame d'or recouverte du film organique a été plongée dans une solution de soude 0,5 M pendant 5 minutes puis séchée sans rinçage supplémentaire. Cette étape a permis de transformer les groupements ammonium, précurseurs de groupe d'affinité, en groupements amine qui présentent une affinité pour les particules. 1 ml de suspension colloïdale de Pt(0) a ensuite été déposé sur la lame d'or revêtue du film. Après 15 minutes, la lame a été rincée (Eau/Ethanol/acétone) avant d'être séchée puis analysée par XPS.

L'analyse XPS a démontré la présence de Platine (0) en quantité significative.

### Exemple IV-5 - Incorporation de nanoparticules de silice dans un film comportant de l'acide polyacrylique greffé sur Au

Un film organique copolymérique dérivé d'acide acryclique (AA) et d'un sel de diazonium préparé *in situ,* greffé sur une lame d'or et comportant des nanoparticules de silice a été préparé.

Des particules de silice commerciales (fournies par DEGUSA®) de petite taille (environ 12 nm de diamètre) non poreuses et finement divisées ont été employées.

Chaque particule est sensiblement sphérique et présente une surface spécifique d'environ 200 m². g⁻¹ et contient environ 1 mmol.g⁻¹ de groupements silanols.

La solution colloïdale de particule de silice a été obtenue par mélange de 10 mg de silice dans 10 ml d'eau distillée.

### 5-1. Greffage d'un film comportant de l'acide polyacryli que sur de l'Au

Le greffage a été réalisé comme indiqué à l'exemple IV-1.

### 5-2. Incorporation des particules de silice dans le film comportant du PAA

L'incorporation des particules a été réalisée selon le protocole de l'exemple IV-1.

L'analyse infrarouge a confirmé la présence des particules dans le film.

### Exemple IV-6 - Incorporation de nanoparticules de platine dans un film comportant de l'acide polyacrylique greffé sur verre et plastique

Des film organiques copolymériques dérivés d'acide acryclique (AA) et d'un sel de diazonium préparé *in situ,* greffés sur une lame de plastique (polyéthylène) et de verre et comportant des nanoparticules de platine ont été préparés.

La préparation des films organiques et l'incorporation des particules ont été réalisées selon les protocoles présentés à l'exemple IV-1.

L'analyse XPS a montré l'incorporation des particules dans chacun des films.

### Exemple IV-7 - Coalescence des nanoparticules présentes dans les films

La surface des supports de verre et d'or des exemples précédents, recouvert de film organique comportant des nanoparticules d'Au ou de Pt ont été traitées durant 5 min avec un pistolet à chaleur à environ 500 °C. Une modification de l'apparence de la surface a été observée durant le traitement et l'aspect irisé initial disparait au profit d'une uniformisation due à la coalescence des particules.

### Exemple IV-8 - Métallisation du film par réduction chimique d'une solution de sels métalliques à l'aide des nanoparticules présentes dans les films

Un bain de métallisation a été préparé avec deux solutions, la première contenant 3 g de sulfate de cuivre, 14 g de tartrate de sodium et de potassium et 4 g de soude dans 100 ml d'eau distilée. La seconde solution est une solution aqueuse de formaldéhyde à 37,02% en masse. Les deux solutions ont été mélangées dans un rapport 10/1 et 20 ml du mélange sont prélevés pour y plonger les supports, de verre ou d'or, recouverts de film organique comportant des nanoparticules d'Au ou de Pt, obtenus selon les exemples IV-1, IV-4 et IV-6 durant 5 min. Les surfaces des supports ont alors été rincées à l'eau et à l'acétone puis séchées sous flux d'argon. Une modification de l'apparence de la surface a été constatée, un film métallique a été obtenu.

### Exemple IV-9 - Métallisation du film de polymère par réduction chimique d'une solution de sels métalliques à l'aide des nanoparticules de paladium présentes dans les films

### 9-1 Préparation de la suspension colloïdale de plaladium (0) : Pd/[C₁₈H₃₇]₄N⁺Br⁻

L'acétate de palladium(II) (4g, 17,8 mmol) et le bromure de tétraoctadecylammonium (5g, 4,5 mmol) ont été placés dans 200 ml d'un mélange(5:1) de toluène et de tétrahydrofurane (THF) à 30°C. Après ajout de 25 ml d'éthanol absolu, le mélange a été porté à 65°C pendant 12 h. La couleur de la solution est devenue brune-noire.

La préparation de la suspension colloïdale est amorcée par un lent ajout d'un excès d'éthanol (100 ml) sous agitation vigoureuse. La solution est alors laissée à décanter pendant 5h à température ambiante. Le solvant a ensuite été évaporé sous pression réduite et une poudre brune foncée a été obtenue (2,1 g) soit avec 88% de rendement.

Une suspension colloidale de paladium a ensuite été préparée par exposition aux ultrasons durant 5 min d'une solution de 0,3 g de la poudre précédemment obtenue dans 200 ml de toluène. La suspension est stable pendant plusieurs mois.

### 9-2. Greffage d'un film comportant de l'acide polyacrylique sur une lame plastique de polyéthylène ou de polypropylène

Des film organiques copolymériques dérivés d'acide acryclique (AA) ou d'HEMA, et d'un sel de diazonium préparé *in situ,* ont été greffés sur une lame de plastique (polyéthylène ou polypropylène). Des films dérivés de diazonium seul ont également été préparés. Ces films ont été obtenus selon les protocoles exposés plus haut.

### 9-3 Incorporation des particules de paladium Pd/[C₁₈H₃₇]₄N⁺Br⁻ dans le film comportant du PAA et métallisation du film à l'aide des nanoparticules présentes dans le film

L'incorporation des particules est effectuée par trempage de la lame plastique de polyéthylène ou de polypropylène recouvert par un film greffé dans La suspension obtenue dans l'exemple 9-2, le film est ensuite rincé au toluène puis séché sous flux d'argon. La métallisation est efectuée selon la même procédure que dans l'exemple exemple IV-8. Un film de métal est alors visible à l'oeil nu.

## Revendications

1. Procédé de préparation d'un film organique à la surface d'un support solide, **caractérisé en ce qu'**il comprend une étape de mise en contact de ladite surface avec une solution liquide comprenant :
- au moins un solvant,
- au moins un sel d'aryle clivable,
dans des conditions non-électrochimiques et permettant la formation d'entités radicalaires à partir du sel d'aryle clivable.

2. Procédé de préparation selon la revendication 1, **caractérisé en ce que** ledit sel d'aryle clivable est choisi dans le groupe constitué par les sels d'aryle diazonium, les sels d'aryle d'ammonium, les sels d'aryle phosphonium et les sels d'aryle sulfonium.

3. Procédé de préparation selon l'une quelconque des revendications 1 ou 2, **caractérisé en ce que** ledit sel d'aryle clivable est soit introduit en l'état dans ladite solution liquide, soit préparé in situ dans cette dernière.

4. Procédé de préparation selon l'une quelconque des revendications précédentes, **caractérisé en ce que** ladite solution liquide contient en outre au moins un tensioactif.

5. Procédé de préparation selon l'une quelconque des revendications précédentes, **caractérisé en ce que** les conditions non-électrochimiques permettant la formation d'entités radicalaires sont choisies dans le groupe constitué par les conditions thermiques, cinétiques, chimiques, photochimiques, radiochimiques et leur combinaison auxquelles le sel d'aryle clivable est soumis.

6. Procédé de préparation selon l'une quelconque des revendications précédents, **caractérisé en ce que** ladite solution liquide comprend en outre un ou plusieurs amorceur(s) chimique(s).

7. Procédé de préparation selon l'une quelconque des revendications précédentes, **caractérisé en ce que** la surface du support solide mise au contact de ladite solution liquide comporte au moins une zone recouverte d'un masque.

8. Procédé de Préparation selon l'une quelconque des revendications précédentes, **caractérisé en ce que** ladite solution liquide comprend en outre au moins un monomère différent du sel d'aryle clivable et polymérisable par voie radicalaire.

9. Procédé de préparation selon la revendication 8, **caractérisé en ce que** ledit monomère polymérisable par voie radicalaire est une molécule de type éthylénique.

10. Procédé de préparation selon l'une quelconque des revendications 8 ou 9, **caractérisé en ce que** ledit monomère polymérisable par voie radicalaire est une molécule de formule (II) suivante : 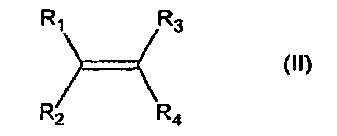 dans laquelle les groupes R₁ à R₄, identiques ou différents, représentent un atome monovalent non métallique, un atome d'hydrogène, un groupe chimique saturé ou insaturé, un groupe -COOR₅ dans lequel R₅ représente un atome d'hydrogène ou un groupe alkyle en C₁-C₁₂, un nitrile, un carbonyle, une amine ou un amide.

11. Procédé de préparation selon l'une quelconque des revendications 8 à 10, **caractérisé en ce que** ledit procédé comprend une étape préalable durant laquelle ledit monomère polymérisable est dispersé ou émulsionné en présence d'au moins un tensioactif ou par action des ultrasons, avant son mélange à la solution liquide comprenant au moins un solvant et au moins un sel d'aryle clivable.

12. Procédé de préparation selon l'une quelconque des revendications 8 à 11, **caractérisé en ce que** ledit procédé comprend les étapes suivantes consistant à :
a) ajouter ledit au moins un monomère à une solution contenant ledit au moins un sel d'aryle clivable différent dudit monomère en présence dudit au moins un solvant et éventuellement dudit au moins un amorceur chimique,
b) placer la solution obtenue à l'étape (a) dans lesdites conditions non-électrochimiques permettant la formation d'entités radicalaires à partir dudit sel d'aryle clivable et éventuellement à partir dudit amorceur chimique,
c) mettre en contact la surface du support solide avec la solution de l'étape (b).

13. Procédé de préparation selon l'une quelconque des revendications 8 à 11, **caractérisé en ce que** ledit procédé comprend les étapes suivantes consistant à :
a') mettre en contact la surface du support solide avec une solution contenant ledit au moins un sel d'aryle clivable en présence dudit au moins un solvant et, éventuellement dudit au moins un amorceur chimique et dudit au moins un monomère,
b') placer la surface du support solide en contact avec la solution de l'étape (a') dans des conditions non-électrochimiques permettant la formation d'entités radicalaires à partir dudit sel d'aryle clivable et éventuellement à partir dudit amorceur chimique,
c') éventuellement ajouter ledit au moins un monomère à la solution obtenue à l'étape (b').

14. Procédé de préparation selon l'une quelconque des revendications précédentes, **caractérisé en ce que** le procédé présente une étape supplémentaire de fonctionnalisation dudit film organique.

15. Procédé selon la revendication 14, **caractérisée en ce que** la fonctionnalisation est réalisée par la mise en contact dudit film organique avec une solution de fonctionnalisation comportant au moins un greffon présentant une structure chelatante.

16. Procédé selon la revendication 14, **caractérisée en ce que** la fonctionnalisation est réalisée par la mise en contact dudit film organique avec une solution de fonctionnalisation comportant au moins un greffon dérivé d'une biomolécule.

17. Procédé de préparation d'un film organique comportant des nano-objets (NBs) à partir d'un support solide recouvert d'un film organique obtenu par le procédé selon l'une quelconque des revendications 1 à 16, **caractérisé en ce que** la surface du support est mise en contact avec une suspension d'au moins un nano-objet (NB) dans un solvant de suspension et **en ce que** le film et le nano-objet présentent une affinité physico-chimique.

18. Procédé selon la revendication 17, **caractérisé en ce qu'**au moins une zone de la surface du support, recouverte du film comportant les NBs, est exposée à un agent de coalescence.

19. Procédé de métallisation d'un film organique préparé à la surface d'un support solide comprenant les étapes consistant à
(a'') préparer, à la surface d'un support solide, un film organique comportant des nano-objets (NBs) selon un procédé tel que défini à la revendication 17 ;
(b") mettre en contact le film préparé à l'étape (a") avec une solution contenant au moins un sel métallique moyennant quoi ledit sel métallique est réduit par lesdits NBs.

20. Support solide non-conducteur de l'électricité sur lequel est greffé un film organique dont la première unité liée de façon covalente audit support non-conducteur de l'électricité est un dérivé d'un sel d'aryle clivable tel que défini dans l'une quelconque des revendications 2 ou 3.

21. Support solide non-conducteur de l'électricité sur lequel est greffé un film organique selon la revendication 20, **caractérisé en ce que** le film organique comporte des NBs.

22. Kit de préparation d'un film organique essentiellement polymère à la surface d'un support solide comprenant :
- dans un premier compartiment, une solution contenant au moins un sel d'aryle clivable tel que défini dans l'une quelconque des revendications 2 ou 3,
- éventuellement, dans un deuxième compartiment, une solution contenant au moins un monomère polymérisable par voie radicalaire différent du sel d'aryle clivable tel que défini dans l'une quelconque des revendications 8 à 10,
- et, éventuellement, dans un troisième compartiment, une solution contenant au moins un amorceur chimique de polymérisation.

## Claims

1. A method for preparing an organic film at the surface of a solid support, wherein it includes a step of contacting said surface with a liquid solution including:
- at least one solvent,
- at least one cleavable aryl salt,
under non-electrochemical conditions, allowing for the formation of radical entities from the cleavable aryl salt.

2. Preparation method according to claim 1, wherein said cleavable aryl salt is chosen from the group constituted by aryl diazonium salts, aryl ammonium salts, aryl phosphonium salts and aryl sulfonium salts.

3. Preparation method according to claim 1 or 2, wherein said cleavable aryl salt is either added as is to said liquid solution, or prepared *in situ* in the latter.

4. Preparation method according to any one of preceeding claims, wherein said liquid solution also contains at least one surfactant.

5. Preparation method according to any one of preceeding claims, wherein the non-electrochemical conditions allowing for the formation of radical entities are chosen from the group constituted by thermal, kinetic, chemical, photochemical or radiochemical conditions and a combination thereof, to which the cleavable aryl salt is subjected.

6. Preparation method according to any one of preceeding claims, wherein said liquid solution also includes one or more chemical initiator(s).

7. Preparation method according to any one of preceeding claims, wherein the surface of the solid support contacted with said liquid solution comprises at least one area covered with a mask.

8. Preparation method according to any one of preceeding claims, wherein said liquid solution also includes at least one radically polymerisable monomer different from the cleavable aryl salt.

9. Preparation method according to claim 8, wherein said radically polymerisable monomer is an ethylene-type molecule.

10. Preparation method according to claim 8 or 9, wherein said radically polymerisable monomer is a molecule with the hollowing formule (II): 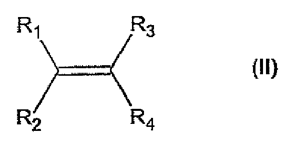 in which the R₁ to R₄ groups, identical or different, represent a non-metallic monovalent atom, a hydrogen atom, a saturated or unsaturated chemical group, a -COOR₅ group in which R₅ represents a hydrogen atom or a C₁-C₁₂ alkyl group, a nitrile, a carbonyl, an amine or an amide.

11. Preparation method according to any one of claims 8 to 10, wherein said method includes a preliminary step during which said radically polymerisable monomer is dispersed or emulsified in the presence of at least one surfactant, or by ultrasound, before it is mixed with the liquid solution including at least one solvent and at least one cleavable aryl salt.

12. Preparation method according to any one of claims 8 to 11, wherein said method includes the following steps consisting of:
a) adding said at least one monomer to a solution containing said at least one cleavable aryl salt different from said monomer in the presence of said at least one solvent and possibly said at least one chemical initiator,
b) placing the solution obtained in step (a) under said non-electrochemical conditions allowing for the formation of radical entities based on said cleavable aryl salt and possibly based on said chemical initiator,
c) placing the surface of the solid support in contact with the solution of step (b).

13. Preparation method according to any one of claims 8 to 11, wherein said method includes the following steps consisting of:
a') placing the surface of the solid support in contact with a solution containing said at least one cleavable aryl salt in the presence of said at least one solvent, and possibly said at least one chemical initiator and said at least monomer,
b') placing the surface of the solid support in contact with the solution of step (a') under non-electrochemical conditions allowing for the formation of radical entities based on said cleavable aryl salt and possibly based on said chemical initiator,
c') possibly adding said at least one monomer to the solution obtained in step (b').

14. Preparation method according to any one of preceeding claims, wherein the method has an additional step of functionalising said organic film.

15. Preparation method according to claim 14, wherein said functionalisation is performed by placing said organic film in contact with a- functionalisation solution comprising at least one graft having a chelating structure.

16. Preparation method according to claim 14, wherein said functionalisation is performed by placing said organic film in contact with a functionalisation solution comprising at least one graft derivative of a biomolecule.

17. Method for preparing an organic film comprising nano-objects (NBs) from a solid support coated by an organic film prepared according to a method of any one of claims 1 to 16, wherein the surface of the support is placed in contact with a suspension of at least one nano-object (NB) in a suspension solvent and wherein the film and the nano-object have a physicochemical affinity.

18. Method according to claim 17, wherein at least one zone of the surface of the support, coated with the film comprising the NBs, is exposed to a coalescence agent.

19. A method for metalizing an organic film prepared at the surface of a solid support including the steps consisting of:
(a") preparing, at the surface of a solid support, an organic film comprising nano-objects (NBs) according to a method as defined in claim 17;
(b") placing the film prepared in step (a") in contact with a solution containing at least one metal salt capable of being reduced by said NBs.

20. A non-electrically-conductive solid support on which an organic film is grafted, of which the first unit covalently bound to said non-electrically-conductive support is a derivative of a cleavable aryl salt as defined in claim 2 or 3.

21. Non-electrically-conductive solid support on which an organic film is grafted according to claim 20, wherein the organic film comprises NBs.

22. Kit for preparing an essentially polymer organic film at the surface of a solid support, including:
- in a first compartment, a solution containing at least one cleavable aryl salt as defined in claim 2 or 3,
- possibly, in a second compartment, a solution containing at least one radically polymerisable monomer different from the cleavable aryl salt as defined in any one of claims 8 to 10,
- and, possibly, in a third compartment, a solution containing at least one chemical polymerisation initiator.

## Patentansprüche

1. Verfahren zur Herstellung eines organischen Films auf der Oberfläche eines festen Trägers, **dadurch gekennzeichnet, dass** es einen Schritt des In-Kontakt-Bringens dieser Oberfläche mit einer Folgendes umfassenden Flüssigkeit:
- wenigstens ein Lösungsmittel und
- wenigstens ein spaltbares Arylsalz
unter nicht-elektrochemischen Bedingungen umfasst und die Bildung radikalischer Einheiten aus dem spaltbaren Arylsalz gestattet.

2. Herstellungsverfahren gemäß Anspruch 1, **dadurch gekennzeichnet, dass** das spaltbare Arylsalz aus der Gruppe ausgewählt ist, die sich aus Aryldiazoniumsalzen, Arylammoniumsalzen, Arylphosphoniumsalzen und Arylsulfoniumsalzen zusammensetzt.

3. Herstellungsverfahren gemäß einem der Ansprüche 1 oder 2, **dadurch gekennzeichnet, dass** das spaltbare Arylsalz entweder als solches der flüssigen Lösung zugesetzt wird oder darin in situ hergestellt wird.

4. Herstellungsverfahren gemäß einem der vorangehenden Ansprüche, **dadurch gekennzeichnet, dass** die flüssige Lösung außerdem wenigstens ein Tensid enthält.

5. Herstellungsverfahren gemäß einem der vorangehenden Ansprüche, **dadurch gekennzeichnet, dass** die die Bildung radikalischer Einheiten gestattenden nicht-elektrochemischen Bedingungen aus der Gruppe ausgewählt sind, die sich aus thermischen, kinetischen, chemischen, photochemischen, strahlenchemischen Bedingungen und ihren Kombinationen zusammensetzt, denen das spaltbare Arylsalz ausgesetzt wird.

6. Herstellungsverfahren gemäß einem der vorangehenden Ansprüche, **dadurch gekennzeichnet, dass** die flüssige Lösung außerdem einen oder mehrere chemische Initiator(en) umfasst.

7. Herstellungsverfahren gemäß einem der vorangehenden Ansprüche, **dadurch gekennzeichnet, dass** die mit der flüssigen Lösung in Kontakt gebrachte Oberfläche des festen Trägers wenigstens eine mit einer Maske abgedeckte Zone umfasst.

8. Herstellungsverfahren gemäß einem der vorangehenden Ansprüche, **dadurch gekennzeichnet, dass** die flüssige Lösung außerdem wenigsten ein Monomer umfasst, das von dem spaltbaren Arylsalz verschieden und radikalisch polymerisierbar ist.

9. Herstellungsverfahren gemäß Anspruch 8, **dadurch gekennzeichnet, dass** das radikalisch polymerisierbare Monomer ein Molekül vom Ethylentyp ist.

10. Herstellungsverfahren gemäß einem der Ansprüche 8 oder 9, **dadurch gekennzeichnet, dass** das radikalisch polymerisierbare Monomer ein Molekül der folgenden Formel (II) ist: 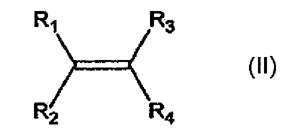 worin die Gruppen R₁ bis R₄ gleich oder verschieden sind und ein einwertiges Nichtmetallatom, ein Wasserstoffatom, eine gesättigte oder ungesättigte chemische Gruppe, eine Gruppe -COOR₅, worin R₅ ein Wasserstoffatom oder eine C₁-C₁₂-Alkylgruppe bedeutet, eine Nitrilgruppe, eine Carbonylgruppe, ein Amin oder Amid darstellen.

11. Herstellungsverfahren gemäß einem der Ansprüche 8 bis 10, **dadurch gekennzeichnet, dass** das Verfahren einen vorherigen Schritt umfasst, währen dessen das polymerisierbare Monomer in Gegenwart wenigstens eines Tensids oder durch Ultraschalleinwirkung vor seinem Mischen mit der wenigstens ein Lösungsmittel und wenigstens ein spaltbares Arylsalz umfassenden flüssigen Lösung dispergiert oder emulgiert wird.

12. Herstellungsverfahren gemäß einem der Ansprüche 8 bis 11, **dadurch gekennzeichnet, dass** das Verfahren die folgenden Schritte umfasst, bestehend aus:
a) Zufügen des wenigstens einen Monomers zu einer Lösung, die das wenigstens eine spaltbare, von diesem Monomer verschiedene Arylsalz enthält, in Gegenwart des wenigsten einen Lösungsmittels und gegebenenfalls des wenigstens einen chemischen Initiators,
b) Aussetzen der in Schritt (a) erhaltenen Lösung den nicht-elektrochemischen Bedingungen, die die Bildung radikalischer Einheiten aus dem spaltbaren Arylsalz und gegebenenfalls dem chemischen Initiator gestatten,
c) In-Kontakt-Bringen der Oberfläche des festen Trägers mit der Lösung aus Schritt (b).

13. Herstellungsverfahren gemäß einem der Ansprüche 8 bis 11, **dadurch gekennzeichnet, dass** das Verfahren die folgenden Schritte umfasst, bestehend aus:
a') In-Kontakt-Bringen der Oberfläche des festen Trägers mit einer das wenigstens ein spaltbare Arylsalz enthaltenden Lösung in Gegenwart des wenigstens einen Lösungsmittels und gegebenenfalls des wenigstens einen chemischen Initiators und des wenigstens einen Monomers,
b') Aussetzen der mit der Lösung aus Schritt (a') in Kontakt befindlichen Oberfläche des festen Trägers nicht-elektrochemischen Bedingungen, die die Bildung radikalischer Einheiten aus dem spaltbaren Arylsalz und gegebenenfalls aus dem chemischen Initiators gestatten,
c') gegebenenfalls Zufügen des wenigstens einen Monomers zu der in Schritt (b') erhaltenen Lösung.

14. Herstellungsverfahren gemäß einem der vorangehenden Ansprüche, **dadurch gekennzeichnet, dass** das Verfahren einen zusätzlichen Schritt der Funktionalisierung des organischen Films aufweist.

15. Verfahren gemäß Anspruch 14, **dadurch gekennzeichnet, dass** die Funktionalisierung durch In-Kontakt-Bringen des organischen Films mit einer Funktionalisierungslösung bewerkstelligt wird, die wenigstens eine eine Chelatbildnerstruktur aufweisende Seitenkette umfasst.

16. Verfahren gemäß Anspruch 14, **dadurch gekennzeichnet, dass** die Funktionalisierung durch In-Kontakt-Bringen des organischen Films mit einer Funktionalisierungslösung bewerkstelligt wird, die wenigstens eine von einem Biomolekül abgeleitete Seitenkette umfasst.

17. Verfahren zur Herstellung eines Nanoteilchen (NBs) umfassenden organischen Films aus einem festen Träger, der mit einem durch das Verfahren gemäß einem der Ansprüche 1 bis 16 erhaltenen organischen Film überzogen ist, **dadurch gekennzeichnet, dass** die Trägeroberfläche mit einer Suspension wenigstens eines Nanoteilchens (NB) in einem Lösungsmittel zur Suspendierung in Kontakt gebracht wird und dadurch, dass der Film und das Nanoteilchen eine physikalisch-chemische Affinität aufweisen.

18. Verfahren gemäß Anspruch 17, **dadurch gekennzeichnet, dass** mindestens eine mit dem die NBs umfassenden Film überzogene Zone der Trägeroberfläche einem Koaleszenzmittel ausgesetzt wird.

19. Verfahren zur Metallisierung eines auf der Oberfläche eines festen Trägers hergestellten Films, das die folgenden Schritte umfasst, bestehend aus:
(a") Herstellen eines Nanoteilchen (NBs) umfassenden organischen Films auf der Oberfläche eines festen Trägers gemäß einem in Anspruch 17 definierten Verfahren,
(b") In-Kontakt-Bringen des in Schritt (a") hergestellten Films mit einer wenigstens ein Metallsalz enthaltenden Lösung, wodurch das Metallsalz durch die NBs reduziert wird.

20. Fester, elektrisch nichtleitender Träger, auf den ein organischer Film gepfropft ist, dessen erste, kovalent an den elektrisch nichtleitenden Träger gebundene Einheit ein Derivat eines in einem der Ansprüche 2 oder 3 definierten spaltbaren Arylsalzes ist.

21. Fester, elektrisch nichtleitender Träger, auf den ein organischer Film gemäß Anspruch 20 gepfropft ist, **dadurch gekennzeichnet, dass** der organische Film NBs umfasst.

22. Kit zur Herstellung eines im Wesentlichen polymeren organischen Films auf der Oberfläche eines festen Trägers umfassend:
- in einem ersten Abteil eine Lösung, die wenigstens ein in einem der Ansprüche 2 oder 3 definiertes spaltbares Arylsalz enthält,
- gegebenenfalls in einem zweiten Abteil eine Lösung, die wenigstens ein in einem der Ansprüche 8 bis 10 definiertes, radikalisch polymerisierbares Monomer enthält, das von dem spaltbaren Arylsalz verschieden ist, und
- gegebenenfalls in einem dritten Abteil eine Lösung, die wenigstens einen chemischen Polymerisationsinitiator enthält.
